# EUROPEAN PATENT SPECIFICATION

(11) **EP 4 339 322 B1**
(45) Date of publication and mention of the grant of the patent: **02.12.2026**
(21) Application number: 24155790.9
(22) Date of filing: 24.08.2018
(51) Int. Cl.: C23C 14/04, C23C 14/12, H10K 59/35, H10K 71/16

(54) **METALLIC MATERIAL DEPOSITION MASK FOR OLED PIXEL DEPOSITION**
METALLMATERIALABSCHEIDUNGSMASKE ZUR OLED-PIXELABSCHEIDUNG
MASQUE DE DÉPÔT DE MATÉRIAU MÉTALLIQUE POUR DÉPÔT DE PIXELS OLED

(30) Priority: 07.09.2017 KR 20170114820; 21.11.2017 KR 20170155670; 23.11.2017 KR 20170157644
(43) Date of publication of application: 20.03.2024
(60) Divisional application: 26214063.5
(62) Document number(s) of the earlier application(s) in accordance with Art. 76 EPC: 18853058.8 / 3 680 949
(73) Proprietor: LG Innotek Co., Ltd., Seoul 07796 (KR)
(72) Inventor: PAIK, Jee Heum, 04637 SEOUL (KR); KIM, Hae Sik, 04637 SEOUL (KR); JO, Yeong Deuk, 04637 SEOUL (KR); LEE, Sang Yu, 04637 SEOUL (KR); CHO, Su Hyeon, 04637 SEOUL (KR); SON, Hyo Won, 04637 SEOUL (KR)
(74) Representative: Plasseraud IP

(56) References cited:
- WO-A1-2017/013903
- JP-A- H04 103 743
- KR-A- 20160 126 807
- LEACH ISSUE RICHARD K: "Good Practice Guide No. 37 The Measurement of Surface Texture using Stylus Instruments", 1 February 2014 (2014-02-01), XP055797111, Retrieved from the Internet <URL:https://eprintspublications.npl.co.uk/2041/1/mgpg37.pdf> [retrieved on 20210420]

## Description

### [Technical Field]

An embodiment relates to a metallic material deposition mask for an organic light emitting diode (OLED) pixel deposition and a method of producing the same. Specifically, the deposition mask according to an embodiment is for producing an OLED panel having high-resolution of 500 PPI or more.

### [Background Art]

As a display device having high-resolution and low power consumption is required, various display devices such as a liquid crystal display device and an electroluminescent display device have been developed.

The electroluminescent display device has been spotlighted as a next generation display device due to excellent characteristics such as low light emission, low power consumption, and high-resolution, and the like, as compared with the liquid crystal display device.

There are an organic light emitting display device and an inorganic light emitting display device in an electric field display device. That is, an electric field display device may be classified into the organic light emitting display device and the inorganic light emitting display device according to a material of a light emitting layer.

Of these, the organic light emitting display device has received attention because the organic light emitting display device has a wide viewing angle, has a fast response speed, and is required to have low power consumption.

An organic material constituting such a light emitting layer may be formed to have a pattern for forming a pixel on a substrate by a fine metal mask method.

At this point, the fine metal mask, that is, a mask for deposition may have a through-hole corresponding to the pattern to be formed on the substrate, and, patterns of red (R), green (G), and blue (B) forming a pixel may be formed by depositing the organic material after the fine metal mask is aligned on the substrate.

Recently, various electronic devices such as a virtual reality (VR) device require a display device having ultra-high definition (UHD). Accordingly, a fine metal mask having a fine-sized through-hole capable of forming an ultra-high resolution (UHD-class) pattern is required.

In a metal plate that may be used as a deposition mask, a plurality of through-holes may be formed by an etching process.

At this time, when a surface roughness in a longitudinal direction of the metal plate is different from that in a lateral direction of the metal plate, adhesion of a photoresist layer disposed on a surface of the metal plate may be different from each other depending on a direction. That is, when a deviation between the surface roughness in the longitudinal direction of the metal plate and the surface roughness in the lateral direction of the metal plate is large, a difference in a degree of etching may occur depending on the direction due to a difference in the adhesion of the photoresist layer. Therefore, it is not possible to form a through-hole having a desired size, and thus, there is a problem that uniformity of a hole diameter of the through-hole may be lowered. In addition, in the deposition mask, disappearance and non-uniformity of an island portion may occur due to the difference in the adhesion of the photoresist layer, and accordingly, non-uniformity occurs between the through-holes during a tensioning process before pixel deposition, and thus, there is a problem that it is difficult to deposit a pixel at a target position using the deposition mask.

Therefore, a deposition mask having a new structure capable of uniformly forming a high-resolution or ultra-high resolution (UHD-class) pattern of 500 PPI or more without deposition failure, and a method of producing the same are required.

The document KR 2016 0126807 A provides an example of a metal substrate and mask using the same. According to an embodiment the metal substrate and the mask for deposition have a twist index (hr) in order to minimize a twist phenomenon generated when the metal substrate is etched.

The document JP H04 103743 A provides an example of Fe-Ni alloy thin sheet for shadow mask and its manufacture. To improve the pierceability in etching in an Fe-Ni alloy thin sheet and to prevent the adhesion seizure therein at the time of annealing by regulating the content of Si, the surface roughness, the mean space between the recessed and projected parts in a sectional 1curve and the componental segregating rate of Si in an Fe-Ni series alloy steel strip.

The document WO 2017/013903 A1 provides an example of metal mask base, metal mask and method for producing metal mask. The metal mask base is provided with a metal surface that is configured such that a resist is arranged thereon. The three-dimensional surface roughness Sa of the surface is 0.11 µm or less, and the three-dimensional surface roughness Sz of the surface is 3.17 µm or less.

### [Disclosure]

### [Technical Problem]

The claimed invention is directed to providing a metal deposition mask as set out in appended claim 1 and capable of improving uniformity of a position, a shape, and the like of a through-hole formed on a metal plate by minimizing internal stress.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

In a metallic material deposition mask for OLED pixel deposition according to an embodiment of the present invention, the deposition mask includes a deposition region for forming a deposition pattern and a non-deposition region other than the deposition region, wherein the deposition region includes a plurality of effective portions spaced apart in a longitudinal direction and an ineffective portion other than the effective portion, wherein the effective portion includes: a plurality of small surface holes formed on one surface; a plurality of large surface holes formed on the other surface opposite to the one surface; a through-hole communicating the small surface hole and the large surface hole; and an island portion between the plurality of through-holes, wherein the deposition mask has a resolution of 500 PPI or more in which a diameter of the through-hole is 33 um or less and a distance between respective centers of two adjacent through-holes of the through-holes is 48 um or less, an inclination angle of the large surface hole with respect to the other surface is 40 degrees to 55 degrees, an average centerline average surface roughness in a longitudinal direction and an average centerline average surface roughness in a lateral direction of the non-deposition region are 0.1 um to 0.3 um, an average 10-point average surface roughness Rz in the longitudinal direction and an average 10-point average surface roughness in the lateral direction of the non-deposition region are 0.5 um to 2.0 um, a deviation of a value of the average centerline average surface roughness in the longitudinal direction with respect to the average centerline average surface roughness in the lateral direction is less than 50%, and a deviation of a value of the average 10-point average surface roughness in the longitudinal direction with respect to the average 10-point average surface roughness in the lateral direction is less than 50%.

In addition, in a metallic material deposition mask for OLED pixel deposition according to an embodiment of the present invention, the deposition mask includes a deposition region for forming a deposition pattern and a non-deposition region other than the deposition region, wherein the deposition region includes a plurality of effective portions spaced apart in a longitudinal direction and an ineffective portion other than the effective portion, wherein the effective portion includes: a plurality of small surface holes formed on one surface; a plurality of large surface holes formed on the other surface opposite to the one surface; a through-hole communicating the small surface hole and the large surface hole; and an island portion between the plurality of through-holes, wherein the deposition mask has a resolution of 500 PPI or more in which a diameter of the through-hole is 33 um or less and a distance between respective centers of two adjacent through-holes of the through-holes is 48 um or less, and an inclination angle of the large surface hole with respect to the other surface is 40 degrees to 55 degrees, an average centerline average surface roughness in a longitudinal direction and an average centerline average surface roughness in a lateral direction of the island portion are 0.1 um to 0.3 um, and an average 10-point average surface roughness Rz in a longitudinal direction and an average 10-point average surface roughness in a lateral direction of the non-deposition region are 0.5 um to 2.0 um, and a deviation of a value of the average centerline average surface roughness in the longitudinal direction with respect to the average centerline average surface roughness in the lateral direction is less than 50%, and a deviation of a value of the average 10-point average surface roughness in the longitudinal direction with respect to the average 10-point average surface roughness in the lateral direction is less than 50%.

In addition, a method of producing a metallic material deposition mask for OLED pixel deposition includes: a first step of preparing a metal plate on which rolling and annealing are performed and having a predetermined thickness, in which an average centerline average surface roughness and an average 10-point average surface roughness in a rolling direction are smaller than an average centerline average surface roughness and an average 10-point average surface roughness in a transverse direction; a second step of surface treating the metal plate such that the average centerline average surface roughness in the rolling direction and the average centerline average surface roughness in the transverse direction are in a range of 0.1 um to 0.3 um, respectively, and the average 10-point average surface roughness in the rolling direction and the average 10-point average surface roughness in the transverse direction are in a range of 0.5 um to 2.0 um, respectively; and a third step of forming a plurality of large surface holes, a plurality of small surface holes and a plurality of through-holes formed by the large surface hole and small surface hole by applying and developing a patterned photoresist layer on a surface of the metal plate and etching the metal plate.

### [Advantageous Effects]

According to an embodiment, it is possible to provide a deposition mask capable of minimizing deposition failure in a deposition mask made of a metal material for OLED pixel deposition having a resolution of 500 PPI or more.

According to the embodiment, a metal plate for producing the deposition mask may have a deviation of 50% or less in roughness in a longitudinal direction and a lateral direction. Accordingly, the metal plate may improve adhesion with a photoresist layer regardless of the direction. Therefore, the deposition mask according to the embodiment may improve uniformity of an island portion and uniformity of a size of a through-hole.

In addition, according to the embodiment, a large surface hole of the through-hole has a first cross-sectional inclination angle in a longitudinal direction, and has a second cross-sectional inclination angle larger than the first cross-sectional inclination angle in a lateral direction. Accordingly, in the deposition mask of the embodiment, a thickness of a central portion of a rib disposed in the longitudinal direction may be increased by a difference between the first cross-sectional inclination angle and the second cross-sectional inclination angle. Accordingly, in the embodiment, rigidity of the deposition mask may be secured. In addition, in the embodiment, length deformation may be minimized as the rigidity of the deposition mask is secured. Further, in the embodiment, uniformity of a shape of a mask pattern and a position of the through-hole may be increased as the rigidity of the deposition mask is secured. Furthermore, in the embodiment, pattern deposition efficiency of the deposition mask may be improved as the uniformity is increased.

In addition, according to the embodiment, an inclination angle of a large surface hole of a through-hole disposed in a direction perpendicular to a moving direction of an organic material deposition container is reduced. Accordingly, the deposition mask according to the embodiment may uniformly deposit an OLED pixel pattern in all regions regardless of a position of the through-hole.

### [Description of Drawings]

FIG. 1 is a perspective view illustrating an organic material deposition device including a deposition mask according to an embodiment.
FIGS. 2 to 4 are conceptual diagrams describing a process of depositing an organic material on a substrate using a deposition mask according to an embodiment.
FIG. 5 is a view illustrating a plan view of a deposition mask according to an embodiment.
FIG.6A is a view illustrating a plan view of an effective portion of a deposition mask.
FIG.6B is a photograph illustrating a plan view of an effective portion of a deposition mask.
FIG. 6C is a view in which a cross-sectional view taken along line A-A' and a cross-sectional view taken along line B-B' are overlapped in FIG. 6A or 6B.
FIG. 7 is a view illustrating another plan view of deposition mask according to an embodiment.
FIG. 8 is a cross-sectional view taken along line B-B' in FIG. 6A or 6B of a deposition mask according to an embodiment.
FIG. 9 is a view showing a rolling step of a metal material.
FIGS. 10 and 11 are views showing a metal plate having a predetermined thickness after the rolling and annealing of FIG. 9.
FIGS. 12 and 13 are SEM photographs of the metal plate according to FIG. 11.
FIG. 14 is a view illustrating a step of preparing a metal plate having a predetermined thickness and etching the metal plate to be thinner than the predetermined thickness so as to have a surface roughness of an embodiment.
FIG. 15 and FIG. 16 are SEM photographs of a non-deposition region of a deposition mask according to an embodiment.
FIG. 17 is views illustrating a manufacturing process of a deposition mask according to Example.
FIG. 18 is a graph showing measured values of roughness in a longitudinal direction, a diagonal direction, and a lateral direction of a non-deposition region of a deposition mask according to Example.
FIG. 19 is a view showing adhesion to a photoresist layer according to a surface roughness of a non-deposition region of a deposition mask according to Example.
FIG. 20 is a view illustrating a shape obtained by half-etching one surface of a metal plate in order to evaluate a shape of an island portion of a deposition mask according to Example.
FIG. 21 is a graph showing measured values of roughness in a longitudinal direction, a diagonal direction, and a lateral direction of a non-deposition region of a deposition mask according to Comparative Example.
FIG. 22 is a view showing adhesion to a photoresist layer according to a surface roughness of a non-deposition region of a deposition mask according to Comparative Example.
FIG. 23 is a view illustrating a shape obtained by half-etching one surface of a metal plate in order to evaluate a shape of an island portion of a deposition mask according to Comparative Example.
FIG. 24 is a view illustrating that a metal plate as a raw material of a deposition mask has been wound.
FIG. 25 is a view for describing a conventional residual stress measurement method.
FIG. 26 is a view for describing a sample metal plate manufactured from a metal plate according to Example.
FIG. 27 is a view for describing a residual stress measurement method according to Example.
FIG. 28 and FIG. 29 are views illustrating a deposition pattern formed through a deposition mask according to an embodiment.
FIG. 30 is a view illustrating a plan view of an effective portion of a deposition mask according to another embodiment of the present invention.
FIG. 31 is a view in which respective cross sections are overlapped in order to describe a height difference and a size between a cross section taken along line A-A' and a cross section taken along line B-B' in FIG. 30.
FIG. 32 is a view illustrating a cross-sectional view taken along line B-B' in FIG. 30.
FIG. 33 is a view illustrating a cross-sectional view taken along line C-C' in FIG. 30.
FIG. 34 is a view illustrating a cross-sectional view taken along line D-D' in FIG. 30.
FIG. 35 is a view illustrating a plan view of an effective portion of a deposition mask according to still another embodiment of the present invention.
FIG. 36 is a cross-sectional view showing a second through-hole in FIG. 35.
FIG. 37 is a cross-sectional view showing a third through-hole in FIG. 35.

### [Modes of the Invention]

Hereinafter, embodiments will be described in detail with reference to the accompanying drawings.

However, the technical scope of the present invention, which is set out in the appended set of claims, is not limited to a part of the embodiments described, and may be implemented in various other forms, and within the technical scope of the present invention, one or more of the elements of the embodiments may be selectively combined and replaced.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art. Further, the terms used in the embodiments of the present invention are for describing the embodiments and are not intended to limit the present invention.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present invention, the terms such as first, second, A, B, (a), and (b) may be used.

These terms are only used to distinguish the elements from other elements, and the terms are not limited to the essence, order, or order of the elements. In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements. Furthermore, when expressed as "on (over)" or "under (below)", it may include not only the upper direction but also the lower direction based on one element.

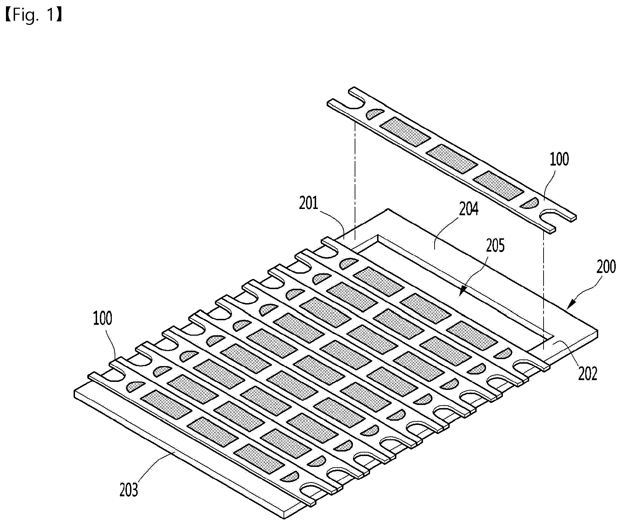

A process of depositing an organic material on a substrate using a deposition mask according to an embodiment will be described with reference to FIGS. 1 to 4.

Referring to FIGS. 1 to 4, the organic material deposition apparatus may include a deposition mask 100, a mask frame 200, a substrate 300, an organic material deposition container 400, and a vacuum chamber 500.

In the claimed invention, the metal deposition mask 100 includes a metal. For example, the deposition mask may include iron (Fe) and nickel (Ni). The deposition mask100 may include a plurality of through-holes TH at an effective portion for deposition. The deposition mask 100 may be a substrate for deposition mask including a plurality of through-holes TH. At this point, the through-holes may be formed to correspond to patterns to be formed on the substrate. The deposition mask 100 may include an ineffective portion other than the effective portion including a deposition region.

The mask frame 200 may include an opening 205. The plurality of through-holes of the deposition mask 100 may be disposed on a region corresponding to the opening 205. Accordingly, organic material supplied to the organic material deposition container 400 may be deposited on the substrate 300. The deposition mask may be disposed and fixed on the mask frame 200. For example, the deposition mask may be pulled and fixed on the mask frame 200 by welding.

That is, the mask frame 200 includes a plurality of frames 201, 202, 203, and 204 surrounding the opening 205. The plurality of frames 20, 202, 203, and 204 may be connected to each other. The mask frame 200 faces each other in a x direction, and includes a first frame 201 and a second frame 202 extending along a y direction. Further, the mask frame 200 faces each other in the y direction, and includes a third frame 203 and a fourth frame 204 extending along the x direction. The first frame 201, the second frame 202, the third frame 203, and the fourth frame 204 may be rectangular frames connected to each other. The mask frame 200 may be made of a material having small deformation during welding of the deposition mask 130, for example, a metal having high rigidity.

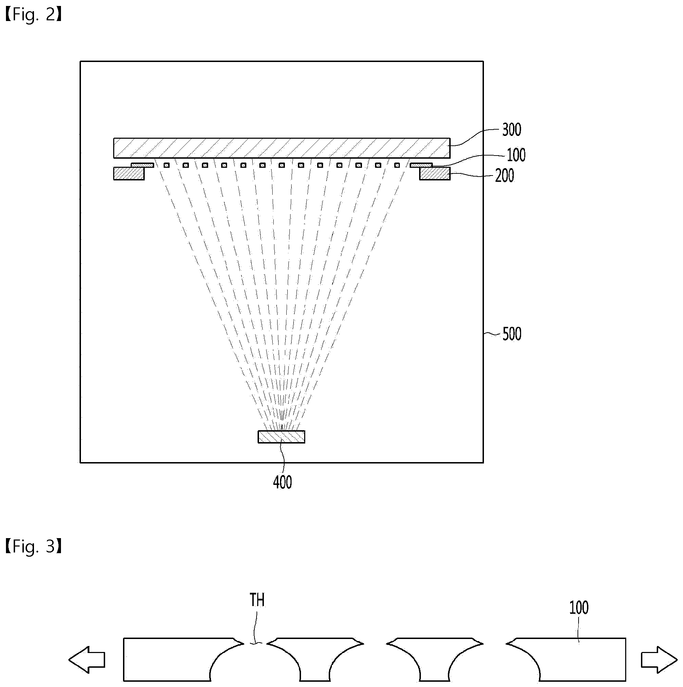

Referring to FIGS. 2 and 3, during a deposition process, the deposition mask 100 may be pulled in opposite directions at an end disposed on the outermost portion of the deposition mask 100. In the deposition mask 100, one end of the deposition mask 100 and the other end opposite to the one end may be pulled in opposite directions in a longitudinal direction of the deposition mask 100. As an example, a tensile direction, an x-axis direction, and the longitudinal direction of the deposition mask 100 may be all the same direction. The one end and the other end of the deposition mask 100 may face each other and be disposed in parallel. The one end of the deposition mask 100 may be one of end portions forming four side surfaces disposed on the outermost portion of the deposition mask 100. For example, the deposition mask 100 may be pulled at a tensile force of 0.1 kgf to 2 kgf. Specifically, the deposition mask 100 may be pulled at a tensile force of 0.4 kgf to 1.5 kgf to be fixed on the mask frame 200. Accordingly, a stress of the deposition mask 100 may be reduced. However, the embodiment is not limited thereto, and the deposition mask 100 may be pulled by various tensile forces that may reduce the stress thereof to be fixed on the mask frame 200.

Then, the deposition mask 100 may be fixed to the mask frame 200 by welding the ineffective portion of the deposition mask 100. Subsequently, a portion of the deposition mask 100 disposed outside the mask frame 200 may be removed by a method such as cutting.

The substrate 300 may be a substrate used for manufacturing a display device. For example, the substrate 300 may be a substrate 300 for depositing an organic material for an OLED pixel pattern. Patterns of red (R), green (G), and blue (B) may be formed on the substrate 300 to form a pixel that is three primary colors of light. That is, an RGB pattern may be formed on the substrate 300.

The organic material deposition container 400 may be a crucible. An organic material may be disposed at an inside of the crucible. The organic material deposition container 400 may move in the vacuum chamber 500. That is, the organic material deposition container 400 may move in the y-axis direction in the vacuum chamber 500. That is, the organic material deposition container 400 may move in the lateral direction of the deposition mask 100 in the vacuum chamber 500. That is, the organic material deposition container 400 may move in the vacuum chamber 500 in a direction perpendicular to the tensile direction of the deposition mask 100.

As a heat source and/or current is supplied to the crucible that is the organic deposition container 400 in the vacuum chamber 500, the organic material may be deposited on the substrate 100.

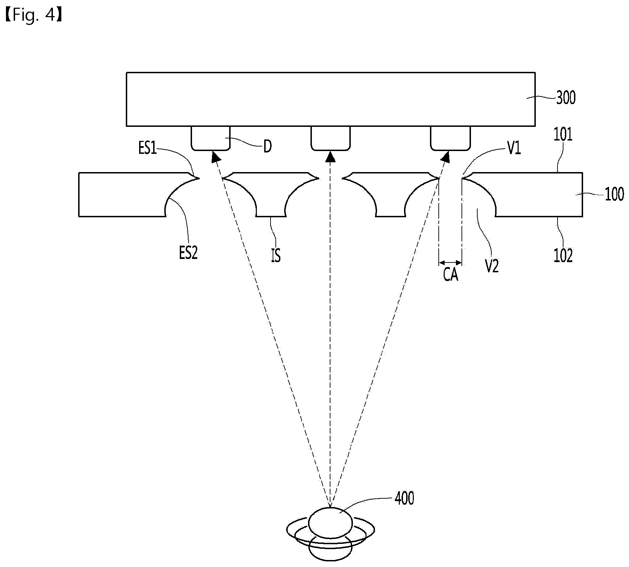

FIG. 4 is a view illustrating that a plurality of deposition patterns are formed on the substrate 300 through a plurality of through-holes of the deposition mask 100.

In the claimed invention, the metal deposition mask 100 includes a first surface 101 and a second surface 102 facing the first surface.

The first surface 101 of the deposition mask 100 may include a small surface hole V1, and the second surface 102 of the deposition mask 100 may include a large surface hole V2. The through-hole may be communicated by a communication portion CA to which the boundary of the small surface hole V1 and the large surface hole V2 is connected.

The deposition mask 100 may include a first etching surface ES1 in the small surface hole V1. The deposition mask 100 may include a second etching surface ES2 in the large surface hole V2. The through-hole may be formed by communicating the first etching surface ES1 in the small surface hole V1 and the second etching surface ES2 in the large surface hole V2. For example, the first etching surface ES1 in one small surface hole V1 may communicate with the second etching surface ES2 in one large surface hole V2 to form one through-hole.

A width of the large surface hole V2 may be greater than that of the small surface hole V1. At this time, the width of the small surface hole V1 may be measured at the first surface 101, and the width of the large surface hole V2 may be measured at the second surface 102.

The small surface hole V1 may be disposed toward the substrate 300. The small surface hole V1 may be disposed close to the substrate 300. Accordingly, the small surface hole V1 may have a shape corresponding to a deposition material, that is, a deposition pattern DP.

The large surface hole V2 may be disposed toward the organic material deposition container 400. Accordingly, the large surface hole V2 may accommodate the organic material supplied from the organic material deposition container 400 in a wide width, and a fine pattern may be formed quickly on the substrate 300 through the small surface hole V1 having a width smaller than that of the large surface hole V2.

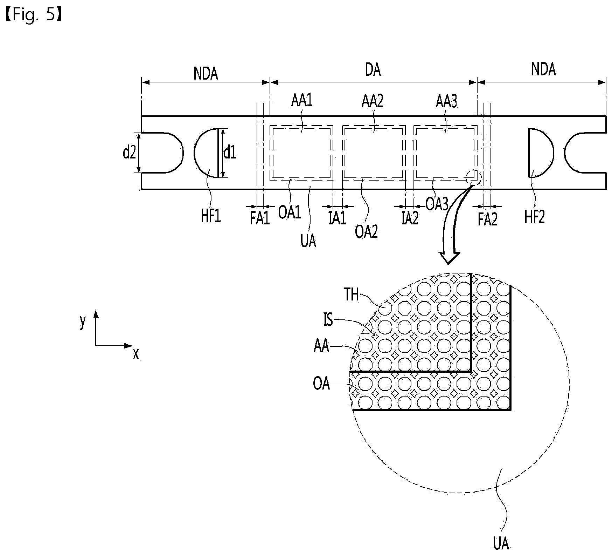

FIG. 5 is a view illustrating a plan view of a deposition mask according to the claimed invention. Referring to FIG. 5, the deposition mask according to the embodiment includes a deposition region DA and a non-deposition region NDA.

The deposition region DA is a region for forming a deposition pattern. One deposition mask may include a plurality of deposition regions DA. For example, the deposition region DA of an embodiment may include a plurality of effective portions AA1, AA2, and AA3 capable of forming a plurality of deposition patterns.

The plurality of effective portions may include a first effective portion AA1, a second effective portion AA2, and a third effective portion AA3. One deposition region DA may be any one of the first effective portion AA1, the second effective portion AA2, and the third effective portion AA3.

In the case of a small-sized display device such as a smartphone, an effective portion of any one of a plurality of deposition regions included in the deposition mask may be one for forming one display device. Accordingly, one deposition mask may include a plurality of effective portions to form a plurality of display devices at the same time. Therefore, the deposition mask according to an embodiment may improve process efficiency.

Alternatively, in case of a large-sized display device such as a television, a plurality of effective portions included in one deposition mask may be a part for forming one display device. In this case, the plurality of effective portions may be for preventing deformation due to a load of the mask.

The deposition region DA may include a plurality of isolation regions IA1 and IA2 included in one deposition mask. The isolation regions IA1 and IA2 may be disposed between adjacent effective portions. The isolation regions IA1 and IA2 may be spaced regions between the plurality of effective portions. For example, a first isolation region IA1 may be disposed between the first effective portion AA1 and the second effective portion AA2. For example, a second isolation region IA2 may be disposed between the second effective portion AA2 and the third effective portion AA3. The isolation region may distinguish adjacent effective regions, and the plurality of effective portions may be supported by one deposition mask.

The isolation regions IA1 and IA2 may have the same height as the island portion, the non-deposition region, or the non-effective region. The isolation regions IA1 and IA2 may be regions that are not etched when forming through-holes.

The deposition mask may include a non-deposition region NDA on both side portions in a longitudinal direction of the deposition region DA. The deposition mask according to an embodiment may include the non-deposition region NDA on both sides in a horizontal direction of the deposition region DA.

The non-deposition region NDA of the deposition mask may be a region not involved in a deposition. The non-deposition region NDA may include frame fixing regions FA1 and FA2 for fixing the deposition mask to a mask frame. For example, the non-deposition region NDA of the deposition mask may include a first frame fixing region FA1 on one side of the deposition region DA, and may include a second frame fixing region FA2 on the other side opposite to the one side of the deposition region DA. The first frame fixing region FA1 and the second frame fixing region FA2 may be region s fixed to the mask frame by welding.

The non-deposition region NDA may include half-etching portions HF1 and HF2. For example, the non-deposition region NDA of the deposition mask may include a first half-etching portion HF1 on one side of the deposition region DA, and may include a second half-etching portion HF2 on the other side opposite to the one side of the deposition region DA. The first half-etching portion HF1 and the second half-etching portion HF2 may be regions in which grooves are formed in a depth direction of the deposition mask. The first half-etching portion HF1 and the second half-etching portion HF2 may have a groove having a thickness of about 1/2 of the deposition mask, thereby dispersing stress when the deposition mask is pulled.

The half-etching portion may be simultaneously formed when forming a small surface hole or a large surface hole. Accordingly, it is possible to improve process efficiency.

Surface treatment layer different from a material of a metal plate may be formed in the deposition region DA of the deposition mask, and the surface treatment layer may not be formed in the non-deposition region NDA. Alternatively, the surface treatment layer different from the material of the metal plate may be formed on only one surface or the other surface opposite to the one surface of the deposition mask. Alternatively, the surface treatment layer different from the material of the metal plate may be formed only on a portion of one surface of the deposition mask. For example, one surface and/or the other surface of the deposition mask, and the entire and/or a portion of the deposition mask may include surface treatment layer having a lower etch rate than that of the material of the metal plate, thereby improving an etching factor. Accordingly, the deposition mask of an embodiment may form a through-hole having a fine size with high efficiency. As an example, the deposition mask of the embodiment may form a deposition pattern having a high-resolution of 500 PPI or more with high efficiency. Here, the surface treatment layer may include a material different from the material of the metal plate, or may include a metal material having a different composition of the same element.

The half-etching portion may be formed in an ineffective portion UA of the deposition region DA. The half-etching portion may be dispersed in the entire or a part of the ineffective portion UA to be disposed in plural in order to disperse a stress when the deposition mask is pulled.

In addition, the half-etching portion may be formed in the frame fixing region and/or a peripheral region of the frame fixing region. Accordingly, a stress of the deposition mask generated when fixing the deposition mask to the mask frame, and/or depositing a deposition material after fixing the deposition mask to the mask frame may be uniformly dispersed. Accordingly, the deposition mask may be maintained so as to have a uniform through-hole.

The frame fixing regions FA1 and FA2 for fixing to the mask frame of the non-deposition region NDA may be disposed between the half-etching portions HF1 and HF2 of the non-deposition region NDA and an effective portion of the deposition region DA adjacent to the half-etching portions HF1 and HF2. For example, the first frame fixing region FA1 may be disposed between the first half-etching portion HF1 of the non-deposition region NDA and the first effective portion AA1 of the deposition region DA adjacent to the first half-etching portion HF1. For example, the second frame fixing region FA2 may be disposed between the second half-etching portion HF2 of the non-deposition region NDA and the third effective portions AA3 of the deposition region DA adjacent to the second half-etching portion HF2. Accordingly, it is possible to simultaneously fix a plurality of deposition pattern portions.

The deposition mask may include a semicircular shaped open portion at both ends in a horizontal direction X. The non-deposition region NDA of the deposition mask may include one semicircular shaped open portion at each of both ends in the horizontal direction. For example, the non-deposition region NDA of the deposition mask may include an open portion of which a center in a vertical direction Y is opened on one side in the horizontal direction. For example, the non-deposition region NDA of the deposition mask may include the open portion of which the center in the vertical direction is opened on the other side opposite to the one side in the horizontal direction. That is, both ends of the deposition mask may include the open portion at 1/2 point of a length in the vertical direction. For example, both ends of the deposition mask may be shaped like a horseshoe.

The half-etching portion included in the deposition mask of the embodiment may be formed in various shapes. The half-etching portion may include a semi-circular shaped groove portion. The groove may be formed on at least one of one surface of the deposition mask and the other surface opposite to the one surface. Preferably, the half-etching portion may be formed on a surface corresponding to the small surface hole (a surface side to be deposited). Accordingly, the half-etching portion may be formed at the same time with the small surface hole, thereby improving process efficiency. In addition, the half-etching portion may disperse a stress that may be generated due to a difference in size between large surface holes.

Alternatively, the half-etching portion may be formed on both sides of the deposition mask in order to disperse the stress of the deposition mask. In this case, a half-etching region of the half-etching portion may be wider in a plane corresponding to a first surface hole (a surface side to be deposited). That is, the deposition mask according to the embodiment may include the half-etching portion as grooves are formed on first and second surfaces of the deposition mask, respectively. In detail, a depth of the groove of the half-etching portion formed on the first surface may be greater than that of the groove of the half-etching portion formed on the second surface. Accordingly, the half-etching portion may disperse a stress that may occur due to a difference in a size between the small surface hole and the large surface hole. Formation of the small surface hole, the large surface hole, and the half-etching portion may make surface areas on the first and second surfaces of the deposition mask similar to each other, thereby preventing displacement of the through-holes.

In addition, the grooves formed on the first surface and the second surface may be formed so as to be displaced from each other. Accordingly, the half-etching portion may not be passed through.

The half-etching portion may include a curved surface and a flat surface. The flat surface of the first half-etching portion HF1 may be disposed to be adjacent to the first effective region AA1, and the flat surface may be disposed horizontally with an end in a longitudinal direction of the deposition mask. The curved surface of the first half-etching portion HF1 may have a convex shape toward one end in the longitudinal direction of the deposition mask. For example, the curved surface of the first half-etching portion HF1 may be formed such that a 1/2 point of a length in a vertical direction of the deposition mask corresponds to the radius of a semicircular shape.

The flat surface of the second half-etching portion HF2 may be disposed to be adjacent to the third effective region AA3, and the flat surface may be disposed horizontally with an end in a longitudinal direction of the deposition mask. The curved surface of the second half-etching portion HF2 may have a convex shape toward the other end in the longitudinal direction of the deposition mask. For example, the curved surface of the second half-etching portion HF2 may be formed such that a 1/2 point of a length in a vertical direction of the deposition mask corresponds to the radius of a semicircular shape.

Meanwhile, a curved surface of the open portion positioned at the both ends of the deposition mask may be directed to the half-etching portion. Accordingly, the open portions at the both ends of the deposition mask may have the shortest separation distance at 1/2 point of a length in the vertical direction of the first or second half-etching portion and the deposition mask. quadrangular shape

Although not shown in the drawings, the half-etching portion may have a quadrangular shape. The first half-etching portion HF1 and the second half-etching portion HF2 may have a rectangular or square shape.

The deposition mask according to the embodiment may include a plurality of half-etching portions. The deposition mask according to the embodiment may include a plurality of half-etching portions in at least one of the deposition region DA and the non-deposition region NDA. The deposition mask according to the embodiment may include the half-etching portion only in the ineffective portion UA. The ineffective portion UA may be a region other than the effective portion AA.

The deposition mask according to the embodiment may include two half-etching portions. Although not shown in the drawings, the deposition mask according to the embodiment may include four half-etching portions. For example, the half-etching portion may include an even number of half-etching portions, thereby efficiently dispersing a stress. The deposition mask according to the embodiment may be disposed only in the non-deposition region NDA.

It is preferable to form the half-etching portion to be symmetric in an X-axis direction or in a Y-axis direction with respect to a center of the mask. Through the same, it is possible to equalize a tensile force in both directions.

A length d1 in a vertical direction of the first half-etching portion HF1 or the second half-etching portion HF2 may correspond to a length d2 in a vertical direction of the open portion. Accordingly, when the deposition mask is pulled, a stress may be uniformly dispersed, so that the deformation (wave deformation) of the deposition mask may be reduced. Therefore, the deposition mask according to the embodiment may have a uniform through-hole, so that the deposition efficiency of the pattern may be improved. Preferably, the length d1 in the vertical direction the first half-etching portion HF1 or the second half-etching portion HF2 may be about 80% to 200% of the length d2 in the vertical direction of the open portion (d1:d2 = 0.8 to 2:1). The length d1 in the vertical direction of the first half-etching portion HF1 or the second half-etching portion HF2 may be about 90% to about 150% of the length d2 in the vertical direction of the open portion (d1:d2 = 0.9 to 1.5:1). The length d1 in the vertical direction of the first half-etching portion HF1 or the second half-etching portion HF2 may be about 95% to about 110% of the length d2 in the vertical direction of the open portion (d1:d2 = 0.95 to 1.1:1).

In the claimed invention, the metal mask includes a plurality of effective portions AA1, AA2, and AA3 spaced in the longitudinal direction and an ineffective portion UA other than the effective portion.

The effective portions AA1, AA2, and AA3 of the deposition mask include a plurality of through-holes TH and an island portion IS supporting between the plurality of through-holes TH. The island portion IS may refer to a portion which is not etched in one surface or the other surface of the effective portion of the deposition mask when the through-hole is formed. In detail, the island portion IS may be a non-etched region between the through-hole and the through-hole on the other surface on which the large surface hole of the effective portion of the deposition mask is formed. Therefore, the island portion IS may be disposed in parallel with one surface of the deposition mask.

The island portion IS may be disposed coplanar with the other surface of the deposition mask. Accordingly, the island portion IS may have the same thickness as at least a portion of the ineffective portion on the other surface of the deposition mask. In detail, the island portion IS may have the same thickness as a non-etched portion of the ineffective portion on the other surface of the deposition mask. Accordingly, deposition uniformity of a sub-pixel may be improved through the deposition mask.

Alternatively, the island portion IS may be disposed in a flat surface parallel to the other surface of the deposition mask. Here, the parallel flat surface may include that a step in height of the other surface of the deposition mask in which the island portion IS is disposed and the other surface of the non-etched deposition mask of the ineffective portions is ± 1 um or less by an etching process around the island portion IS.

The island portion IS may be positioned between adjacent through-holes among the plurality of through-holes. That is, a region other than the through-hole may be an island portion IS in the effective portions AA1, AA2, and AA3 of the deposition mask 100.

The effective portions AA1, AA2, and AA3 include a plurality of small surface holes V1 formed on one surface of the deposition mask 100, a plurality of large surface holes V2 formed on the other surface opposite to the one surface, and a through-hole TH formed by a communication portion CA in which a boundary between the small surface hole and the large surface hole is connected.

The deposition mask100 may include an ineffective portion UA disposed at an outer periphery of the effective region.

The effective portion AA may be an inner region when an outer periphery of through-holes positioned at the outermost portion for depositing an organic material among a plurality of through-holes is connected. The ineffective portion UA may be an outer region when the outer periphery of the through-holes positioned at the outermost portion for depositing the organic material among the plurality of through-holes is connected.

The ineffective portion UA is a region excluding the effective region of the deposition region DA and the non-deposition region NDA. The ineffective portion UA may include outer regions OA1, OA2, and OA3 surrounding an outer periphery of the effective portions AA1, AA2, and AA3.

The deposition mask according to the embodiment may include a plurality of outer regions OA1, OA2, and OA3. The number of the outer regions may correspond to the number of the effective portions. That is, one effective portion may include one outer region spaced apart at a predetermined distance in the horizontal direction and the vertical direction from an end of one effective portion.

The first effective portion AA1 may be included in a first outer region OA1. The first effective portion AA1 may include a plurality of through-holes for forming a deposition material. The first outer region OA1 surrounding the outer periphery of the first effective portion AA1 may include a plurality of through-holes.

A shape of the through-hole TH of the first effective portion AA1 may correspond to a shape of the through-hole of the first outer region OA1. Accordingly, uniformity of the through-hole included in the first effective portion AA1 may be improved. For example, the shape of the through-hole TH of the first effective portion AA1 and the shape of the through-hole of the first outer region OA1 may be in a circular shape. However, the embodiment is not limited thereto, and the through-hole may have various shapes such as a diamond pattern, an oval pattern, and the like.

The plurality of through-holes included in the first outer region OA1 is for reducing etching failure of the through-holes positioned at the outermost portion of the effective portion. Accordingly, the deposition mask according to the embodiment may improve the uniformity of the plurality of through-holes positioned in the effective portion, and may improve the quality of the deposition pattern produced through the same.

The through-hole included in the effective portion may have a shape partially corresponding to that of the through-hole included in the ineffective portion. As an example, the through-hole included in the effective portion may have a different shape from that of a through-hole positioned at an edge portion of the ineffective portion. Accordingly, it is possible to adjust a difference in stress according to a position of the deposition mask.

The second effective portion AA2 may be included in the second outer region OA2. The second effective portion AA2 may have a shape corresponding to the first effective portion AA1. The second outer region OA2 may have a shape corresponding to the first outer region OA1.

The second outer region OA2 may further include two through-holes in the horizontal direction and the vertical direction, respectively, from the through-hole positioned at the outermost portion of the second effective portion AA2. For example, in the second outer region OA2, two through-holes may be disposed in a row in the horizontal direction at an upper and a lower portion of the through-hole positioned at the outermost portion of the second effective portion AA2, respectively. For example, in the second outer region OA2, two through-holes may be disposed in a line in the vertical direction at the left side and the right side of the through-hole positioned at the outermost portion of the second effective portion AA2, respectively. The plurality of through-holes included in the second outer region OA2 is for reducing etching failure of the through-holes positioned at the outermost portion of the effective portion. Accordingly, the deposition mask according to the embodiment may improve the uniformity of the plurality of through-holes positioned in the effective portion, and may improve the quality of the deposition pattern manufactured through the same.

The third effective portion AA3 may be included in the third outer region OA3. The third effective portion AA3 may include a plurality of through-holes for forming a deposition material. The third outer region OA3 surrounding the outer periphery of the third effective portion AA3 may include a plurality of through-holes.

The third effective portion AA3 may be in a shape corresponding to that of the first effective portion AA1. The third outer region OA3 may be in a shape corresponding to that of the first outer region OA1.

A value of surface roughness measured in the non-deposition region NDA except for the half-etching portions HF1 and HF2 of the deposition mask according to the embodiment may have a predetermined range in the diagonal direction positioned at about 45 degrees in the longitudinal direction (x direction) and the lateral direction (y direction). The diagonal direction may be an inclination direction of about +45 degrees, or about -45 degrees, and may refer to an angle between the x direction and the y direction. The diagonal direction may include an angle between +40 degrees to +50 degrees, or -40 degrees to - 50 degrees.

In the non-deposition region DA, an average centerline average surface roughness in the longitudinal direction, an average centerline average surface roughness in about a +45 degree direction in the diagonal, an average centerline average surface roughness in about a -45 degree direction in the diagonal, and an average centerline average surface roughness in the lateral direction is 0.1 um to 0.3 um, and in the non-deposition region DA, an average 10-point average surface roughness in the longitudinal direction, an average 10-point average surface roughness in about a +45 degree direction in the diagonal, an average 10-point average surface roughness in about a -45 degree direction in the diagonal, and an average 10-point average surface roughness in the lateral direction may be 0.5 um to 2.0 um. For example, the average centerline average surface roughness in the longitudinal direction, the average centerline average surface roughness in about the +45 degree direction in the diagonal, the average centerline average surface roughness in about the - 45 degree direction in the diagonal, and the average centerline average surface roughness in the lateral direction in the non-deposition region DA may be 0.1 um to 0.2 um, and the average 10-point average surface roughness in the longitudinal direction, the average 10-point average surface roughness in about the +45 degree direction in the diagonal, the average 10-point average surface roughness in about the -45 degree direction in the diagonal, and the average 10-point average surface roughness in the lateral direction in the non-deposition region DA may be 0.5 um to 1.5 um. For example, the average centerline average surface roughness in the longitudinal direction, the average centerline average surface roughness in about the +45 degree direction in the diagonal, the average centerline average surface roughness in about the -45 degree direction in the diagonal, and the average centerline average surface roughness in the lateral direction in the non-deposition region DA may be 0.1 um to 0.15 um, and the average 10-point average surface roughness in the longitudinal direction, the average 10-point average surface roughness in about the +45 degree direction in the diagonal, the average 10-point average surface roughness in about the -45 degree direction in the diagonal, and the average 10-point average surface roughness in the lateral direction in the non-deposition region DA may be 0.5 um to 1.0 um.

In an OLED deposition mask having a quad high definition (QHD) class resolution of 500 PPI or more of the embodiment, a diameter of a through-hole may be 33 um or less, a distance between each center of two adjacent through-holes among the plurality of through-holes may be 48 um or less, an inclination angle of a large surface hole with respect to the other surface may be 40 degrees to 55 degrees, a deviation ((|(Ra(RD)-Ra(TD))|/Ra(TD)x100(%))) of a value of an average surface roughness (Ra(RD)) of an average centerline in the longitudinal direction with respect to an average surface roughness (Ra(TD)) of an average centerline in the lateral direction may be less than 50%, and a deviation ((|(Rz(RD)-Rz(TD))|/Rz(TD)x100(%))) of a value of an average surface roughness (Rz(RD)) of an average 10-point in the longitudinal direction with respect to an average surface roughness (Rz(TD)) of an average 10-point in the lateral direction may be less than 50%.

In an OLED deposition mask having a UHD-class resolution of 800 PPI or more of the embodiment, a diameter of a through-hole may be 20 um or less, an inclination angle of a large surface hole with respect to the other surface may be 45 degrees to 55 degrees, a distance between each center of two adjacent through-holes among the plurality of through-holes may be 32 um or less, a deviation ((|(Ra(RD)-Ra(TD))|/Ra(TD)x100(%))) of a value of an average surface roughness (Ra(RD)) of an average centerline in the longitudinal direction with respect to an average surface roughness (Ra(TD)) of an average centerline in the lateral direction may be 30% or less, and a deviation ((|(Rz(RD)-Rz(TD))|/Rz(TD)x100(%))) of a value of an average surface roughness (Rz(RD)) of an average 10-point in the longitudinal direction with respect to an average surface roughness (Rz(TD)) of an average 10-point in the lateral direction may be 30% or less. For example, the deviation ((|(Ra(RD)-Ra(TD))|/Ra(TD)x100(%))) of the value of the average surface roughness (Ra(RD)) of the average centerline in the longitudinal direction with respect to the average surface roughness (Ra(TD)) of the average centerline in the lateral direction may be 15% or less, and the deviation ((|(Rz(RD)-Rz(TD))|/Rz(TD)x100(%))) of the value of the average surface roughness (Rz(RD)) of the average 10-point in the longitudinal direction with respect to the average surface roughness (Rz(TD)) of the average 10-point in the lateral direction may be 15% or less.

For example, the deviation ((|(Ra(RD)-Ra(TD))|/Ra(TD)x100(%))) of the value of the average surface roughness (Ra(RD)) of the average centerline in the longitudinal direction with respect to the average surface roughness (Ra(TD)) of the average centerline in the lateral direction may be 13% or less, and the deviation ((|(Rz(RD)-Rz(TD))|/Rz(TD)x100(%))) of the value of the average surface roughness (Rz(RD)) of the average 10-point in the longitudinal direction with respect to the average surface roughness (Rz(TD)) of the average 10-point in the lateral direction may be 10% or less.

The deposition region may include the ineffective portion in a region other than the effective portion, and in a surface roughness of the island portion among the ineffective portions, an average centerline average surface roughness in the longitudinal direction, an average centerline average surface roughness in the diagonal direction, and an average centerline average surface roughness in the lateral direction is 0.1 um to 0.3 um, and an average 10-point average surface roughness in the longitudinal direction, an average 10-point average surface roughness in the diagonal direction, and an average 10-point average surface roughness in the lateral direction may be 0.5 um to 2.0 um, a deviation ((|(Ra(RD)-Ra(TD))|/Ra(TD)x100(%))) of a value of an average surface roughness (Ra(RD)) of an average centerline in the longitudinal direction with respect to an average surface roughness (Ra(TD)) of an average centerline in the lateral direction may be less than 50%, and a deviation ((|(Rz(RD)-Rz(TD))|/Rz(TD)x100(%))) of a value of an average surface roughness (Rz(RD)) of an average 10-point in the longitudinal direction with respect to an average surface roughness (Rz(TD)) of an average 10-point in the lateral direction may be less than 50%.

Alternatively, in the surface roughness of the island portion among the ineffective portions, the average centerline average surface roughness in the longitudinal direction, the average centerline average surface roughness in the diagonal direction, and the average centerline average surface roughness in the lateral direction may be 0.1 um to 0.2 um, and the average 10-point average surface roughness in the longitudinal direction, the average 10-point average surface roughness in the diagonal direction, and the average 10-point average surface roughness in the lateral direction may be 0.5 um to 1.5 um, the deviation ((|(Ra(RD)-Ra(TD))|/Ra(TD)x100(%))) of the value of the average surface roughness (Ra(RD)) of the average centerline in the longitudinal direction with respect to the average surface roughness (Ra(TD)) of the average centerline in the lateral direction may be less than 30%, and the deviation ((|(Rz(RD)-Rz(TD))|/Rz(TD)x100(%))) of the value of the average surface roughness (Rz(RD)) of the average 10-point in the longitudinal direction with respect to the average surface roughness (Rz(TD)) of the average 10-point in the lateral direction may be less than 30%.

Alternatively, in the surface roughness of the island portion among the ineffective portions, the average centerline average surface roughness in the longitudinal direction, the average centerline average surface roughness in the diagonal direction, and the average centerline average surface roughness in the lateral direction may be 0.1 um to 0.15 um, and the average 10-point average surface roughness in the longitudinal direction, the average 10-point average surface roughness in the diagonal direction, and the average 10-point average surface roughness in the lateral direction may be 0.5 um to 1.0 um, the deviation ((|(Ra(RD)-Ra(TD))|/Ra(TD)x100(%))) of the value of the average surface roughness (Ra(RD)) of the average centerline in the longitudinal direction with respect to the average surface roughness (Ra(TD)) of the average centerline in the lateral direction may be less than 15%, and the deviation ((|(Rz(RD)-Rz(TD))|/Rz(TD)x100(%))) of the value of the average surface roughness (Rz(RD)) of the average 10-point in the longitudinal direction with respect to the average surface roughness (Rz(TD)) of the average 10-point in the lateral direction may be less than 15%.

In isolation regions IA1 and IA2 positioned between adjacent effective portions AA1, AA2, and AA3, an average centerline average surface roughness in the longitudinal direction, an average centerline average surface roughness in the diagonal direction, and an average centerline average surface roughness in the lateral direction may be 0.1 um to 0.3 um, and in the ineffective portion, an average 10-point average surface roughness in the longitudinal direction, an average 10-point average surface roughness in the diagonal direction, and an average 10-point average surface roughness in the lateral direction may be 0.5 um to 2.0 um.

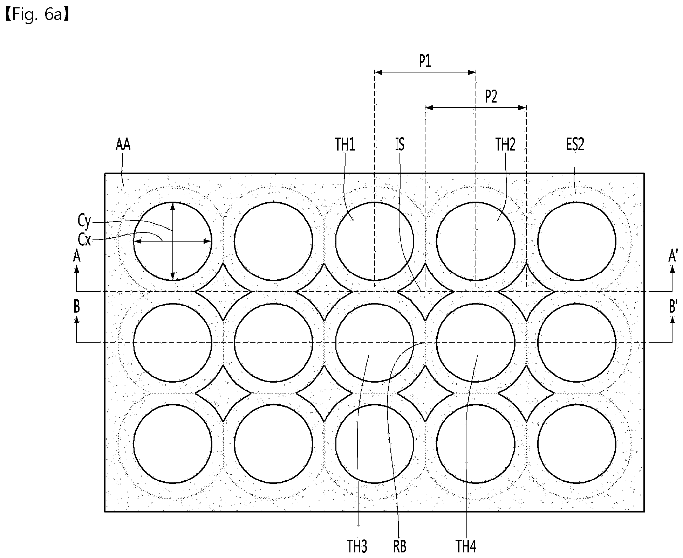

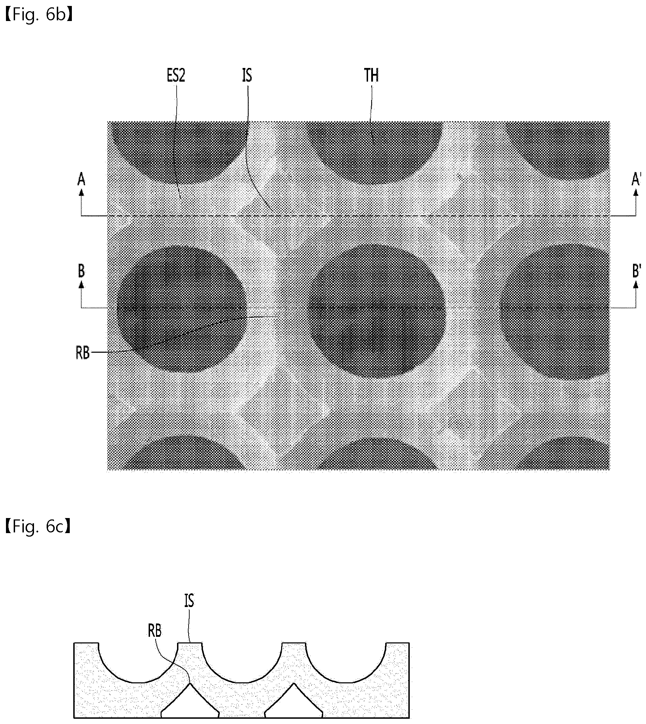

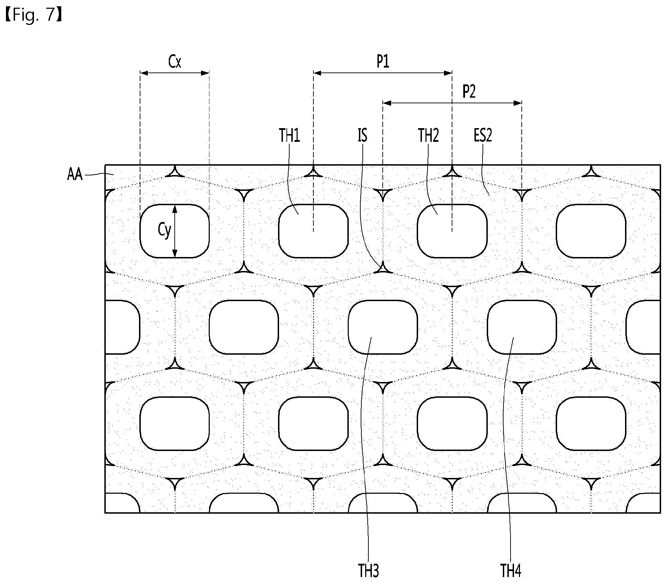

FIGS. 6a, 6b, and 7 are views and photographs showing a plan view of an effective portion of a deposition mask. FIGS. FIGS. 6a, 6b, and 7 are plan views or photographs of an effective portion of any one of the first effective portion AA1, the second effective portion AA2, and the third effective portion AA3. FIGS. 6a, 6b, and 7 are views for describing a shape of through-holes and arrangement between the through-holes, and of course, the deposition mask according to the embodiment is not limited to a number of the through-holes in the drawings.

Referring to FIGS. 6a and 6b, the deposition mask 100 may include a plurality of through-holes. The plurality of through-holes may have a circular shape. Accordingly, a diameter Cx in the horizontal direction and a diameter Cy in the vertical direction of the through-hole may correspond to each other.

Alternatively, referring to FIG. 7, the through-hole may have an elliptical shape. Accordingly, the diameter Cx in the horizontal direction of the through-hole and the diameter Cy in the vertical direction may be different from each other. For example, the diameter Cx in the horizontal direction of the through-hole may be larger than the diameter Cy in the vertical direction. However, the embodiment is not limited thereto, and of course, the through-hole may have a rectangular shape, an octagonal shape, or a rounded octagonal shape. As an example, in the case of measuring a diameter Cx in the horizontal direction and a diameter Cy in the vertical direction of a reference hole which is any one of through-holes, a deviation between the diameters Cx in the horizontal direction and a deviation between the diameters Cy in the vertical direction of each of holes adjacent to the reference hole may be realized as 2% to 10%. That is, when a size deviation between the adjacent holes of one reference hole is realized as 2% to 10%, deposition uniformity may be secured. The size deviation between the reference hole and the adjacent holes may be 4% to 9%. For example, the size deviation between the reference hole and the adjacent holes may be 5% to 7%. For example, the size deviation between the reference hole and the adjacent holes may be 2% to 5%. When the size deviation between the reference hole and the adjacent holes is less than 2%, an occurrence ratio of moire in an OLED panel after deposition may be increased. When the size deviation between the reference hole and the adjacent holes is more than 10%, an occurrence ratio of color unevenness in the OLED panel after deposition may be increased. An average deviation of the diameters of the through-holes may be ± 5 um. For example, the average deviation of the diameters of the through-holes may be ± 3 um. For example, the average deviation of the diameters of the through-holes may be ± 1 um. In the embodiment, deposition efficiency may be improved by realizing the size deviation between the reference hole and the adjacent holes within ± 3 um.

The through-holes may be disposed in a row or may be disposed crossing each other according to a direction. Referring to FIGS. 6a and 6b, the through-holes may be disposed in a row in a vertical axis, and may be disposed in a row in a horizontal axis.

A first through-hole TH1 and a second through-hole TH2 may be disposed in a row in the horizontal axis. In addition, the third through-hole TH1 and the fourth through-hole TH4 may be disposed in a row in the horizontal axis.

The first through-hole TH1 and the third through-hole TH3 may be disposed in a row in the vertical axis. In addition, the second through-holes TH2 and the fourth through-holes TH4 may be disposed in a row in the horizontal axis.

When the through-holes are disposed in a row in the vertical axis and the horizontal axis, an island portion is placed between two through-holes that are adjacent to each other in the diagonal direction, in which both the vertical axis and the horizontal axis intersect. That is, the island portion may be position between two adjacent through-holes that are positioned in the diagonal direction to each other.

An island portion IS may be disposed between the first through-hole TH1 and the fourth through-hole TH4. Further, the island portion IS may be disposed between the second through-hole TH2 and the third through-hole TH3. The Island portion IS may be disposed in an inclination angle direction of about +45 degrees and an inclination angle direction of about -45 degrees with respect to the horizontal axis crossing two adjacent through-holes, respectively. Here, an inclination angle direction of about ± 45 may mean a diagonal direction between the horizontal axis and the vertical axis, and the diagonal inclination angle is measured on the same plane of the horizontal axis and the vertical axis.

Referring to FIG. 7, the through-holes are disposed in a row on any one of the vertical axis or the horizontal axis, and may be disposed to cross each other on one axis.

The first through-hole TH1 and the second through-hole TH2 may be disposed in a row on the horizontal axis. The third through-hole TH1 and the fourth through-hole TH4 may be disposed to cross the first through-hole TH1 and the second through-hole TH2 on the vertical axis, respectively.

When the through-holes are disposed in a row in any one direction of the vertical axis and the horizontal axis, and cross in the other direction, the island portion may be positioned between two adjacent through-holes in the other direction of the vertical axis and the horizontal axis. Alternatively, the island portion may be positioned between three through-holes adjacent to each other. Two through-holes of the three adjacent through-holes are through-holes disposed in a row, and the remaining one through-hole may refer to a through-hole that may be disposed in a region between the two through-holes at an adjacent position in a direction corresponding to the direction of the row. The island portion IS may be disposed between the first through-hole TH1, the second through-hole TH2, and the third through-hole TH3. Alternatively, the island portion IS may be disposed between the second through-hole TH2, the third through-hole TH3, and the fourth through-hole TH4.

The island portion IS of FIGS. 6a, 6b, and 7 may refer to a non-etched surface between the through-holes in the other surface of the deposition mask in which the large surface hole of the effective portion AA is formed. In detail, the island portion IS may be the other surface of the non-etched deposition mask except the second etching surface ES2 and the through-hole TH positioned in the large surface hole in the effective portion AA of the deposition mask. The deposition mask of an embodiment may be for deposition of OLED pixels of high-resolution to ultra-high resolution having a resolution of 500 PPI to 800 PPI or more.

For example, the deposition mask of the embodiment may be for forming a deposition pattern having high-resolution of quad high definition (QHD) having a resolution of 500 PPI or more. For example, the deposition mask of the embodiment may be for deposition of OLED pixels having a pixel number of 2560*1440 or more in the horizontal direction and the vertical direction, and a resolution of 530 PPI or more. According to the deposition mask of the embodiment, a number of pixels per inch may be 530 PPI or more based on a 5.5-inch OLED panel. That is, one effective portion included in the deposition mask of the embodiment may be for forming a pixel number with a resolution of 2560 * 1440 or more.

For example, the deposition mask of the embodiment may be for forming a deposition pattern having ultra-high resolution of ultra-high definition (UHD) having a resolution of 700 PPI or more. For example, the deposition mask of the embodiment may be for forming a deposition pattern having UHD-class resolution for the deposition of OLED pixels having a pixel number of 3840*2160 or more in the horizontal direction and the vertical direction and a resolution of 794 PPI (800 PPI class) or more.

A diameter of one through-hole may be a width between the communication portions CA. In detail, the diameter of the one through-hole may be measured at the point in which an end of the inner side surface in the small surface hole meets an end of the inner side surface in the large surface hole. A measuring direction of the diameter of the through-hole may be any one of a horizontal direction, a vertical direction, and a diagonal direction. The diameter of the through-hole measured in the horizontal direction may be 33 um or less. Alternatively, the diameter of the through-hole measured in the horizontal direction may be 33 um or less. Alternatively, the diameter of the through-hole may be an average value of values measured in the horizontal direction, the vertical direction, and the diagonal direction, respectively.

Accordingly, the deposition mask according to the embodiment may implement a QHD-class resolution.

For example, the diameter of the through-hole in the horizontal direction may be 20 um or less. Accordingly, the deposition mask according to the embodiment may implement a UHD-class resolution.

For example, the diameter of the through-hole may be 15 um to 33 um. For example, the diameter of the through-hole may be 19 um to 33 um. For example, the diameter of the through-hole may be 20 um to 17 um. When the diameter of the through-hole exceeds 33 um, it may be difficult to implement a resolution of 500 PPI or more. On the other hand, when the diameter of the through-hole is less than 15 um, deposition failure may occur.

The diameter of the through-hole may be measured based on a green (G) pattern. This is because since the G pattern among R, G, and B patterns has a low recognition rate through vision, a larger number is required than the R and B patterns, and a pitch between the through-holes may be narrower than the R and B patterns.

The measuring direction of the diameter of the through-hole and the measuring direction of a pitch between two through-holes may be the same. The pitch of the through-holes may be a value of measuring a pitch between two adjacent through-holes in the horizontal direction or the vertical direction.

Referring to FIGS. 6a and 6b, a pitch between two adjacent through-holes among the plurality of through-holes in the horizontal direction may be 48 um or less. For example, the pitch between two adjacent through-holes among the plurality of through-holes in the horizontal direction may be 20 um to 48 um. For example, the pitch between two adjacent through-holes among the plurality of through-holes in the horizontal direction may be 30 um to 35 um.

Here, the pitch may refer to a pitch P1 between a center of a first through-hole TH1 and a center of a second through-hole TH2, which are adjacent in the horizontal direction.

Alternatively, here, the pitch may refer to a pitch P2 between a center of a first island portion and a center of a second island portion, which are adjacent in the horizontal direction. Here, the center of the island portion may be a center at the non-etched other surface between four adjacent through-holes in the horizontal direction and the vertical direction. For example, the center of the island portion, based on the first through-hole TH1 and the second through-hole TH2 which are adjacent in the horizontal direction, may refer to a point at which the horizontal axis and the vertical axis connecting the edges of one island portion IS positioned in a region between the third through-hole TH3 vertically adjacent to the first through-hole TH1 and the fourth through-hole TH4 vertically adjacent to the second through-hole TH2 intersect.

Alternatively, the pitch may refer to a pitch P2 between a center of the first island portion and a center of the second island portion adjacent to the first island portion, among three adjacent through-holes in the horizontal direction.

Referring to FIG. 7, the pitch may refer to a pitch P2 between a center of a first island portion and a center of a second island portion which are adjacent in the horizontal direction. Here, the center of the island portion may be a center at a non-etched other surface between one through-hole and two adjacent through-holes in the vertical direction. Alternatively, here, the center of the island portion may be a center at the non-etched other surface between two through-holes and one through-hole adjacent in the vertical direction. That is, the center of the island portion is a center of the non-etched surface between three adjacent through-holes, and the three adjacent through-holes may refer that a triangular shape may be formed when the centers are connected.

For example, the center of the island portion may be a center at the other surface that is not etched between the third through-holes TH3 at least partially or entirely positioned in regions between the vertical directions of each of a first through-hole TH1 and a second through-hole TH2 adjacent to each other in the horizontal direction, and the first through-hole TH1 and the second through-hole TH2.

In the deposition mask according to the embodiment, the diameter of the through-hole is 33 um or less, and the pitch between the through-holes is 48 um or less, and thus OLED pixels having a resolution of 500 PPI or more may be deposited. That is, QHD-class resolution may be implemented using the deposition mask according to the embodiment.

The diameter of the through-hole and the pitch between the through-holes may be a size for forming a green sub pixel. The deposition mask may be an OLED deposition mask for realizing quad high display pixels.

For example, the deposition mask may be for depositing at least one subpixel among red R, first green G1, blue B, and second green G2. In detail, the deposition mask may be for depositing a red R subpixel. Alternatively, the deposition mask may be for depositing a blue B subpixel. Alternatively, the deposition mask may be for simultaneously forming a first green G1 subpixel and a second green G2 subpixel.

The pixel arrangement of an organic light emitting display device may be disposed in an order of "red R-first green G1-blue B-second green G2". In this case, red R -first green G1 may form one pixel RG, and blue B-second green G2 may form another pixel BG. In the organic light emitting display device having such an arrangement, since a deposition interval of a green light emitting organic material is narrower than that of a red light emitting organic material and a blue light emitting organic material, a form of deposition mask like the present invention may be required.

In the deposition mask according to the embodiment, the diameter of the through-holes is 20 um or less, and the pitch between the through-holes is 32 um or less, and thus OLED pixels having a resolution of 800 PPI class may be deposited. That is, UHD-class resolution may be realized using the deposition mask according to the embodiment.

The diameter of the through-hole and the pitch between the through-holes may be a size for forming a green sub pixel. The deposition mask may be an OLED deposition mask for realizing ultra-high display pixels.

With reference to FIG. 6C, the cross section in the A-A' direction and the cross section in the B-B' direction of FIG. 6A and FIG. 6B, are described, respectively.

FIG. 6C is a view showing each cross section overlapped for describing a height step and a size between the cross section in the A-A' direction and the cross section in the B-B' direction of FIGS. 6A and 6B.

First, the cross section in the A-A' direction of FIGS. 6A and 6B will be described. The A-A direction is a cross section that crosses the center region between a first through-hole TH1 and a third through-hole TH3 adjacent in the vertical direction. That is, the cross section in the A-A' direction may not include through-holes.

An etching surface ES2 in a large surface hole and an island portion IS which is the other surface of a deposition mask not etched between and the etching surface ES2 in the large surface hole may be positioned in the cross section in the A-A direction. Accordingly, the island portion IS may include a surface parallel to one unetched surface of the deposition mask. Alternatively, the island portion IS may include a surface that is the same as or parallel to the other unetched surface of the deposition mask.

Next, the cross section in the B-B' direction of FIG. 6A and FIG. 6B will be described. The B-B' direction is a cross section that crosses the center of each of the first through-hole TH1 and the second through-hole TH2 that are adjacent in the horizontal direction. That is, the cross section in the direction B-B' may include a plurality of through-holes.

One rib may be positioned between the third through-hole TH3 and the fourth through-hole TH4 adjacent in the direction B-B'. Another rib may be positioned between the fourth through-hole TH4 and the fifth through-hole adjacent to the fourth through-hole in the horizontal direction but positioned in a direction opposite to third through-hole TH3. One through-hole may be positioned between the one rib and the other rib. That is, one through-hole may be positioned between two ribs adjacent in the horizontal direction.

In the cross section in the B-B' direction, a rib RB which is a region in which the etching surface ES2 in the large surface hole and the etching surfaces ES2 in the adjacent large surface hole are connected to each other, may be positioned. Here, the rib RB may be a region in which a boundary of two adjacent large surface holes is connected. Since the rib RB is an etching surface, the rib RB may have a smaller thickness than the island portion IS.

For example, the island portion may have a width of 2 um or more. That is, a width in a direction parallel to the other surface of a portion remaining unetched on the other surface may be 2 um or less. When a width of one end and the other end of one island portion is 2 um or more, the total volume of the deposition mask may be increased. The deposition mask having such a structure ensures sufficient rigidity against a tensile force applied to an organic material deposition process or the like, and thus it may be advantageous for maintaining uniformity of the through-hole.

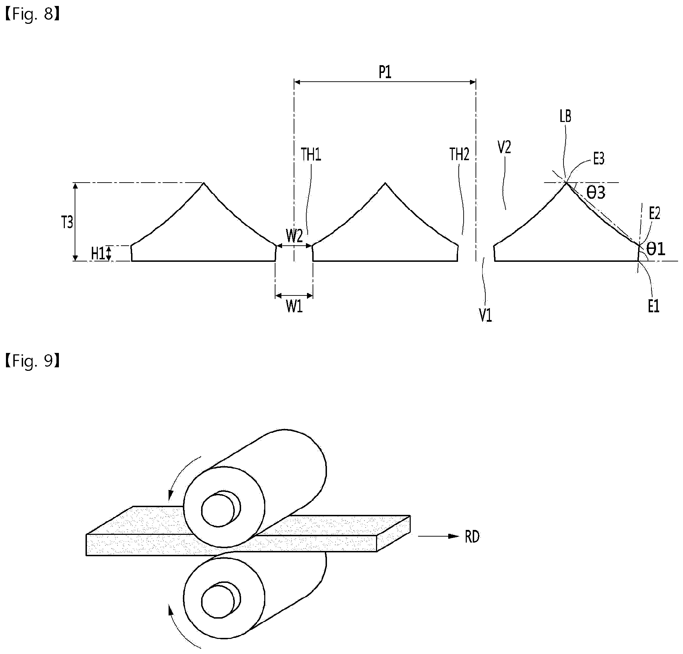

With reference to FIG. 8, the cross section of B-B' of FIG. 6A and FIG. 6B and an enlarged cross section of the through-hole between the rib RB of an effective region according to FIG. 6C and the ribs will be described. In the deposition mask of the embodiment, a thickness of an effective portion AA in which the through-hole is formed by etching may be different from a thickness of an ineffective portion UA that is not etched. In detail, a thickness of the rib RB may be less than the thickness in the ineffective portion UA that is not etched.

In the deposition mask of the embodiment, the thickness of the ineffective portion may be greater than that of the effective portion. For example, in the deposition mask of the embodiment, a maximum thickness of the ineffective portion or a non-deposition region may be 30 um or less. For example, in the deposition mask of the embodiment, the maximum thickness of the ineffective portion or the non-deposition region may be 25 um or less. For example, in the deposition mask of the embodiment, the maximum thickness of the ineffective portion or the non-deposition region may be 15 um to 25 um. When the maximum thickness of the ineffective portion or the non-deposition region of the deposition mask according to the embodiment is greater than 30 um, it may be difficult to form through-holes having a fine size because a thickness of a metal plate material is thick. When the maximum thickness of the ineffective portion or the non-deposition region of the deposition mask according to the embodiment is less than 15 um, it may be difficult to form through-holes having a uniform size because the thickness of the metal plate material is thin.

A maximum thickness T3 measured at the center of the rib RB may be 15 um or less. For example, the maximum thickness T3 measured at the center of the rib RB may be 7 um to 10 um. For example, the maximum thickness T3 measured at the center of the rib RB may be 6 um to 9 um. When the maximum thickness T3 measured at the center of the rib RB is greater than 15 um, it may be difficult to form an OLED deposition pattern having a high-resolution of 500 PPI or more. When the maximum thickness T3 measured at the center of the rib RB is less than 6 um, it may be difficult to form uniformly the deposition pattern.

A height H1 of the small surface hole of the deposition mask may be 0.2 to 0.4 times the maximum thickness T3 measured at the center of the rib RB. For example, the maximum thickness T3 measured at the center of the rib RB may be 7 um to 9 um, and the height H1 between one surface of the deposition mask and the communication portion may be 1.4 um to 3 um. The height H1 of the small surface hole of the deposition mask may be 3.5 um or less. For example, the height of the small surface hole may be 0.1 um to 3.2 um. For example, the height of the small surface hole of the deposition mask may be 0.5 um to 3.5 um. For example, the height of the small surface hole of the deposition mask may be 2 um to 3.2 um. Here, the height may be measured in a thickness measurement direction of the deposition mask, that is, in a depth direction, and may be a height measured from one surface of the deposition mask to the communication portion. In detail, it may be measured in the z-axis direction forming 90 degrees to the horizontal direction (x direction) and the vertical direction (y direction) described above in the plan view of FIG. 4, FIG. 6A, or FIG. 6B.

When the height between one surface of the deposition mask and the communication portion is greater than 3.5 um, deposition failure may occur due to a shadow effect in which a deposition material spreads to a region larger than an area of a through-hole during OLED deposition.

A hole diameter W1 at one surface in which a small surface hole V1 of the deposition mask is formed and a hole diameter W2 at the communication portion which is a boundary between the small surface hole V1 and a large surface hole V2, may be similar to or different from each other. The hole diameter W1 at the one surface on which the small surface hole V1 of the deposition mask is formed may be larger than the hole diameter W2 at the communication portion.

For example, a difference between the hole diameter W1 at one surface of the deposition mask and the hole diameter W2 at the communication portion may be 0.01 um to 1.1 um. For example, the difference between the hole diameter W1 at one surface of the deposition mask and the hole diameter W2 at the communication portion may be 0.03 um to 1.1 um. For example, the difference between the hole diameter W1 at one surface of the deposition mask and the hole diameter W2 at the communication portion may be 0.05 um to 1.1 um.

When the difference between the hole diameter W1 at one surface of the deposition mask and the hole diameter W2 at the communication portion is larger than 1.1 um, deposition failure may occur due to the shadow effect.

An inclination angle of the small surface hole measured on one surface of the deposition mask may be 89 degrees or less. The inclination angle of the small surface hole may refer to that it was measured at the rib RB. An inclination angle connecting one end E1 of the small surface hole and one end E2 of the communication portion between the small surface hole and the large surface hole may be 89 degrees or less with respect to the one surface of the deposition mask. For example, the inclination angle connecting one end E1 of the small surface hole and one end E2 of the communication portion between the small surface hole and the large surface hole may be 75 degrees to 89 degrees with respect to the one surface of the deposition mask. For example, the inclination angle connecting one end E1 of the small surface hole and one end E2 of the communication portion between the small surface hole and the large surface hole may be 78 degrees to 89 degrees with respect to the one surface of the deposition mask. For example, the inclination angle connecting one end E1 of the small surface hole and one end E2 of the communication portion between the small surface hole and the large surface hole may be 85 degrees to 89 degrees with respect to the one surface of the deposition mask.

In other words, the inclination angle may be defined as follows. The inclination angle of the large surface hole may be an inner angle between a virtual first straight line corresponding to the other flat surface of the deposition mask and a virtual second straight line connecting one end of the large surface hole and one end of the communication portion. In addition, the inclination angle of the small surface hole may be an internal angle between a virtual third straight line corresponding to the other flat surface of the deposition mask and a virtual fourth straight line connecting one end of the small surface hole and one end of the communication portion.

Here, the small surface hole V1 may be formed on one surface of the deposition mask, and the large surface hole V2 may be formed on the other surface of the deposition mask. In addition, one surface of the deposition mask serves as a reference for measuring the inclination angle of the small surface hole, and the other surface of the deposition mask serves as a reference for measuring the inclination angle of the large surface hole.

When the inclination angle connecting one end E1 of the small surface hole located on one surface of the deposition mask and one end E2 of the communication portion between the small surface hole and the large surface hole exceeds 89 degrees, the shadow effect may be prevented, but a problem that organic matter remains in the through-hole during deposition may occur. Accordingly, it may be difficult to form a deposition pattern of uniform size.

When the inclination angle connecting one end E1 of the small surface hole located on one surface of the deposition mask and one end E2 of the communication portion between the small surface hole and the large surface hole is less than 70 degrees, deposition failure may occur due to the shadow effect.

An inclination angle of the large surface hole V2 may be 55 degrees or less. The inclination angle of the large surface hole may refer to that it was measured at the rib RB. An inclination angle connecting one end E3 of the large surface hole V2 and one end E2 of the communication portion between the small surface hole and the large surface hole may be 40 to 55 degrees with respect to the other surface opposite to the one surface of the deposition mask. Accordingly, the deposition pattern having a high-resolution of 500 PPI or more may be formed, and simultaneously, the island portion may exist on the other surface of the deposition mask.

The inclination angle connecting one end E3 of the large surface hole V2 and one end E2 of the communication portion between the small surface hole and the large surface hole may be 45 to 55 degrees with respect to the other surface opposite to the one surface of the deposition mask. Accordingly, the deposition pattern having a high-resolution of 800 PPI or more may be formed, and simultaneously, the island portion may exist on the other surface of the deposition mask.

With reference to FIGS. 9 to 13, a step of processing a metal plate for manufacturing a deposition mask according to an embodiment will be described.

With reference to FIG. 9, a rolled metal plate will be described. A metal plate used for manufacturing a deposition mask may be reduced in thickness by passing between a plurality of rolls disposed above and below. For example, the metal plate of the embodiment may be thinner than the metal plate before rolling by cold rolling.

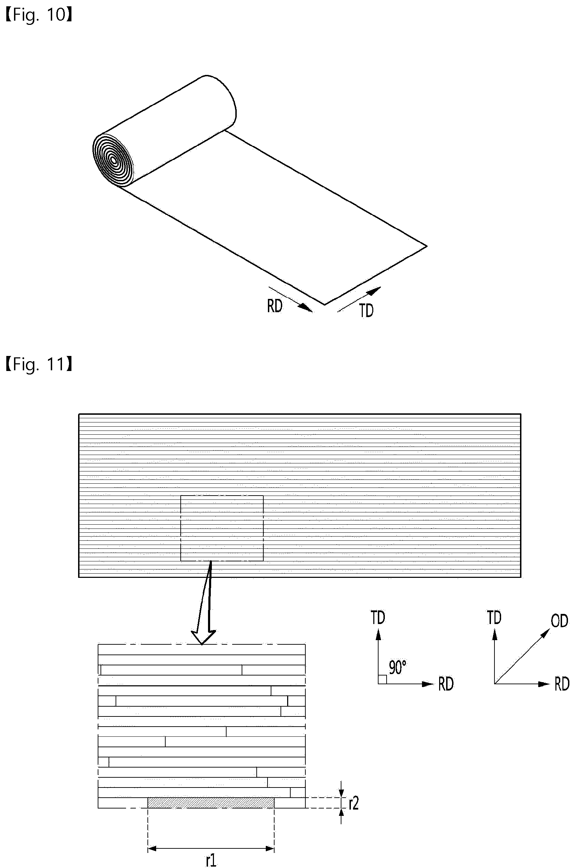

With reference to FIG. 10, cutting of a rolled metal plate will be described. A metal plate used for manufacturing a deposition mask may be rolled for storage convenience. At this time, a direction in which the metal plate is rolled or a rolling direction may be expressed as RD, and a direction perpendicular to the rolling direction (rolled direction) may be expressed as TD. The rolling direction of the metal plate is the same as the longitudinal direction of the metal plate. The rolled metal plate may be cut into a length suitable for manufacturing a deposition mask.

With reference to FIG. 11, a shape of crystal grains on a surface of the rolled metal plate will be described. In the rolled metal plate, crystal grains may be stretched in the rolling direction RD. Accordingly, the metal plate may include a stripe-shaped texture in the rolling direction. In detail, the surface of the rolled metal plate may be formed with stripe-shaped irregularities along the rolling direction. That is, in the rolled metal plate, components of a rolling texture may develop on the surface. Here, the texture may refer to a selective arrangement state of the crystal grains. For example, the surface of a rolled metal plate may include a texture component having a repeating stripe-shape.

Here, a size of the crystal grains may be non-uniform depending on a direction. That is, grain boundaries positioned on the surface of the rolled metal plate may have anisotropy.

For example, a length r1 of the crystal grains in the rolling direction RD may be greater than a length r2 of the crystal grains in the direction TD perpendicular to the rolling direction. For example, the length r1 of the crystal grains in the rolling direction RD: the length r2 of the crystal grains in the transverse direction TD perpendicular to the rolling direction may be 50: 1 to 150: 1. A specific crystal grains size may vary depending on a recrystallization temperature, a thickness of the metal plate, and a rolling process.

When a through-hole is formed in the rolled metal plate, a deviation in the size of crystal grains differs greatly between the rolling direction RD and the transverse direction TD, and thus there is a problem that the diameter of the through-hole may be different depending on a direction. That is, there may be a problem that uniform etching in the rolling direction RD and the transverse direction TD is difficult due to the anisotropy of the crystal grains.

The rolled metal plate may have a value that an average centerline average surface roughness Ra and an average 10-point average surface roughness Rz in the rolling direction RD are smaller than an average centerline average surface roughness Ra and an average 10-point average surface roughness Rz in the transverse direction TD. That is, the surface roughness may be different depending on whether the rolled metal plate is in the rolling direction RD or the transverse direction TD. Here, the average centerline average surface roughness Ra and the average 10-point average surface roughness Rz may be used as a method of measuring the surface roughness. For example, since the cold rolled invar metal plate has a value that an average centerline average surface roughness Ra and an average 10-point average surface roughness Rz in the rolling direction RD are smaller than an average centerline average surface roughness Ra and an average 10-point average surface roughness Rz in the transverse direction TD, adhesion of a photoresist layer may appear differently depending on a direction. Accordingly, when a through-hole is formed by disposing a patterned photoresist layer on the rolled metal plate, it may be difficult to form a through-hole having a uniform hole diameter. In addition, de-filming of the photoresist layer may occur due to a difference in adhesion of the photoresist layer depending on the direction, and thus it may be difficult to manufacture a deposition mask having an island portion having a uniform area.

A shape of crystal grains due to surface treatment of a surface of the rolled metal plate may be changed. The rolled metal plate may be subjected to surface treatment by etching in order to reduce a thickness and reduce the anisotropy of crystal grains.

A surface of the surface-treated metal plate after rolling may include protrusions having various shapes such as a circle, an ellipse, a rectangle, and a random shape. In a plurality of protrusions on the surface of the surface-treated metal plate after the rolling, the length r1 of the crystal grains in the rolling direction RD may be the same as or different from the length r2 of the crystal grains in the transverse direction TD.

In case of forming a through-hole with the surface-treated metal plate after the rolling in the embodiment, since a size of the crystal grains in the rolling direction RD and a size of the crystal grains in the transverse direction TD are similar to each other, a diameter of the through-hole may be formed uniformly regardless of the direction.. That is, in order to solve the etching nonuniformity according to the anisotropy of the crystal grains, in the embodiment, the through-hole is formed by using a metal plate on which the surface is surface-treated, thereby improving uniformity of a shape and a diameter of the through-hole and uniformity of an area of the island portion.

The surface-treated metal plate after the rolling in the embodiment may have a value in a range in which the average centerline average surface roughness Ra in the rolling direction RD and the average centerline average surface roughness Ra in the transverse direction TD correspond to each other.

The surface-treated metal plate after the rolling in the embodiment may have a value in a range in which the average 10-point average surface roughness Rz in the rolling direction RD and the average 10-point average surface roughness Rz in the transverse direction TD correspond to each other. That is, in the rolled metal plate, the range of the surface roughness may be the same or similar regardless of whether it is the rolling direction RD, the transverse direction TD, or the diagonal direction.

For example, although the cold rolled invar metal plate before the surface treatment has a value that the average centerline average surface roughness Ra and the average 10-point average surface roughness Rz in the rolling direction RD are smaller than the average centerline average surface roughness Ra and the average 10-point average surface roughness Rz in the transverse direction TD. the invar metal plate after the surface treatment by etching may have a value of average centerline average surface roughness Ra and average 10-point average surface roughness Rz having a predetermined range regardless of the direction. Therefore, in the metal plate surface-treated after rolling, adhesion of the photoresist layer may be uniform regardless of the direction. Accordingly, when a through-hole is formed by disposing the patterned photoresist layer on the metal plate surface-treated by etching after the rolling, a through-hole having a uniform hole diameter may be formed with high yield. In addition, since the adhesion of the photoresist layer may be uniform regardless of the direction, de-filming of the photoresist layer may be prevented, so that a deposition mask having an island portion of a uniform area may be manufactured. Therefore, the deposition mask manufactured using the metal plate of the embodiment may form a fine and uniform through-hole with high yield.

In the metal plate, the average centerline average surface roughness in the rolling direction RD, the average centerline average surface roughness in the transverse direction TD, and the average centerline average surface roughness in a 45-degree diagonal direction OD between the rolling direction RD and the transverse direction TD to) may be 0.1 um to 0.3 um, respectively.

For example, in the metal plate, the average centerline average surface roughness in the rolling direction RD, the average centerline average surface roughness in the transverse direction TD, and the average centerline average surface roughness in a 45-degree diagonal direction OD between the rolling direction RD and the transverse direction TD to) may be 0.1 um to 0.2 um, respectively.

For example, in the metal plate, the average centerline average surface roughness in the rolling direction RD, the average centerline average surface roughness in the transverse direction TD, and the average centerline average surface roughness in a 45-degree diagonal direction OD between the rolling direction RD and the transverse direction TD may be 0.1 um to 0.15 um, respectively.

In the metal plate, the average 10-point average surface roughness in the rolling direction RD, the average 10-point average surface roughness in the transverse direction TD, and the average 10-point average surface roughness in the 45-degree diagonal direction OD between the rolling direction RD and the transverse direction TD may be 0.5 um to 2.0 um, respectively.

For example, in the metal plate, the average 10-point average surface roughness in the rolling direction RD, the average 10-point average surface roughness in the transverse direction TD, and the average 10-point average surface roughness in the 45-degree diagonal direction OD between the rolling direction RD and the transverse direction TD may be 0.5 um to 1.5 um, respectively.

For example, in the metal plate, the average 10-point average surface roughness in the rolling direction RD, the average 10-point average surface roughness in the transverse direction TD, and the average 10-point average surface roughness in the 45-degree diagonal direction OD between the rolling direction RD and the transverse direction TD may be 0.5 um to 1.0 um, respectively.

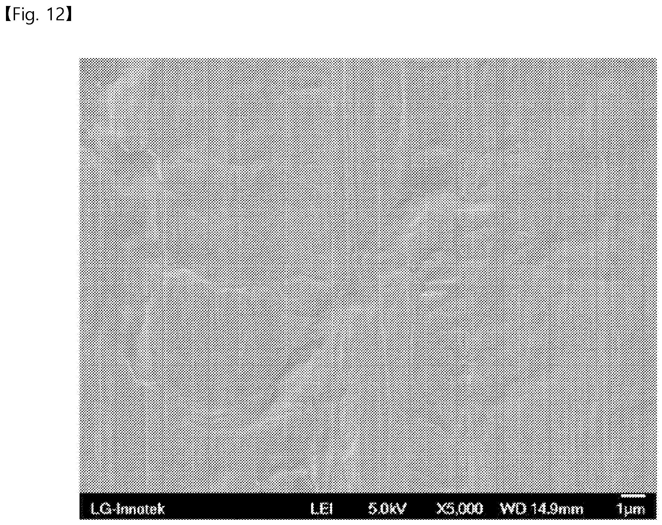

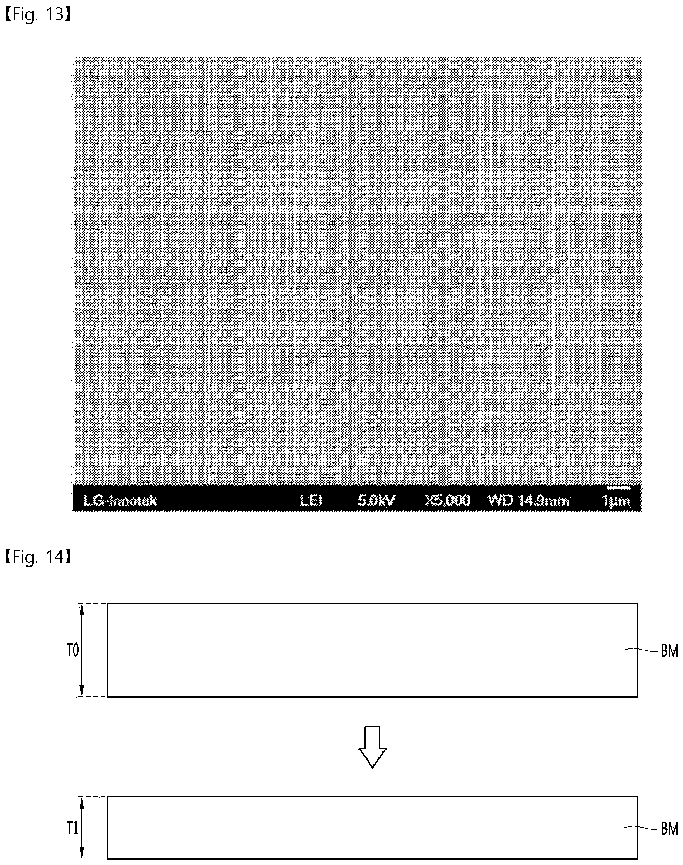

FIGS. 12 and 13 are SEM photographs of a metal plate having a predetermined thickness after rolling and annealing.

FIG. 12 is an SEM photograph of a first test piece of invar that has been rolled and annealed at 5,000 times magnification.

FIG. 13 is an SEM photograph of a second test piece of invar that has been rolled and annealed at 5,000 times magnification.

A surface roughness of the rolled and annealed invar before surface treatment may have the following values. In the first test piece and the second test piece, a centerline average surface roughness (average centerline average surface roughness Ra in the entire area) measured over the entire area having a first horizontal length and a second vertical length may be 0.06 um to 0.1 um. In the first test piece and the second test piece, a10-point average surface roughness (average 10-point average surface roughness Rz in the entire area) measured over the entire area having the first horizontal length and the second vertical length may be 0.8 um to 1.5 um.

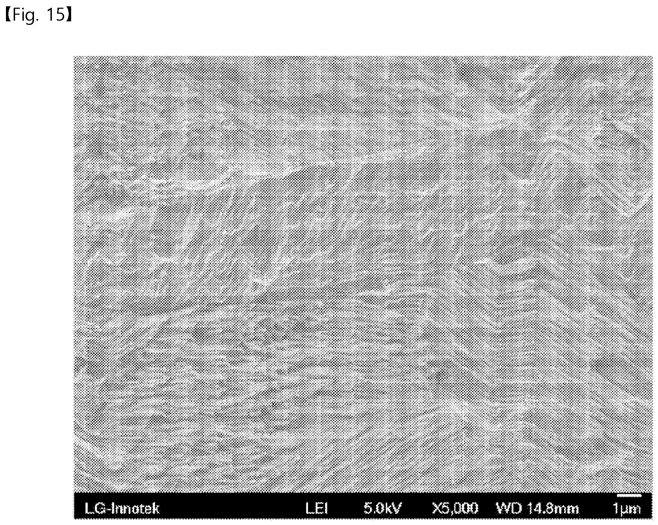

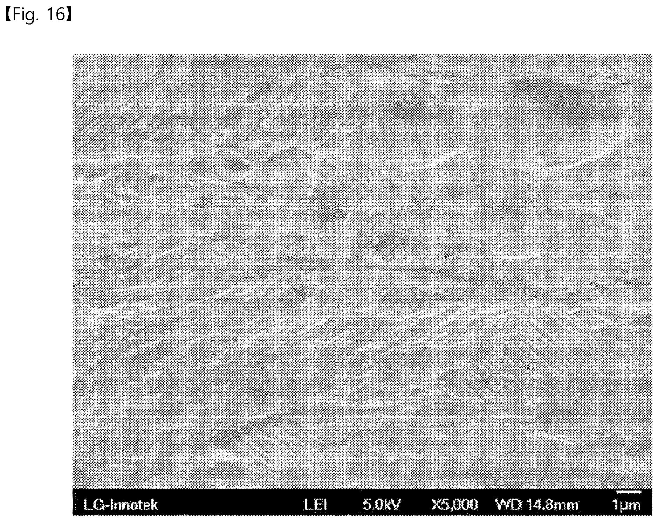

Next, a step of preparing a test piece of a metal plate BM that has been rolled and annealed as shown in FIG. 14 and then etching, and processing it into a test piece as shown in FIGS. 15 and 16 will be described.

A predetermined thickness T0 of the rolled and annealed metal plate BM may be 30 um or more. For example, the predetermined thickness T0 of the rolled and annealed metal plate BM may be 25 um or more.

One side and/or both sides of the metal plate may be etched to produce a metal plate having a thickness T1 thinner than the predetermined thickness T0. After being rolled and annealed, a thickness of the metal plate that has undergone the etching step may be a thickness T1 of 20 um to 30 um. The rolled and annealed metal plate having a predetermined thickness of 30 um or more may have a thickness T1 of 20 um to 30 um through the etching step of a surface of the metal plate.

The rolled and annealed metal plate having a predetermined thickness T0 of 25 um or more may have a thickness T1 of 15 um to 25 um through the etching step. Here, the etching may include an electrical or chemical etching.

The thickness T1 of the metal plate after the etching step may be 60% to 90% of the predetermined thickness T0 of the metal plate. Preferably, the thickness T1 of the metal plate after the etching step may be 70% to 80% of the predetermined thickness T0 of the metal plate.

FIG. 15 and FIG. 16 are SEM photographs of a non-deposition region of a deposition mask according to an embodiment.

FIG. 15 is a SEM photograph of the first test piece of FIG. 11 in which a deviation in surface roughness has been improved after surface treatment by etching of the rolled and annealed invar, which is magnified 5,000 times. FIG. 16 is a SEM photograph of the second test piece of FIG. 12 in which a deviation in surface roughness has been improved after surface treatment by etching of the rolled and annealed invar, which is magnified 5,000 times.

A surface roughness of the etched invar after rolling and annealing may have the following values. In the first test piece, a centerline average surface roughness (average centerline average surface roughness in the entire area) measured over the entire area having a first horizontal length and a second vertical length may be 0.14 um to 0.15 um. In the second test piece, a centerline average surface roughness (average centerline average surface roughness in the entire area) measured over the entire area having the first horizontal length and the second vertical length may be 0.14 um to 0.15 um.

In the first test piece, a10-point average surface roughness (10-point average surface roughness in the entire area) measured over the entire area having a first horizontal length and a second vertical length may be 3.8 um to 4.5 um.

In the second test piece, a10-point average surface roughness (10-point average surface roughness in the entire area) measured over the entire area having the first horizontal length and the second vertical length may be 3.8 um to 4.5 um.

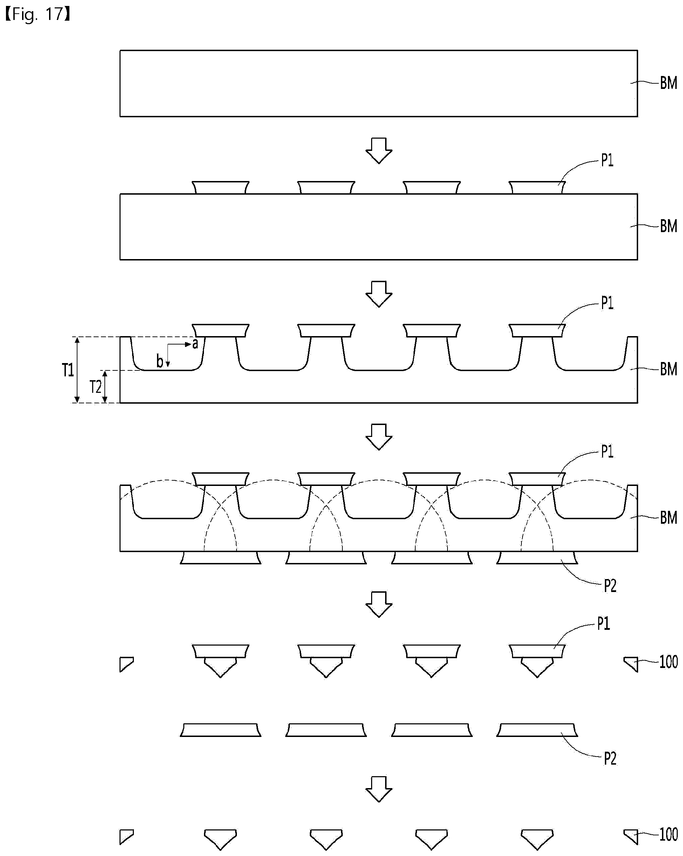

With reference to FIG. 14 and FIG. 17, a manufacturing process of the deposition mask according to an embodiment will be described.

In a method of producing a metallic material deposition mask for OLED pixel deposition, the deposition mask may be manufactured including: a first step of preparing a metal plate on which rolling and annealing are performed and having a predetermined thickness, in which an average centerline average surface roughness and an average 10-point average surface roughness in a rolling direction are smaller than an average centerline average surface roughness and an average 10-point average surface roughness in a transverse direction; a second step of etching a metal plate to be thinner than a predetermined thickness such that an average centerline average surface roughness in a rolling direction and an average centerline average surface roughness in a transverse direction are in a range of 0.1 um to 0.3 um, respectively, and an average 10-point average surface roughness in a rolling direction and an average 10-point average surface roughness in a transverse direction are in a range of 0.5 um to 2.0 um, respectively; and a third step of forming a plurality of large surface holes, a plurality of small surface holes and a plurality of through-holes formed by the large surface hole and small surface hole by applying and developing a patterned photoresist layer on a surface of the metal plate and etching the metal plate.

First, the first step of preparing a metal plate BM on which rolling and annealing are performed, and having a predetermined thickness T0 will be described with reference to FIG. 14.

Here, the rolling may include cold rolling. The annealing may include continuous annealing.

The base metal plate BM may include a metal material. The base metal plate BM may include a nickel alloy. For example, the base metal plate BM may be an alloy of nickel and iron. At this point, the nickel may be about 35 to 37 wt%, and the iron may be about 63 to 65 wt%. For example, the base metal plate BM may include an invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb. Here, the small amount may mean not more than 1w%. Specifically, here, the trace amount may refer to 0.5 wt% or less. However, the base metal plate BM is not limited thereto, and may obviously include various metal materials.

Since the nickel alloy such as invar has a small thermal expansion coefficient, it has advantage that a lifetime of the deposition mask may be increased.

In the metal plate prepared in the first step, an average centerline average surface roughness Ra and an average 10-point average surface roughness Rz in a rolling direction RD are smaller than an average centerline average surface roughness Ra and an average 10-point average surface roughness Rz in a transverse direction TD.

Next, the second step of etching a metal plate to be thinner than the predetermined thickness will be described with reference to FIG. 14.

One side and/or both sides of the metal plate may be etched to produce a metal plate having the thickness T1 thinner than the predetermined thickness T0. That is, the second step may include a step of isotropic etching a surface of the rolled and annealed metal plate.

The metal plate on which the second step has been performed may include a step of etching to be thinner than a predetermined thickness such that the average centerline average surface roughness Ra in the rolling direction RD and the average centerline average surface roughness Ra in the transverse direction TD are in a range of 0.1 um to 0.3 um, respectively, and the average 10-point average surface roughness Rz in the rolling direction RD and the average 10-point average surface roughness Rz in the transverse direction TD are in a range of 0.5 um to 2.0 um, respectively. The rolling direction RD is a longitudinal direction of the deposition mask. The transverse direction TD is a lateral direction perpendicular to the longitudinal direction of the deposition mask.

Optionally, the metal plate BM may include a step of forming an etching control layer.

For example, there is a problem that uniform etching for the nickel alloy such as the invar is difficult. That is, in the nickel alloy such as the invar, the etch rate may be increased in an initial stage of the etching. Accordingly, there is a problem that the etching factor of the small surface hole may be lowered. When the etching factor of the small surface hole is lowered, there may be a problem that a deposition mask may be formed in which deposition failure occurs due to the shadow effect. Alternatively, de-filming of the photoresist layer may occur due to side etching of the large surface hole. In addition, it may be difficult to form a through-hole having a fine size as a size of the through-hole increases. Further, the through-hole is formed non-uniformly, so that a yield of the deposition mask may be lowered.

Therefore, in an embodiment, an etching control layer for surface modification may be disposed on a surface of the base metal plate with different composition, content, crystal structure and corrosion rate. Here, the surface modification may refer to a layer made of various materials disposed on the surface to improve an etching factor.

That is, the etching control layer may be an etching barrier layer having a lower etch rate than that of the metal plate. The etching control layer may have a different crystal plane and crystal structure from those of the metal layer. For example, as the etching control layer includes a different element from that of the metal layer, a crystal plane and a crystal structure may be different from each other.

In the same corrosion environment, the etching control layer may have a different corrosion potential from that of the base metal plate. For example, when the same etchant is applied for the same time at the same temperature, the etching control layer may have different corrosion currents or corrosion potentials from those of the base metal plate.

The metal plate BM may include an etching control layer on one surface and/or both surfaces, the entire surface, and/or an effective region thereof. The etching control layer may include different elements from the metal plate, or may include a metal element having a slow corrosion rate in a larger content than the metal plate.

For example, the etching control layer may include at least one metal of nickel (Ni), chromium (Cr), iron (Fe), titanium (Ti), manganese (Mn), oxygen (O), molybdenum (Mo), silver (Ag), zinc (Zn), nitrogen (N), aluminum (Al) and alloys thereof, and a content of at least one metal of nickel (Ni), chromium (Cr), iron (Fe), titanium (Ti), manganese (Mn), oxygen (O), molybdenum (Mo), silver (Ag), zinc (Zn), nitrogen (N), aluminum (Al) and alloys thereof may be greater than that of the base metal plate. Preferably, the etching control layer may include nickel (Ni). That is, after the second step, the third step may be performed after further performing a step of forming a nickel-deposited layer having a sub-micrometer thickness on the metal plate having a thickness thinner than the predetermined thickness.

In case of further including such a surface treatment step, the etching control layer may be disposed on a surface of the metal plate according to the embodiment. In the surface treatment step, the etching control layer of the element different from the metal plate BM is disposed, so that the corrosion rate on the surface may be slower than that of a raw material of the metal plate BM. Accordingly, the etching factor of the deposition mask according to the embodiment may be increased. In addition, since the deposition mask according to the embodiment may uniformly form a plurality of through-holes, the deposition efficiency of R, G, and B patterns may be improved. Here, including different elements may mean that the metal plate BM and the etching control layer include at least one different element, or even though all the elements are the same, alloys having different contents are included.

Next, a third step of forming a plurality of through-holes will be described with reference to FIG. 17.

A step of disposing a patterned photoresist layer P1 on one surface of the metal plate will be described. The patterned photoresist layer P1 may be applied and developed on one surface of the base metal plate in order to form a small surface hole. An etching barrier layer such as a coating layer or a film layer for preventing etching may be disposed on the other surface opposite to one surface of the base metal plate.

Next, a step of forming a groove on one surface of the metal plate by half-etching an open portion of the photoresist layer P1 will be described.

The open portion of the photoresist layer P1 may be exposed to an etchant or the like, and thus etching may occur in an open portion of one surface of the metal plate on which the photoresist layer P1 is not disposed.

For example, the metal plate having a thickness T1 of 20 um to 30 um may be etched until a groove having a thickness of about 1/2 of the thickness of the metal plate is formed. In detail, the small surface hole may be formed by half-etching. A depth of the groove formed by half-etching may be about 10 um to 15 um.

For example, the metal plate having a thickness T1 of 15 um to 25 um may be etched until a groove having a thickness of about 1/2 of the thickness of the metal plate is formed. In detail, the small surface hole may be formed by half-etching. A depth of the groove formed by half-etching may be about 7.5 um to 12.5 um.

The step of forming the groove on one surface of the metal plate may be an anisotropic etching or semi additive process (SAP). Accordingly, in the groove formed by half-etching, an etch rate (b direction) in a depth direction may be faster than that of the side etching (a direction) than an isotropic etching.

An etching factor of the small surface hole may be 2.0 to 3.0. For example, the etching factor of the small surface hole may be 2.1 to 3.0. For example, the etching factor of the small surface hole may be 2.2 to 3.0.

Here, the etching factor may mean that a depth B of an etched small surface hole divided by a width A of the photoresist layer extending from the island portion on the small surface hole and protruding toward the center of the through-hole (Etching Factor = B/A). The A may mean an average value of a width of one side of the photoresist layer protruding on the one surface hole and a width of the other side opposite to the one side.

Next, a step of disposing a patterned photoresist layer P2 on the other surface opposite to the one surface of the metal plate will be described. The patterned photoresist layer P2 having an open portion may be disposed on the other surface opposite to the one surface of the base metal plate in order to form a large surface hole. An etching barrier layer such as a coating layer or a film layer for preventing etching may be disposed on one surface of the base metal plate.

The open portion of the photoresist layer P2 may be exposed to an etchant, and thus etching may occur in an open portion of the other surface of the metal plate on which the photoresist layer P1 is not disposed. The other surface of the metal plate may be etched by anisotropic etching or isotropic etching.

The open portion of the photoresist layer is etched, and thus the groove on one surface of the metal plate may be connected to the large surface hole to form a through-hole.

In the third step, 1) the patterned photoresist layer P1 is disposed on one surface of the metal plate and the patterned photoresist layer P2 is disposed on the other surface of the metal plate. And then, 2) the through-hole may be formed by etching one surface and the other surface of the metal plate at the same.

Alternatively, in the third step, 1) the patterned photoresist layer P1 may be disposed on one surface of the metal plate, and 2) the grove may be formed on only one surface of the metal plate by half-etching the open portion of the photoresist layer P1. Then, 3) the patterned photoresist layer P2 may be disposed on the other surface of the metal plate. And then 4) the through-hole may be formed on the other surface of the metal plate by etching the open portion of the photoresist layer P2.

Alternatively, in the second step, 1) the patterned photoresist layer P2 may be disposed on the other surface of the metal plate, and 2) the large surface hole may be formed on only the other surface of the metal plate by etching the open portion of the photoresist layer P2. Then, 3) the patterned photoresist layer P1 may be disposed on the one surface of the metal plate. And then 4) the through-hole connected to the large surface hole may be formed on the one surface of the metal plate by half-etching the open portion of the photoresist layer P1.

Next, the photoresist layer is removed, and the deposition mask may be formed through the third step of forming a plurality of large surface holes, a plurality of small surface holes, and a plurality of through-holes formed by the large surface hole and the small surface hole. For example, the through-holes may be formed by anisotropic etching.

The plurality of large surface holes are simultaneously formed on the one surface, the plurality of small surface holes are simultaneously formed on the other surface opposite to the one surface, and the plurality of through-holes are simultaneously formed by the communication portion to which the boundary between the large surface hole and the small surface hole is connected, and accordingly. the deposition mask may be manufactured.

The deposition mask may include the same material as the metal plate. For example, the deposition mask may include a material having the same composition as the metal plate. For example, the island portion of the deposition mask may include the etching control layer described above. In detail, the island portion of the deposition mask or the surface of the non-deposition region may include a nickel-deposited layer. That is, nickel may remain on the surface of the non-deposition region or the island portion of the metal plate that has not been etched.

In the deposition mask, a maximum thickness at the center of the island portion may be smaller than a maximum thickness T1 at the non-deposition region without undergoing etching to form a half etching portion. For example, the maximum thickness at the center of the island portion may be less than 15 um. For example, the maximum thickness at the center of the island portion may be less than 10 um. However, the maximum thickness T1 in the non-deposition region of the deposition mask may be 20 um to 30 um or 15 um to 25 um. The maximum thickness in the non-deposition region of the deposition mask may be equal to the thickness of the metal plate prepared in the second step. Since the surfaces of the non-effective portion and the effective portion are entirely etched in the second step, the thickness of the non-effective portion may be smaller than the predetermined thickness measured in the first step of the metal plate.

In order to manufacture a deposition mask having a high-resolution of the UHD and QHD classes, it is required to use a thin metal plate. Therefore, the deposition mask may be manufactured using a metal plate rolled with a thin thickness. However, it was confirmed that the uniformity of the through-holes was lowered in the deposition mask manufactured by such a method. That is, the density of the through-holes becomes higher as the high-resolution is required, and thus it is required to form a through-hole having a fine and uniform size.

The present inventor has confirmed surface characteristics in order to confirm a problem that the uniformity of the through-holes of the rolled metal plate has decreased, and as a result, it was confirmed that the rolled metal plate had different surface roughness values in the rolling direction and the transverse direction. Since the surface roughness of the rolled metal plate is a factor that determines the adhesion to the photoresist layer, it was confirmed that the uniformity was lowered when the through-hole was manufactured using the rolled metal plate as it was. That is, when manufacturing the deposition mask using the rolled metal plate, it was confirmed that a uniform through-hole was not formed because an etching rate in a specific direction was high.

Accordingly, the present inventor has derived a deposition mask including a through-hole having a uniform size and a method of manufacturing the same, after performing a processing step of controlling the surface roughness of the rolled metal plate to a predetermined range.

When the roughness is reduced to a predetermined range or less by etching as surface treatment, a problem that adhesion to the photoresist layer is lowered may occur. In addition, when the metal plate is etched to a thickness of 10 um to 12 um, a problem is expected that structural deformation occurs due to low rigidity when the deposition mask is pulled.

Therefore, the deposition mask according to the embodiment has a thickness of 20 um to 30 um, or 15 um to 25 um in a portion in which the half etching portion is not formed in the non-deposition region, an average centerline average surface roughness in the longitudinal direction and an average centerline average surface roughness in the lateral direction of the non-deposition region are 0.1 um to 0.3 um, an average 10-point average surface roughness in the longitudinal direction and an average 10-point average surface roughness in the lateral direction are 0.5 um to 2.0 um, a deviation of a value of an average centerline average surface roughness Ra (RD) in the longitudinal direction with respect to an average centerline average surface roughness Ra (TD) in the lateral direction is less than 50%, and a deviation of a value of an average 10-point average surface roughness Rz (RD) in the longitudinal direction with respect to an average 10-point average surface roughness Rz (TD) in the lateral direction may be less than 50%.

Through this, it is possible to manufacture a deposition mask including a fine through-hole having a uniform size.

OLED pixels having a high-resolution of 500 PPI or more and 800 PPI or more may be deposited in high yield using the deposition mask according to the embodiment. In addition, it is possible to improve consistency and accuracy of a position between a through-hole and an OLED pattern.

Hereinafter, the present invention will be described in more detail with reference to Examples and Comparative Examples. Such Examples are merely illustrative in order to describe the present invention in more detail. Therefore, the present invention is not limited to such Examples.

In Comparative Example, a metal plate is rolled and annealed. In Example, a surface of the rolled and annealed metal plate is treated with an iron chloride-based acidic etchant.

### <Experimental Example 1: SEM measurement result>

FIGS. 15 and 16 show SEM photographs of a surface of an acid-treated metal plate after rolling and annealing according to Example.

Referring to FIGS. 15 and 16, it can be seen that a stripe shape in a rolling direction is disappeared or reduced on the surface of the metal plate of Example. It can be seen that crystal grains on the surface of the metal plate are arranged in the same or different directions. That is, it can be seen that the crystal grains on the surface of the metal plate are arranged in a random direction.

FIGS. 12 and 13 show SEM photographs of a surface of an invar metal plate after rolling and annealing according to Comparative Example.

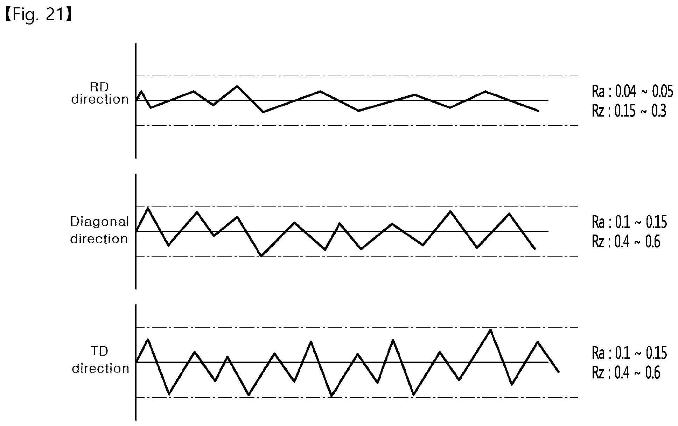

Referring to FIG. 21, it may be confirmed that the surface of the metal plate of Comparative Example has stripe-shaped crystal grains in the rolling direction.

In the embodiment, the surface of the metal plate may be processed so as to have crystal grains irrespective of direction through surface treatment. In the Experimental Example, only an acidic etchant is described, but it is needless to say that an alkaline etchant may be used.

### <Experimental Example 2: Measurement results of Ra and Rz in RD direction, TD direction, and diagonal direction>

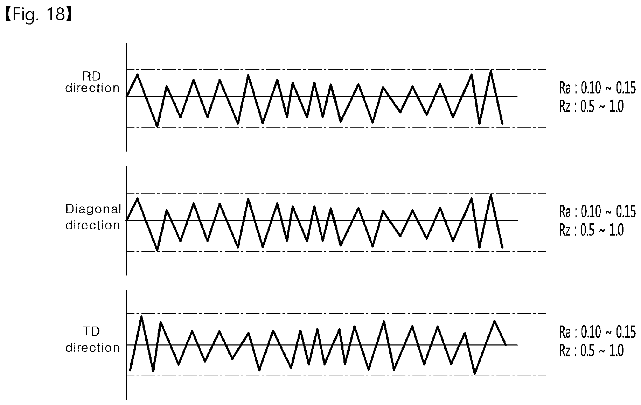

Roughness measurement results of Example, which were measured using a roughness measuring device (Nano View, manufacturer: Nanosystem, Product name: NV-E1000), are shown in FIG. 18 and Tables 1 and 2, and roughness measurement results of Comparative Example are shown in FIG. 21 and Tables 3 and 4.

An average centerline average surface roughness Ra and an average 10-point average surface roughness Rz in Example were measured in an area having a first horizontal length and a second vertical length of a test piece, and an average value measured by a plurality of lines (Line 1 to Line 40) in a lateral direction, a longitudinal direction, a first diagonal direction, and a second diagonal direction, respectively is shown.

Table 1 shows individual values and an average value of an average centerline average surface roughness Ra and an average 10-point average surface roughness Rz measured by ten lines of Example in the lateral direction and the longitudinal direction, respectively.

Table 2 shows individual values and an average values of an average centerline average surface roughness Ra and an average 10-point average surface roughness Rz measured by ten lines of the embodiment in the first diagonal direction, and the second diagonal direction, respectively.

It is a calculated value of a deviation ratio (%) of RD to TD |RD-TD|TD*100 (%).

**[Table 1]**

| Surface roughness by Line | Surface roughness in lateral direction (TD) | | Surface roughness by Line | Surface roughness in longitudinal direction (RD) | |
|---|---|---|---|---|---|
| | Centerline average roughness (Ra) | 10-point average roughness (Rz) | | Centerline average roughness (Ra) | 10-point average roughness (Rz) |
| Line1 | 0.0964 | 0.513 | Line 11 | 0.1719 | 0.8389 |
| Line2 | 0.1063 | 0.5422 | Line 12 | 0.1785 | 0.7686 |
| Line3 | 0.1154 | 0.6745 | Line 13 | 0.1375 | 0.7883 |
| Line4 | 0.1204 | 0.6445 | Line 14 | 0.1463 | 0.8234 |
| Line5 | 0.1386 | 1.0232 | Line 15 | 0.1314 | 0.8487 |
| Line6 | 0.0959 | 0.5346 | Line 16 | 0.1342 | 0.7342 |
| Line7 | 0.1202 | 0.8154 | Line 17 | 0.1484 | 0.7853 |
| Line8 | 0.1483 | 0.7735 | Line 18 | 0.1539 | 0.6725 |
| Line9 | 0.118 | 0.5986 | Line 19 | 0.1108 | 0.4636 |
| Line10 | 0.2311 | 0.974 | Line 20 | 0.1337 | 0.9421 |
| Average in lateral direction (Line 1~Line 10) | 0.12906 | 0.70935 | Average in longitudinal direction (Line 11~Line 20) | 0.14466 | 0.76656 |
| Deviation ratio (%) of average in lateral direction to average in longitudinal direction | 12.0874 | 8.06513 | | | |

**[Table 2]**

| Surface roughness value by Line | Surface roughness in first diagonal direction (+45 degrees) | | Surface roughness value by Line | Surface roughness in second diagonal direction (-45 degrees) | |
|---|---|---|---|---|---|
| | Centerline average roughness (Ra) | 10-point average roughness (Rz) | | Centerline average roughness (Ra) | 10-point average roughness (Rz) |
| Line 21 | 0.1022 | 0.686 | Line 31 | 0.1716 | 0.687 |
| Line 22 | 0.2117 | 0.998 | Line 32 | 0.1242 | 0.5658 |
| Line 23 | 0.15 | 0.7721 | Line 33 | 0.1546 | 0.8139 |
| Line 24 | 0.1388 | 0.7224 | Line 34 | 0.1197 | 0.7589 |
| Line 25 | 0.1508 | 0.8543 | Line 35 | 0.13 | 0.6917 |
| Line 26 | 0.1955 | 1.0736 | Line 36 | 0.1403 | 0.7398 |
| Line 27 | 0.1507 | 0.7115 | Line 37 | 0.1623 | 0.8039 |
| Line 28 | 0.1251 | 0.8489 | Line 38 | 0.1993 | 0.8599 |
| Line 29 | 0.1216 | 0.6597 | Line 39 | 0.1442 | 0.6631 |
| Line 30 | 0.1302 | 0.7813 | Line 40 | 0.13 | 0.7427 |
| Average in +45 degree direction (Line 21~Line 30) | **0.14766** | **0.81078** | Average in - 45 degree direction (Line 31~Line 40) | **0.14762** | **0.73267** |
| Deviation ratio (%) of average in +45 degree direction to average in - 45 degree direction | 0.027089 | 9.633933 | | | |

An average centerline average surface roughness Ra and an average 10-point average surface roughness Rz in Comparative Example were measured in an area having a first horizontal length and a second vertical length of a test piece, and an average value measured by a plurality of lines (Line 1 to Line 40) in a lateral direction, a longitudinal direction, a first diagonal direction, and a second diagonal direction, respectively is shown.

Table 3 shows individual values and an average values of an average centerline average surface roughness Ra and an average 10-point average surface roughness Rz measured by ten lines of Comparative Example in the lateral direction and the longitudinal direction, respectively.

Table 4 shows individual values and an average values of an average centerline average surface roughness Ra and an average 10-point average surface roughness Rz measured by ten lines of Comparative Example in the first diagonal direction, and the second diagonal direction, respectively.

It is a calculated value of a deviation ratio (%) of RD to TD |RD-TDI/TD*100 (%).

**[Table 3]**

| Surface roughness | Surface roughness in lateral direction (TD) | Surface roughness | Surface roughness in longitudinal direction (RD) | | |
|---|---|---|---|---|---|
| by Line | Centerline average roughness (Ra) | 10-point average roughness (Rz) | by Line | Centerline average roughness (Ra) | 10-point average roughness (Rz) |
| Line1 | 0.091 | 0.346 | Line 11 | 0.07 | 0.293 |
| Line2 | 0.084 | 0.357 | Line 12 | 0.063 | 0.228 |
| Line3 | 0.093 | 0.354 | Line 13 | 0.046 | 0.237 |
| Line4 | 0.098 | 0.382 | Line 14 | 0.054 | 0.182 |
| Line5 | 0.117 | 0.42 | Line 15 | 0.041 | 0.198 |
| Line6 | 0.096 | 0.446 | Line 16 | 0.029 | 0.116 |
| Line7 | 0.114 | 0.483 | Line 17 | 0.04 | 0.203 |
| Line8 | 0.108 | 0.418 | Line 18 | 0.036 | 0.168 |
| Line9 | 0.123 | 0.54 | Line 19 | 0.029 | 0.137 |
| Line10 | 0.106 | 0.476 | Line 20 | 0.023 | 0.1 |
| Average (TD) in lateral direction (Line 1~Line 10) | 0.103 | 0.4222 | Average (RD) in longitudinal direction (Line 11~Line 20) | 0.0431 | 0.1862 |
| Deviation ratio (%) of average in lateral direction to average in longitudinal direction | 58.15534 | 55.89768 | | | |

**[Table 4]**

| Surface roughness value by | Surface roughness in first diagonal direction (+45 degrees) | Surface roughness value by | Surface roughness in second diagonal direction (-45 degrees) | | |
|---|---|---|---|---|---|
| Line | Centerline average roughness (Ra) | 10-point average roughness (Rz) | Line | Centerline average roughness (Ra) | 10-point average roughness (Rz) |
| Line 21 | 0.128 | 0.414 | Line 31 | 0.121 | 0.421 |
| Line 22 | 0.101 | 0.394 | Line 32 | 0.108 | 0.492 |
| Line 23 | 0.109 | 0.381 | Line 33 | 0.114 | 0.53 |
| Line 24 | 0.111 | 0.419 | Line 34 | 0.08 | 0.252 |
| Line 25 | 0.123 | 0.461 | Line 35 | 0.079 | 0.353 |
| Line 26 | 0.131 | 0.58 | Line 36 | 0.082 | 0.269 |
| Line 27 | 0.111 | 0.61 | Line 37 | 0.11 | 0.445 |
| Line 28 | 0.092 | 0.457 | Line 38 | 0.116 | 0.407 |
| Line 29 | 0.091 | 0.488 | Line 39 | 0.127 | 0.41 |
| Line 30 | 0.093 | 0.453 | Line 40 | 0.106 | 0.272 |
| Average in +45 degree direction (Line 21~Line 30) | **0.109** | **0.4657** | Average in - 45 degree direction (Line 31~Line 40) | **0.1043** | **0.3851** |
| Deviation ratio (%) of average in +45 degree direction to average in - 45 degree direction | 4.311927 | 17.30728 | | | |

In the metal plate according to Example, it was confirmed that the average centerline average surface roughness Ra in a rolling direction RD and a transverse direction TD was 0.1 um to 0.3 um.

In the metal plate according to Example, it was confirmed that the average 10-point average surface roughness Rz in the rolling direction RD and the transverse direction TD was 0.5 um to 2.0 um. That is, in Example, it was confirmed that the metal plate has the same or similar range of roughness values for the same roughness evaluation item regardless of the direction.

In this case, a length in the first horizontal direction and a length in the second vertical direction may correspond to each other or may be different from each other.

Specifically, after setting the roughness measuring device at 20 times magnifications, an arbitrary point on the metal plate is selected, and the surface roughness may be measured in an area of 232 um *309 um.

A specific method of measuring the surface roughness of Example is to measure the surface roughness on an arbitrary straight line in the TD and RD directions within an area of the length in the first horizontal direction and the length in the second vertical direction, and a length of the straight line may be the same as the length in the first horizontal direction or the length in the second vertical direction. Example shows values of Ra and Rz measured based on an arbitrary straight line in a longitudinal direction, a diagonal direction, and a lateral direction at an arbitrary point of a metal test piece after surface treatment, and shows average derived values obtained by measuring the Ra and Rz on 10 straight lines in the TD direction, 10 straight lines in the RD direction, 10 straight lines in the 45-degree direction, and 10 straight lines in the -45-degree direction, respectively, by changing the position.

Comparative Example shows values of Ra and Rz measured based on an arbitrary straight line in a longitudinal direction, a diagonal direction, and a lateral direction at an arbitrary point of a metal test piece before surface treatment, and shows average derived values obtained by measuring the Ra and Rz on 10 straight lines in the TD direction, 10 straight lines in the RD direction, 10 straight lines in the 45-degree direction, and 10 straight lines in the -45-degree direction, respectively, by changing the position.

In the metal plate according to Comparative Example, it was confirmed that the average centerline average surface roughness Ra in the rolling direction RD was 0.0431 um, and the average centerline average surface roughness Ra in the transverse direction TD was 0.103 um. In the metal plate according to Comparative Example, it was confirmed that the average 10-point average surface roughness Rz in the rolling direction RD was 0.1862 um and the average 10-point average surface roughness Rz in the transverse direction TD was 0.4222 um. That is, in Comparative Example, it was confirmed that the average centerline average surface roughness was different depending on the direction. In addition, in Comparative Example, it was confirmed that the average 10-point average surface roughness was different depending on the direction.

In case of Example, the total average centerline average surface roughness measured in an area of 232 um*309 um was 0.14 um to 0.15 um, and the total average 10-point average surface roughness measured in the area of 232 um*309 um was 3.8 um to 4.5 um. On the other hand, in Comparative Example, the total average centerline average surface roughness measured in the area of 232 um*309 um was 0.06 um to 0.1 um, and the total average 10-point average surface roughness measured in the area of 232 um*309 um was 0.8 um to 1.5 um.

As a result, when the surface roughness is increased, it is considered that the adhesion is improved, but before deriving Example, an etching shape was evaluated with a test piece having a total average centerline average surface roughness of 0.05 um to 0.5 um measured in the area of 232 um*309 um and a total average 10-point average surface roughness of 1.0 um to 3.0 um measured in the area of 232 um*309 um, but a desired shape was not appeared.

As a result of examining the reason, the average surface roughness in the entire area of 232 um *309 um was increased, but an undesired etching shape was appeared due to the deviation of the surface roughness in the longitudinal direction (rolling direction) and the lateral direction (transverse direction) of the metal plate. Based on this, it was possible to derive Example of the present invention.

In addition, it can be seen that a deviation of a value of an average centerline average surface roughness Ra(RD) in the longitudinal direction with respect to an average centerline average surface roughness Ra(TD) in the lateral direction of the non-deposition region or the island portion of the deposition mask according to the embodiment is less than 50%, and a deviation of a value of an average 10-point average surface roughness Rz(RD) in the longitudinal direction with respect to an average 10-point average surface roughness Rz(TD) in the lateral direction is less than 50%. In detail, it can be seen that the deviation of the value of the average centerline average surface roughness Ra(RD) in the longitudinal direction with respect to the average centerline average surface roughness Ra(TD) in the lateral direction of the non-deposition region or the island portion of the deposition mask according to the embodiment is 30% or less, and the deviation of the value of the average 10-point average surface roughness Rz(RD) in the longitudinal direction with respect to the average 10-point average surface roughness Rz(TD) in the lateral direction is 30% or less. In more detail, it can be seen that the deviation of the value of the average centerline average surface roughness Ra(RD) in the longitudinal direction with respect to the average centerline average surface roughness Ra(TD) in the lateral direction of the non-deposition region or the island portion of the deposition mask according to the embodiment is 15% or less, and the deviation of the value of the average 10-point average surface roughness Rz(RD) in the longitudinal direction with respect to the average 10-point average surface roughness Rz(TD) in the lateral direction is 15% or less.

On the other hand, in a test piece of the metal plate according to Comparative Example, it can be seen that a deviation of a value of an average centerline average surface roughness Ra(RD) in the longitudinal direction with respect to an average centerline average surface roughness Ra(TD) in the lateral direction exceeds 50%, and a deviation of a value of an average 10-point average surface roughness Rz(RD) in the longitudinal direction with respect to an average 10-point average surface roughness Rz(TD) in the lateral direction exceeds 50%.

### <Experimental Example 3: Measurement of adhesion of photoresist layer in RD direction and TD direction>

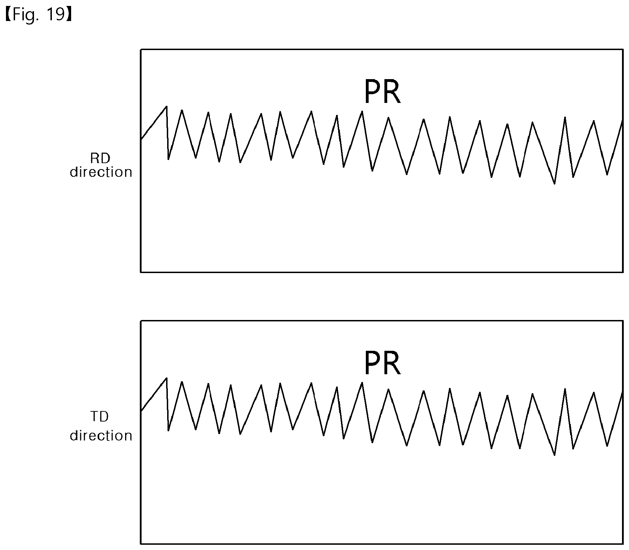

FIG. 19 is a view showing a correlation between a surface roughness according to a direction of a metal plate and adhesion of a photoresist layer according to an Example. In Example, since a range of the roughness at a surface of the metal plate has a constant value regardless of the direction, the adhesion of the photoresist layer may be constant.

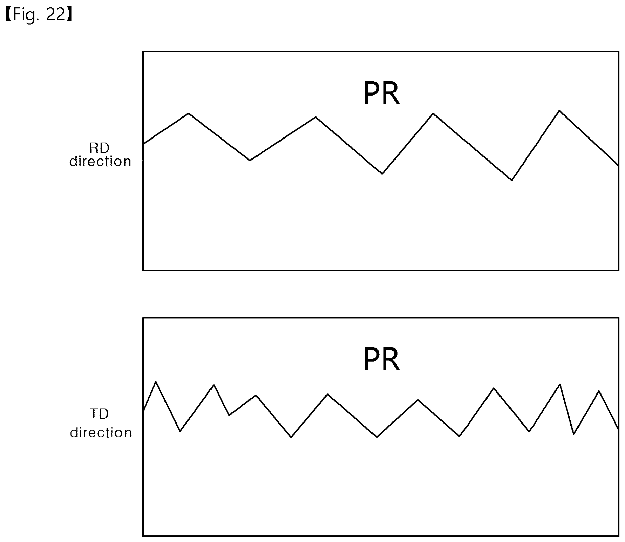

FIG. 22 is a view showing a correlation between a surface roughness according to a direction of a metal plate and adhesion of a photoresist layer according to Comparative Example. In Comparative Example, since the roughness differs from the surface of the metal plate depending on the direction, the adhesion of the photoresist layer is not uniform. Therefore, the photoresist layer may be lifted or de-filmed.

An etched surface was formed to evaluate etching characteristics of the metal plates of Example and Comparative Example described above.

### <Experimental Example 4: Shape of etched surface according to Example and Comparative Example>

It is a photograph showing a shape of an etched surface after preparing a metal plate according to Example and Comparative Example, and etching for forming a large surface hole, respectively. At this time, the large surface hole may have been formed by half-etching.

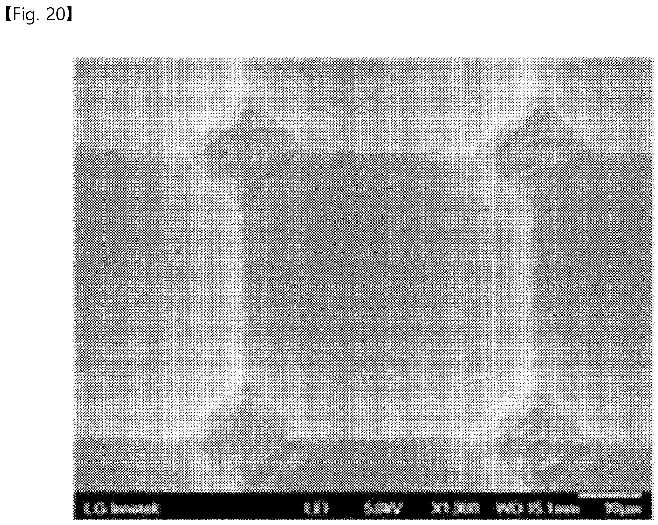

FIG. 20 is a photograph showing a half-etched shape of one surface of a metal plate in order to evaluate a shape of an island portion IS of a deposition mask manufactured by a method according to Example. In the deposition mask formed based on the manufacturing method of Example, a shape of a through-hole and an island portion may be uniform.

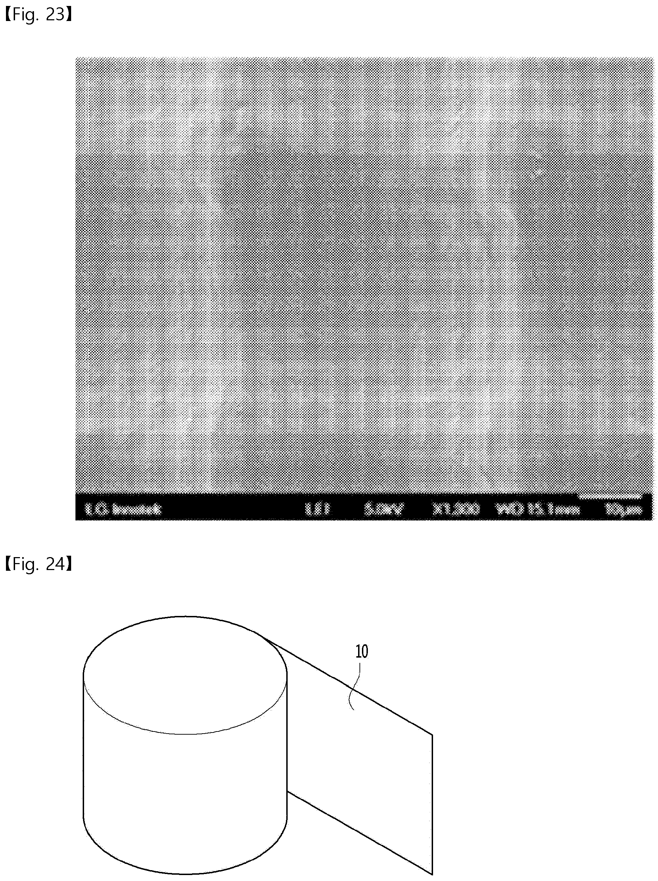

FIG. 23 is a photograph showing a half-etched shape of one surface of a metal plate in order to evaluate a shape of an island portion IS of a deposition mask manufactured using a metal plate of Comparative Example. In the deposition mask formed based on the manufacturing method of Comparative Example, a boundary between an island portion and a through-hole may not be clear. Accordingly, it may be difficult to manufacture a deposition mask having a through-hole with a uniform size.

Meanwhile, the deposition mask used to realize a high-resolution pattern as described above requires a metal plate of 30 um or less, and as a PPI value to be realized increases, a thinner metal plate and a precise through-hole are required.

In general, the metal plate is manufactured through a rolling process, and may have a rectangular shape including a major axis and a minor axis. The metal plate may include a residual stress due to the rolling process, and as a force applied during the rolling process increases, the residual stress included in the metal plate may increase.

A warp phenomenon (wave deformation) may occur in the metal plate due to the residual stress, and as a thickness of the metal plate becomes thinner for realizing a high-resolution, the residual stress of the metal plate may increase.

A size and a position of the through-hole formed on the metal plate may not be uniform due to the residual stress. Accordingly, when a deposition mask is manufactured using the metal plate, deposition failure may occur.

In addition, when a deposition mask is manufactured using the metal plate, an alignment failure may occur due to a warp phenomenon of the deposition mask. Specifically, at the time of organic substance deposition, the deposition mask may be set in a deposition apparatus. At this time, adhesion to a substrate may be reduced due to the warp phenomenon of the deposition mask. Accordingly, organic substances may not be uniformly deposited on the substrate, and adjacent organic substances may be mixed with each other to cause deposition failure.

In order to prevent this, a residual stress of a base metal plate which is a base material of the metal plate may be measured in advance. In detail, a sample metal plate may be manufactured using the base metal plate to measure the residual stress, and residual stress characteristics of the base metal plate may be grasped.

Hereinafter, a metal plate according to an embodiment and a method of measuring a residual stress of the metal plate will be described.

FIG. 24 is a view illustrating that a metal plate as a raw material of a deposition mask has been wound.

Referring to FIG. 24, a metal plate 10 according to an embodiment may include a metal material. For example, the metal plate 10 may include nickel (Ni). In detail, the metal plate 10 may include iron (Fe) and nickel (Ni). In more detail, the metal plate 10 may include iron (Fe), nickel (Ni), oxygen (O), and chromium (Cr). In addition, the metal plate 10 may further include at least one element of a small amount of carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb). The invar is an alloy containing iron and nickel and is a low thermal expansion alloy having a thermal expansion coefficient close to zero. That is, since the invar has a very small thermal expansion coefficient, it is used for precision parts such as masks and precision equipment. Therefore, a deposition mask manufactured using the metal plate 10 may have improved reliability, thereby preventing deformation and increasing lifetime.

The metal plate 10 may include about 60 wt% to about 65 wt% of the iron, and may include about 35 wt% to about 40 wt% of the nickel. In detail, the metal plate 10 may include about 63.5 wt% to about 64.5 wt% of the iron, and may include about 35.5 wt% to about 36.5 wt% of the nickel. In addition, the metal plate 10 may further include at least one element of carbon (C), silicon (Si), sulfur (S), phosphorus (P), manganese (Mn), titanium (Ti), cobalt (Co), copper (Cu), silver (Ag), vanadium (V), niobium (Nb), indium (In), antimony (Sb) by about 1 wt% or less. The component, content, and weight% of the metal plate 10 may be confirmed using a method of examining the weight% of each component by selecting a specific region a* b on a plane of the metal plate 10, sampling a test piece (a*b*t) corresponding to the thickness t of the metal plate 10, and dissolving it in a strong acid, etc. However, the embodiment is not limited thereto, and the content may be confirmed by various methods

The metal plate 10 may be manufactured by a cold rolling method. For example, the metal plate 10 may be formed by melting, forging, hot rolling, normalizing, primary cold rolling, primary annealing, secondary cold rolling, and secondary annealing processes, and may have a thickness of about 30 um or less through the above processes. Alternatively, the metal plate 10 may have a thickness of about 30 um or less through an additional thickness reduction process after the above processes.

The metal plate 10 may be wound as shown in FIG. 24. For example, the metal plate 10 may be manufactured by a cold rolling method, and the manufactured metal plate 10 may be wound using a winding roll or the like. In detail, a manufacturing process of the deposition mask 100 may be performed by a roll-to-roll process, and the metal plate 10 may be continuously supplied using the wound metal plate 10.

The metal plate 10 may have a quadrangular shape. For example, the metal plate 10 may have a rectangular shape including a major axis and a minor axis. In detail, the metal plate 10 may have a first direction, which is a rolling direction RD, and may have a second direction, which is a transverse direction TD that crosses the rolling direction. The first direction may correspond to a major axis direction of the metal plate, and the second direction may correspond to a minor axis direction of the metal plate.

As the metal plate 10 is manufactured by a rolling process, a warp phenomenon may occur in the metal plate 10. In detail, the metal plate 10 may include an internal stress during the rolling process, and the warp phenomenon may occur in the metal plate 10 due to the internal stress, that is, a residual stress.

In manufacturing the deposition mask 100 using the metal plate 10, the above-described residual stress may be an important factor. Therefore, it may be desirable to measure the residual stress of the metal plate 10 before manufacturing the deposition mask 100. In detail, a failure such as a warp phenomenon may occur in the metal plate 10 due to the residual stress, and a failure may occur in the deposition mask 100 manufactured due to the failure. Accordingly, it may be desirable to measure the residual stress of the metal plate 10 in advance.

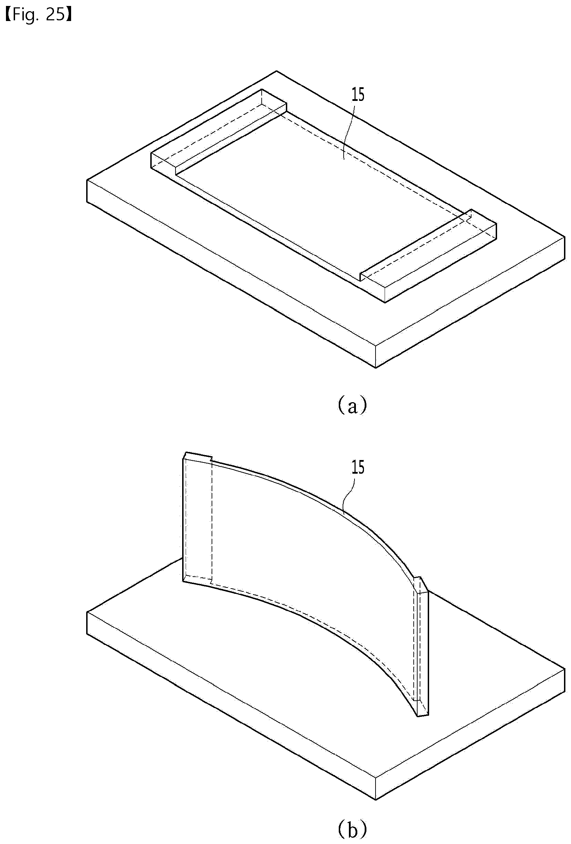

FIG. 25 is a view illustrating a method of measuring a residual stress of a metal plate according to Comparative Example. Comparative Example will be described first with reference to FIG. 25.

Referring to FIG. 25, a sample metal plate 15 extracted from a metal plate may be prepared to measure the residual stress of the metal plate. The sample metal plate 15 may have a major axis and a minor axis, and the sample metal plate 15 may be manufactured by etching a region except for a region within a predetermined distance from both ends in the major axis direction. The etching is half-etching one surface of the sample metal plate 15, and the half-etching may be performed until a thickness of one surface of the sample metal plate 15 becomes about 30% to 70% of the total thickness of the sample metal plate 15.

Subsequently, the sample metal plate 15 may be disposed on a horizontal table to measure the residual stress. In this case, the sample metal plate 15 disposed on the horizontal table may be disposed to face an upper surface of the horizontal table as shown in FIG. 25B.

As described above, in the sample metal plate 15 disposed on the horizontal table, the warp phenomenon (wave deformation) may occur due to an internal stress, and the residual stress may be calculated based on data obtained by measuring a degree of warpage. However, when a thickness of the metal plate is thin, the residual stress may not be accurately measured by the above-described method. For example, a deposition mask for realizing a high-resolution pattern of 400 PPI or more is manufactured by a metal plate having a thickness of about 30 um or less, and a side surface of the metal plate having the thickness as described above may not be disposed parallel to the horizontal table. That is, when the thickness of the metal plate is thin, it may be very difficult to stand the metal plate on the horizontal table due to the thickness thereof, and thus it may be impossible to measure the residual stress.

In other words, conventionally, a sample metal plate was manufactured by half-etching a region except for partial regions of both ends of one surface of the sample metal plate. Subsequently, the sample metal plate was set on a flat horizontal table, and a degree of warpage of the sample metal plate was measured to measure a residual stress thereof. However, in such a sample metal plate, both end regions in the longitudinal direction remain without being etched. In addition, for the above reasons, when the sample metal plate is set on a flat horizontal table, all four vertices are not etched and thus are not lifted, so that it is difficult to measure the residual stress in a horizontal state.

In addition, in the metal plate for realizing a high-resolution pattern, it is very difficult to stand on the horizontal table because a thickness thereof is very thin. In detail, when the thickness of the metal plate is thin, the sample metal plate to be manufactured also has a thin thickness, and thus it is very difficult to stand for a side surface of the sample metal plate to face an upper surface of the horizontal table. Accordingly, there is a problem that a residual stress of a thin metal plate is very difficult to measure, and in the deposition mask manufactured using the metal plate, uniformity characteristics of a through-hole to be formed and adhesion to a substrate may be lowered due to an internal stress, and a problem such as a decrease in deposition efficiency and deposition failure may occur.

On the contrary, in the embodiment, the residual stress may be measured regardless of the thickness of the metal plate 10.

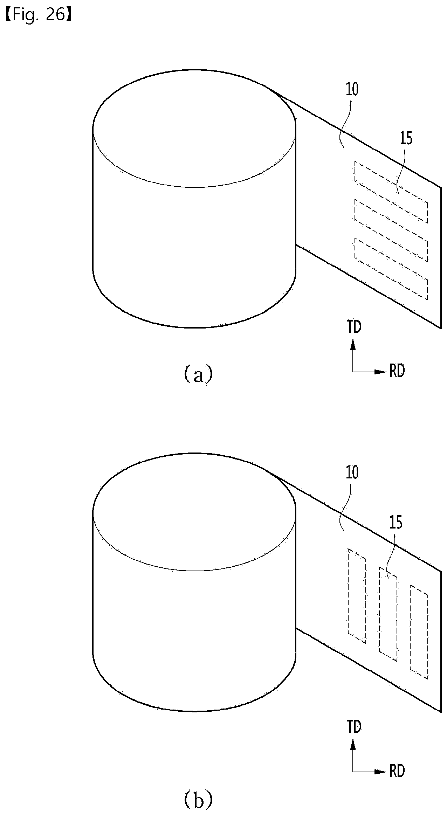

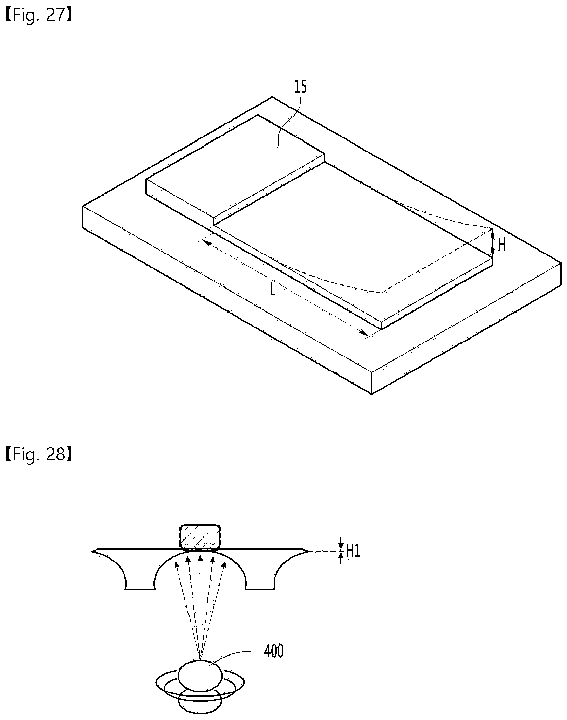

FIG. 26 is a view for describing a sample metal plate manufactured using a metal plate according to Example. FIG. 27 is a view for describing a measuring method of a residual stress according to Example. With reference to FIGS. 26 and 27, a residual stress characteristic and a measurement method of the metal plate according to Example will be described. Referring to FIG. 26, the metal plate 10 may be a metal plate for manufacturing a deposition mask 100 for realizing a high-resolution of 400 PPI or more, and may have a thickness of about 30 um or less.

The metal plate 10 may be formed by rolling a base metal plate as a base material. The base metal plate may include a metal material. The base metal plate may include about 60 wt% to about 65 wt% of the iron, and may include about 35 wt% to about 40 wt% of the nickel. In detail, the base metal plate may include about 63.5 wt% to about 64.5 wt% of the iron, and may include about 35.5 wt% to about 36.5 wt% of the nickel. In addition, the base metal plate may further include at least one element of carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb) by about 1 wt% or less. That is, the base metal plate and the metal plate 10 may include the same material.

Subsequently, a step of forming a sample metal plate 15 using the metal plate 10 may be performed. The residual stress of the metal plate 10 may be measured using the sample metal plate 15. The sample metal plate 15 may be a sample collected at an arbitrary point on the metal plate 10. In this case, the sample metal plate 15 may be at least one sample collected at the arbitrary point on the metal plate 10, and the residual stress may be measured using the at least one sample.

The step of forming the sample metal plate 15 may include a step of extracting the sample metal plate 15 from the metal plate 10 and a step of etching the sample metal plate 15.

The step of extracting the sample metal plate 15 is a step of extracting a sample metal plate having a strip shape in which a width is larger than a height at the arbitrary point on the metal plate 10, and may be a step of extracting a first sample metal plate extracted to have a width in a first direction and a second sample metal plate extracted to have a width in a second direction. For example, the sample metal plate 15 may include a first sample metal plate extracted in a first direction which is a rolling direction RD of the metal plate 10 and a second sample metal plate extracted in a second direction which is a transverse direction TD of the metal plate 10.

The sample metal plate 15 may be a sample having a size of about 200 mm*30 mm (width*length). In detail, the length of the first sample metal plate in the first direction may be about 200 mm and the length in the second direction may be 30 mm. That is, a major axis of the first sample metal plate may extend in the rolling direction RD. In addition, the length of the second sample metal plate in the first direction may be about 30 mm and the length in the second direction may be about 200 mm. That is, a major axis of the second sample metal plate may extend in the transverse direction TD.

Subsequently, the step of etching the sample metal plate 15 may be performed. In detail, the step of etching the sample metal plate 15 may be a step of half-etching one surface of the sample metal plate 15. For example, the step of etching may be a step of half-etching one surface of each of the first sample metal plate and the second sample metal plate.

The step of etching the sample metal plate 15 may be a step of half-etching a region of about 150 mm*30 mm (width*length), which is a region beyond 50 mm, while remaining a region from one end to about 50 mm in the major axis which is a horizontal direction of the sample metal plate 15. In addition, the step of etching the sample metal plate 15 may be a step of half-etching such that a thickness of the region of 150 mm*30 mm becomes about 30% to about 70% of a thickness of the metal plate 10.

Next, a step of measuring the residual stress of the sample metal plate may be performed. In detail, the step of measuring the residual stress may be a step of measuring the residual stress of the first sample metal plate and the second sample metal plate which have been half etched, respectively.

Referring to FIG. 27, the step of measuring the residual stress of the sample metal plate 15 may include a step of setting the sample metal plate 15 on a horizontal table. For example, the step of setting may be a step of disposing at least one sample metal plate 15 of the first sample metal plate and the second sample metal plate that have undergone half-etching on the horizontal table.

The sample metal plate 15 may include one surface and the other surface. In detail, the sample metal plate 15 may include one surface on which half-etching is performed and the other surface on which half-etching is not performed. The step of setting the sample metal plate 15 may be a step in which the other surface of the sample metal plate 15 is disposed to face an upper surface of the horizontal table.

Subsequently, a first residual stress rate and a second residual stress rate may be measured. The first residual stress rate may be a residual stress rate of the first sample metal plate, and the second residual stress rate may be a residual stress rate of the second sample metal plate. In detail, the first residual stress rate may be a residual stress rate of a first sample metal plate having a size of about 200 mm*30 mm (width*length) in which the first direction is a horizontal direction, and the second residual stress rate may be a residual stress rate of a second sample metal plate having a size of about 200 mm*30 mm (width*length) in which the second direction in a horizontal direction. The sample metal plate 15 set on the horizontal table may be warped due to an internal stress caused by the rolling process. In detail, one end of at least one of the etching regions of the sample metal plate 15 may be warped in a direction away from the upper surface of the horizontal table.

More specifically, at least one end of one surface of the half-etched sample metal plate 15 may be warped toward the center of the sample metal plate 15 while being separated from the upper surface of the horizontal table. That is, one end of the sample metal plate 15 may be warped in a direction away from the horizontal table due to the internal stress, and the one end may be warped in a roll shape according to the magnitude of the internal stress.

That is, the residual stress rate of the sample metal plate 15 may be calculated by measuring a height of a half-etched region of the sample metal plate 15 spaced apart from the upper surface of the horizontal table, and the following [Equation] may be satisfied. [Equation] $Residual stress rate = H / L$

(H: the maximum height at which the etching region of the sample metal plate is lifted and warped from the upper surface of the horizontal table, L: a length in a horizontal direction in which the etching region of the sample metal plate is formed)

The residual stress rate of the sample metal plate 15 may be measured by the method described above. At this time, the residual stress rate may be a value obtained by using a plurality of sample metal plates 15. For example, the first residual stress rate of the first sample metal plate may be a value derived from an average value of a plurality of first sample metal plates measured by the method described above. In addition, the second residual stress rate of the second sample metal plate may be a value derived from an average value of a plurality of second sample metal plates measured by the method described above. That is, the residual stress rate may be an average residual stress rate.

The residual stress rate of the sample metal plate 15 may be about 0.06 or less. In detail, the residual stress rate of the sample metal plate 15 may be about 0.0333 (5/150) or less. For example, the first residual stress rate of the first sample metal plate and the second residual stress rate of the second sample metal plate may be about 0.06 or less. Preferably, the first residual stress rate of the first sample metal plate and the second residual stress rate of the second sample metal plate may be about 0.0333 (5/150) or less.

When the residual stress rate of the sample metal plate 15 exceeds about 0.06, a warp phenomenon (wave deformation) may occur in the metal plate 10, and a process failure may occur during manufacturing the deposition mask 100 using the metal plate. In addition, when an organic material is deposited by the deposition mask 100 manufactured using the metal plate 10, deposition failure may occur. In detail, a position, a shape, and the like of a through-hole TH formed in the deposition mask 100 may not be uniform due to the warp phenomenon, and thus deposition efficiency may be lowered, and deposition failure may occur. Therefore, it is preferable that the residual stress rate of the metal plate 10 satisfies the above-described range, and it is more preferable that the residual stress rate is close to zero. That is, when the residual stress rate of the metal plate 10 is out of the above-described range, it may be inappropriate as a metal plate for manufacturing the deposition mask 100.

The residual stress rates of the first sample metal plate and the second sample metal plate may be different from each other. For example, the first residual stress rate of the first sample metal plate extending in the rolling direction RD may be smaller than the second residual stress rate of the second sample metal plate extending in the transverse direction TD.

In this case, the first sample metal plate may be warped in the second direction, and the second sample metal plate may be warped in the second direction. In detail, two corners extending in the major axis direction in the first sample metal plate may tend to be warped and curled toward a central portion of the first sample metal plate due to an internal stress. In addition, one corner, which is positioned in an etching region, of the two corners extending in the minor axis direction in the second sample metal plate may tend to be warped and curled toward a central portion of the second sample metal plate due to an internal stress.

A difference between the first residual stress rate of the first sample metal plate and the second residual stress rate of the second sample metal plate may be about 0.0333 (5/150). In more detail, the difference between the first residual stress rate of the first sample metal plate and the second residual stress rate of the second sample metal plate may be about 0.02 (3/150). When the difference in the residual stress rate exceeds about 0.0333 (5/150), the warp phenomenon may be concentrated in the first direction which is the rolling direction RD or the second direction which is the transverse direction TD of the metal plate 10, and a process failure may occur when the deposition mask 100 is manufactured using the metal plate 10. Therefore, it may be preferable that the difference between the first residual stress rate of the first sample metal plate and the second residual stress rate of the second sample metal plate is within the above-described range, and it may be more preferable that the difference in the residual stress rate is close to zero and is small.

However, Example is not limited thereto, and the first residual stress rate of the first sample metal plate may be greater than the second residual stress rate of the second sample metal plate within the above-described range of the residual stress rate. In addition, the first residual stress rate of the first sample metal plate may be greater than the second residual stress rate of the second sample metal plate within the above-described difference range of the residual stress rate. In this case, the first sample metal plate may be warped in the first direction, and the second sample metal plate may be warped in the first direction. In detail, one corner, which is positioned in an etching region, of the two corners extending in the minor axis direction in the first sample metal plate may tend to be warped and curled toward the central portion of the first sample metal plate. In addition, two corners extending in the major axis direction in the second sample metal plate may tend to be warped and curled toward the central portion of the second sample metal plate.

The deposition mask 100 may be manufactured by supplying the metal plate 10 in a roll-to-roll method. In this case, the metal plate 10 may be supplied in the major axis direction of the metal plate 10, and may be supplied while applying a predetermined amount of tensile force in the major axis direction of the metal plate by the roll-to-roll method. That is, the metal plate 10 may be supplied while the tensile force is applied in the rolling direction RD of the metal plate 10.

In addition, in a manufacturing process of the deposition mask 100 for forming a through-hole and the like on the metal plate 10, a separate tensile force may be further applied to the metal plate 10 in the major axis direction of the metal plate 10. That is, a separate tensile force may be further applied in the rolling direction RD of the metal plate 10.

Accordingly, the metal plate 10 may be pulled in the rolling direction RD. Therefore, it may be preferable that the residual stress rate in the rolling direction RD of the metal plate 10 is smaller than the residual stress rate in the transverse direction TD. In detail, it may be preferable that the first residual stress rate of the metal plate 10 is smaller than the second residual stress rate thereof. That is, it may be preferable that the residual stress rate of the first sample metal plate extracted from the metal plate 10 in the first direction which is the rolling direction RD is smaller than the residual stress rate of the second sample metal plate extracted in the second direction which is the transverse direction TD.

As an example, when the first residual stress rate of the metal plate 10 is greater than the second residual stress rate, a lot of warp phenomenons may occur in the first direction of the metal plate 10, and thus a lot of deformation may occur. Therefore, when the metal plate 10 is supplied by a roll-to-roll method, a length of the supplied metal plate 10 may not be uniform due to the deformation. In addition, in the process of forming a through-hole and the like on the metal plate 10, the uniformity of the position and shape of the formed through-hole may be lowered due to deformation caused by the warp phenomenon.

Therefore, that the first residual stress rate of the metal plate 10 is lower than the second residual stress rate of the metal plate 10 may be preferable than that the first residual stress rate is higher than the second residual stress rate of the metal plate 10. Accordingly, even though the metal plate 10 is pulled in the rolling direction RD in the manufacturing process of the deposition mask 100, it is possible to form a uniform and precise pattern.

Hereinafter, an operation and effect of the present invention will be described in more detail with reference to Examples and Comparative Examples.

### Example 1

A sample metal plate was extracted from a metal plate having a thickness of about 25 um and containing about 63.5 wt% to about 64.5 wt% of iron and about 35.5 wt% to about 36.5 wt% of nickel.

The sample metal plate has a size of 200 mm*30 mm (width*length), and a first sample metal plate was extracted in the rolling direction RD of the metal plate, and a second sample metal plate was extracted in the transverse direction TD.

A length in a horizontal direction of the first sample metal plate may be 200 mm, and the horizontal direction of the first sample metal plate may be the rolling direction RD. In addition, a length in a horizontal direction of the second sample metal plate may be 200mm, and the horizontal direction of the second sample metal plate may be the transverse direction TD.

Subsequently, a region of about 150 mm*30 mm (width*length), which is a region beyond 50 mm, was half-etched while remaining a region from one end to 50 mm in the horizontal direction of the sample metal plate. The half-etching was performed until a thickness of the etching region became about 30% to about 70% of a thickness of a region in which the etching was not performed.

The sample metal plate after the half-etching process was disposed on a horizontal table. In this case, the other surface opposite to one surface half-etched of the sample metal plate was disposed so as to face an upper surface of the horizontal table.

Each of the first sample metal plate and the second sample metal plate was manufactured by three in the above-described method, an average value for each direction was derived by measuring the maximum height at which an end of each sample metal plate disposed on the horizontal table is spaced apart from the horizontal table, and a residual stress rate was calculated based on the average value.

### Example 2

Except for extracting a sample metal plate from a metal plate having a thickness of about 25 um and containing about 63.5 wt% to about 64.5 wt% of iron and about 35.5 wt% to about 36.5 wt% of nickel, three sample metal plates were manufactured in the same manner as in Example 1 for each of a rolling direction RD and a transverse direction TD.

Subsequently, the sample metal plate was disposed on a horizontal table, and an average value for each direction was derived by measuring the maximum height at which an end of each sample metal plate disposed on the horizontal table is spaced apart from the horizontal table, and a residual stress rate was calculated based on the average value.

### Example 3

Except for extracting a sample metal plate from a metal plate having a thickness of about 30 um and containing about 63.5 wt% to about 64.5 wt% of iron and about 35.5 wt% to about 36.5 wt% of nickel, three sample metal plates were manufactured in the same manner as in Example 1 for each of a rolling direction RD and a transvers direction TD.

Subsequently, the sample metal plate was disposed on a horizontal table, and an average value for each direction was derived by measuring the maximum height at which an end of each sample metal plate disposed on the horizontal table is spaced apart from the horizontal table, and a residual stress rate was calculated based on the average value.

### Example 4

Except for extracting a sample metal plate from a metal plate having a thickness of about 20 um and containing about 63.5 wt% to about 64.5 wt% of iron and about 35.5 wt% to about 36.5 wt% of nickel, three sample metal plates were manufactured in the same manner as in Example 1 for each of a rolling direction RD and a transverse direction TD.

Subsequently, the sample metal plate was disposed on a horizontal table, and an average value for each direction was derived by measuring the maximum height at which an end of each sample metal plate disposed on the horizontal table is spaced apart from the horizontal table, and a residual stress rate was calculated based on the average value.

### Comparative Example 1

Except for extracting a sample metal plate from a metal plate having a thickness of about 30 um and containing about 63.5 wt% to about 64.5 wt% of iron and about 35.5 wt% to about 36.5 wt% of nickel, three sample metal plates were manufactured in the same manner as in Example 1 for each of a rolling direction RD and a transverse direction TD.

Subsequently, the sample metal plate was disposed on a horizontal table, and an average value for each direction was derived by measuring the maximum height at which an end of each sample metal plate disposed on the horizontal table is spaced apart from the horizontal table, and a residual stress rate was calculated based on the average value.

### Comparative Example 2

Except for extracting a sample metal plate from a metal plate having a thickness of about 25 um and containing about 63.5 wt% to about 64.5 wt% of iron and about 35.5 wt% to about 36.5 wt% of nickel, three sample metal plates were manufactured in the same manner as in Example 1 for each of a rolling direction RD and a transverse direction TD.

Subsequently, the sample metal plate was disposed on a horizontal table, and an average value for each direction was derived by measuring the maximum height at which an end of each sample metal plate disposed on the horizontal table is spaced apart from the horizontal table, and a residual stress rate was calculated based on the average value.

**[Table 5]**

| Etching region 150mm*30mm (width*length) | | Example 1 | Example 2 | Example 3 | Example 4 | Comparativ e Example 1 | Comparativ e Example 2 |
|---|---|---|---|---|---|---|---|
| | | Maximum separation height (mm) | | | | | |
| First sample metal plate (RD) | Sample 1 | 1 | 8 | 2 | 3 | 6 | 12 |
| | Sample 2 | 1 | 5 | 4 | 4 | 5 | 17 |
| | Sample 3 | 2 | 2 | 3 | 6 | 7 | 18 |
| | Average value | 1 | 5 | 3 | 4 | 6 | 16 |
| | Residual stress rate | 0.0066 | 0.0333 | 0.02 | 0.0266 | 0.04 | 0.1066 |
| Second sample metal plate (TD) | Sample 1 | 4 | 4 | 5 | 14 | 9 | Roll |
| | Sample 2 | 4 | 8 | 4 | 6 | 13 | Roll |
| | Sample 3 | 2 | 7 | - | 7 | 7 | Roll |
| | Average value | 3 | 6 | 5 | 9 | 10 | X |
| | Residual stress rate | 0.02 | 0.04 | 0.0333 | 0.06 | 0.0666 | Unavailable |

Referring to Table 5, it can be seen that a residual stress rate of a thin metal plate may be measured. In detail, it can be seen that the residual stress rate of the metal plate having a thickness of about 30 um or less may be measured, and the residual stress rate of the metal plate having a thickness of about 20 um may be measured.

In addition, referring to Table 5, in the residual stress rate of the sample metal plate according to Examples and Comparative Examples, it can be seen that the residual stress rate of the first sample metal plate extending in the rolling direction RD is smaller than the residual stress rate of the second sample metal plate extending in the transverse direction TD. In addition, it can be seen that the residual stress rate of the sample metal plate according to Examples is 0.06 or less. In detail, it can be seen that the residual stress rate of each of the first sample metal plate and the second sample metal plate according to Examples is 0.06 or less. That is, the metal plate according to Example may have a low residual stress rate, thereby minimizing a warp phenomenon. When manufacturing a deposition mask using the metal plate, a position and shape of a through-hole may be precisely formed on the metal plate.

On the other hand, in case of Comparative Example 1, the residual stress rate of the first sample metal plate extending in the rolling direction RD is 0.06 or less, but the residual stress rate of the second sample metal plate extending in the transverse direction TD exceeds 0.06. Therefore, the sample metal plate of Comparative Example 1 tends to warp in the transverse direction TD. In case of Comparative Example 2, the residual stress rate of the first sample metal plate extending in the rolling direction RD exceeds 0.06, and since the second sample metal plate extending in the transverse direction TD was warped and curled in the transverse direction TD, the measurement was not possible. That is, in the metal plate according to Comparative Examples, both the residual stress rate in the rolling direction RD and the residual stress rate in the transverse direction TD are large. In particular, since the residual stress rate in the transverse direction TD is very large, the metal plate of Comparative Examples tends to be warped in the transverse direction TD. Accordingly, when a deposition mask is manufactured using the metal plate of Comparative Example, a position and shape of a through-hole formed on the metal plate may not be uniform.

In Example, it is possible to effectively measure a residual stress of a metal plate 10 manufactured thinly by a rolling process. In detail, the residual stress of the metal plate 10 having a thickness of about 30 um or less may be measured. In more detail, the residual stress may be measured without being affected by a thickness of the metal plate 10.

In addition, the metal plate 10 measured by the method described above may have a residual stress rate of about 0.06 or less. In detail, a residual stress rate in the rolling direction RD and a residual stress rate in the transverse direction TD of the metal plate may be about 0.06 or less. Accordingly, in Example, a deposition mask 100 having a more precise pattern may be manufactured using the metal plate 10.

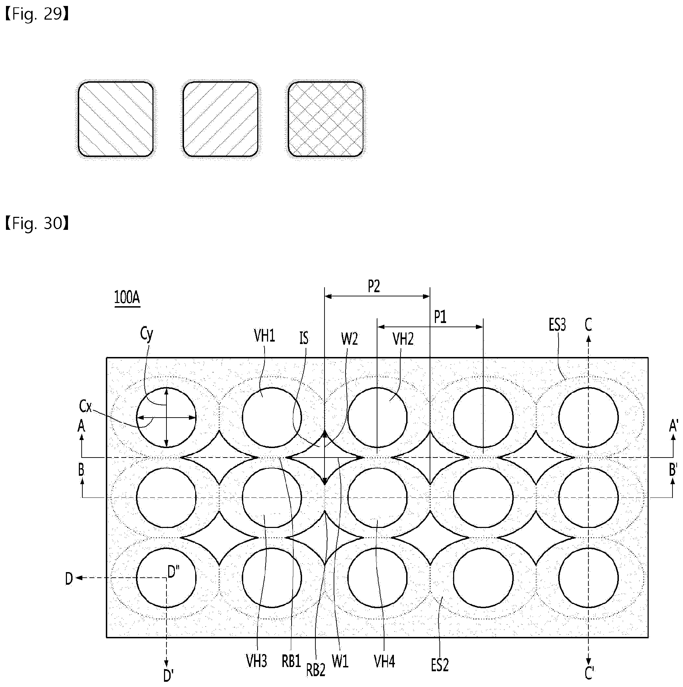

FIG. 28 and FIG. 29 are views illustrating a deposition pattern formed via a deposition mask according to an embodiment.

Referring to FIG. 28, in a deposition mask 100 according to an embodiment, a height H1 between one surface of the deposition mask 100 in which a small surface hole V1 is formed and a communication portion may be about 3.5 um or less. For example, the height H1 may be about 0.1 um to about 3.4 um. For example, the height H1 may be about 0.5 um to about 3.2 um. For example, the height H1 may be about 1 um to about 3 um.

Accordingly, a distance between one surface of the deposition mask 100 and a substrate on which a deposition pattern is disposed may be short, and thus deposition failures due to a shadow effect may be reduced. For example, it is possible to prevent failures in which different deposition materials are deposited in a region between two adjacent patterns when forming R, G, and B patterns by using the deposition mask 100 according to the embodiment. Specifically, as shown in FIG. 29, when the above patterns are formed in order of R, G, and B from the left, it is possible to prevent the R pattern and the G pattern from being deposited in a region between the R pattern and the G pattern by the shadow effect.

In addition, the deposition mask 100 according to the embodiment may be manufactured using a metal plate having a residual stress rate of 0.06 or less. In detail, the deposition mask 100 may be manufactured using a metal plate having a residual stress rate in the rolling direction RD and a residual stress rate in the transverse direction TD of 0.06 or less. Accordingly, it is possible to minimize occurrence of a warp phenomenon in the metal plate 10 when manufacturing the deposition mask 100. Accordingly, a small surface hole V1, a large surface hole V2, and a through-hole TH may be formed uniformly and precisely on the metal plate 10.

In addition, since the deposition mask 100 according to the embodiment is manufactured by using a metal plate in which a residual stress is measured in advance, a high-resolution pattern of 400 PPI or more, and further 800 PPI or more may be precisely realized, and when depositing an organic material on a substrate 300 using the deposition mask 100, it is possible to improve deposition efficiency of the organic material.

Meanwhile, an inclination angle of a large surface hole formed in the deposition mask affects a height or thickness of a central portion of a rib. That is, when the inclination angle of the large surface hole is smaller than a predetermined range, the thickness of the central portion of the rib connecting between through-holes becomes thin. In addition, when the thickness of the central portion of the rib becomes thin, rigidity of the deposition mask is lowered, thereby causing deformation of the length of the deposition mask such as tensile deformation, total pitch deformation, and sagging. Further, as the length is deformed, uniformity of the shape of the mask pattern and the position of the through-hole may be lowered. Furthermore, when a diameter of the through-hole is not uniform, the pattern deposition efficiency may be lowered, thereby generating deposition failure.

In addition, when the inclination angle of the large surface hole formed in the deposition mask is larger than a predetermined range, there is a problem that when an organic material is deposited on the substrate, a part of the organic material does not pass through the through-hole. In detail, in a region which is not overlapped with an organic material deposition container or a through-hole positioned in a direction perpendicular to a moving direction of the organic material deposition container, a moving distance of the organic material is longer, and accordingly, there is a problem that a part of the organic material cannot pass through the through-hole and is deposited on an island portion formed between adjacent through-holes or on an inner surface of the large surface hole of the through-hole.

Therefore, in the embodiment, it is possible to provide a deposition mask capable of uniformly forming a high-resolution or ultra-high resolution (UHD-class) pattern without deposition failure, and preventing various length deformations.

FIG. 30 is a view illustrating a plan view of an effective portion of a deposition mask 100A according to another embodiment of the present invention.

As shown in FIG. 30, a large surface hole V2 may include a plurality of etching surfaces. That is, in FIG. 6A, it has been described that the large surface hole V2 includes the second etching surface ES2. At this time, the large surface hole V2 in FIG. 6A also substantially includes a plurality of etching surfaces, but the plurality of etching surfaces are formed under the same conditions. On the other hand, the deposition mask 100A in FIG. 30 is formed under a condition in which the etching surface in the vertical direction and the etching surface in the horizontal direction are different from each other in one large surface hole V2.

That is, in the deposition mask 100 in FIG. 6A, the large surface hole V2 was formed while having the second etching surface ES2 under the same conditions as a whole, but in the deposition mask 100A in FIG. 30, the large surface hole V2 may be formed while having the second etching surface ES2 and the third etching surface ES3 under different conditions.

Here, the large surface hole V2 and a small surface hole V1 of the deposition mask in the embodiment of FIG. 30 are disposed to be aligned with each other. In other words, the center of the small surface hole V1 and the center of the large surface hole V2 formed in all regions of the deposition mask are aligned. For example, the center of the small surface hole V1 and the center of the large surface hole V2 formed in all regions of the deposition mask may be positioned on the same vertical line.

Meanwhile, the etching surface may also be referred to as an inner surface of the large surface hole V2.

As shown in FIG. 30, as in another embodiment of the present disclosure, the large surface hole V2 may include a second etching surface ES2 and a third etching surface ES3. The large surface hole is formed by connecting a plurality of second etching surfaces ES2 and a plurality of third etching surfaces ES3. Preferably, the plurality of second etching surfaces ES2 and the plurality of third etching surfaces ES3 form one large surface hole.

The second etching surface ES2 of the large surface hole is an inner surface positioned in the horizontal direction with respect to the center of the large surface hole of the through-hole. Preferably, the second etching surface ES2 is an inner surface positioned at both sides in the longitudinal direction with respect to the center of the large surface hole. The second etching surface ES2 is an inner surface positioned at both sides of the tensile direction with respect to the center of the large surface hole. The second etching surface ES2 is an inner surface positioned at both sides of the X-axis direction with respect to the center of the large surface hole. Therefore, the second etching surface ES2 includes a first sub-second etching surface ES2-1 positioned in a first longitudinal direction with respect to the center of the large surface hole of the through-hole, and a second sub-second etching surface ES2-2 positioned in a second longitudinal direction opposite to the first longitudinal direction. Meanwhile, in the other surface of the deposition mask, a cross-sectional inclination angle of the first sub-second etching surface ES2-1 may correspond to a cross-sectional inclination angle of the second sub-second etching surface ES2-2. That is, the cross-sectional inclination angles θ of the first sub-second etching surface ES2-1 and the second sub-second etching surface ES2-2 may be the same.

The third etching surface ES3 of the large surface hole is an inner surface positioned in the vertical direction with respect to the center of the large surface hole of the through-hole. Preferably, the third etching surface ES3 is an inner surface positioned at both sides of the lateral direction with respect to the center of the large surface hole. The third etching surface ES3 is an inner surface positioned at both sides of the direction perpendicular to the tensile direction with respect to the center of the large surface hole. The third etching surface ES3 is an inner surface positioned at both sides of the Y-axis direction with respect to the center of the large surface hole. Therefore, the third etching surface ES3 includes a first sub-third etching surface ES3-1 positioned in a first lateral direction with respect to the center of the large surface hole of the through-hole, and a second sub-third etching surface ES3-2 positioned in a second lateral direction opposite to the first lateral direction. Meanwhile, a cross-sectional inclination angle of the first sub-third etching surface ES3-1 may correspond to a cross-sectional inclination angle of the second sub-third etching surface ES3-2. That is, the inclination angles θ of the first sub-third etching surface ES3-1 and the second sub-third etching surface ES3-2 may be the same.

Meanwhile, a cross-sectional inclination angle θ of the second etching surface ES2 may be different from a cross-sectional inclination angle θ of the third etching surface ES3. That is, the cross-sectional inclination angle θ of the second etching surface ES2 may be smaller than the cross-sectional inclination angle θ of the third etching surface ES3. That is, in the large surface hole of the through-hole, a cross-sectional inclination angle θ of an etching surface in the lateral direction crossing the longitudinal direction may be larger than a cross-sectional inclination angle θ of an etching surface in the longitudinal direction.

The second etching surface ES2 and the third etching surface ES3 may be surfaces formed by an etching factor during an etching process. The second etching surface ES2 and the third etching surface ES3 may be inner surfaces extending from the through-hole TH to the other surface 102 of the deposition mask 100. For example, the second etching surface ES2 and the third etching surface ES3 may extend from an end of the through-hole TH toward an adjacent through-hole TH, and may extend toward the island portion IS. In addition, the second etching surface ES2 and the third etching surface ES3 may extend in the direction of the ineffective portion UA. That is, the second etching surface ES2 and the third etching surface ES3 may extend in the direction in which a non-etching surface is formed in the other surfaces 102 of the deposition mask 100.

Ribs RB1 and RB may be positioned between the through-holes TH. For example, referring to FIG. 30, one second rib RB2 may be formed between a first through-hole TH1 and a second through-hole TH2 adjacent in the horizontal direction. In addition, another first rib RB1 may be formed between the first through-hole TH1 and a third through-hole TH3 adjacent in the vertical direction.

The first rib RB1 is disposed to extend in the longitudinal direction on the deposition mask 100. The first rib RB1 is positioned in the longitudinal direction between a plurality of through-holes arranged in the lateral direction on the deposition mask 100. The first rib RB1 connects between a plurality of island portions IS arranged in the longitudinal direction on the deposition mask 100.

The second rib RB2 is disposed to extend in the lateral direction on the deposition mask 100. The second rib RB2 is formed in the lateral direction between a plurality of through-holes arranged in the longitudinal direction on the deposition mask 100. The second rib RB2 connects between a plurality of island portions IS arranged in the lateral direction on the deposition mask 100.

That is, the ribs RB1 and RB2 may be positioned between the through-holes TH adjacent to each other. In detail, the ribs RB1 and RB2 may be positioned between the large surface holes V2 adjacent to each other. In more detail, the second rib RB2 may be positioned in a region in which the respective second etching surfaces ES2 of the large surface holes V2 adjacent to each other are connected to each other. In more detail, the first rib RB1 may be positioned in a region in which the respective third etching surfaces ES3 of the large surface holes V2 adjacent to each other are connected to each other. That is, the ribs RB1 and RB2 may be regions in which boundaries of the large surface holes V2 adjacent to each other are connected.

A central portion of the first rib RB1 may have a first thickness T1. In addition, a central portion of the second rib RB2 may have a second thickness T2 different from the first thickness T1. The thickness of the central portion of the first rib RB1 may be different from that of the central portion of the second rib RB2. In detail, the thickness of the central portion of the first rib RB1 may be greater than that of the central portion of the second rib RB2. That is, the first rib RB1 is positioned in a region connecting the third etching surfaces ES3 of adjacent through-holes, and the second rib RB2 is positioned in a region connecting the second etching surfaces ES2 of adjacent through-holes. In this case, a cross-sectional inclination angle of the third etching surface ES3 is greater than a cross-sectional inclination angle of the second etching surface ES2. Therefore, the thickness of the central portion of the first rib RB1 positioned in a region connecting the second etching surfaces ES2 having the larger cross-sectional inclination angle may be greater than the thickness of the central portion of the second rib RB2 positioned in a region connecting the third etching surfaces ES3 having the smaller cross-sectional inclination angle. Meanwhile, the cross-sectional inclination angle will be described below.

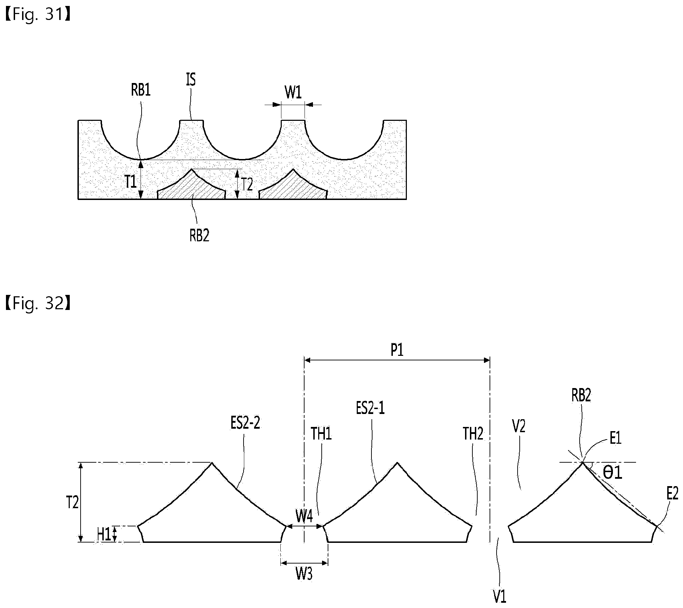

FIG. 31 is a view illustrating each cross section overlapped for describing a height step and a size between the cross section in the A-A' direction and the cross section in the B-B' direction of FIG. 30

First, the cross section in the A-A' direction will be described. The A-A' direction is a cross section that crosses the center region between a first through-hole TH1 and a third through-hole TH3 adjacent in the vertical direction. That is, the cross section in the A-A' direction may not include the through-hole TH.

A third etching surface ES3 in a large surface hole and an island portion IS which is the other surface of a deposition mask not etched between a third etching surfaces ES3 in the large surface hole may be positioned in the cross section in the A-A' direction. Accordingly, the island portion IS may include a surface parallel to one unetched surface of the deposition mask. Alternatively, the island portion IS may include a surface that is the same as or parallel to the other unetched surface of the deposition mask.

Next, the cross section in the B-B' direction will be described. The B-B' direction is a cross section that crosses the center of each of the first through-hole TH1 and the second through-hole TH2 that are adjacent in the horizontal direction. That is, the cross section in the direction B-B' may include a plurality of through-holes TH.

One second rib RB2 may be positioned between the third through-hole TH3 and the fourth through-hole TH4 adjacent in the direction B-B'. Another second rib RB2 may be positioned between the fourth through-hole TH4 and the fifth through-hole adjacent to the fourth through-hole in the horizontal direction but positioned in a direction opposite to third through-hole TH3. One through-hole TH may be positioned between the one rib and the other rib. That is, one through-hole TH may be positioned between two ribs RB adjacent in the horizontal direction.

In addition, in the cross section in the A-A' direction, a first rib RB1 which is a region in which the etching surface ES3 in the large surface hole and the etching surfaces ES3 in the adjacent large surface hole are connected to each other, may be positioned. Here, the first rib RB1 may be a region in which a boundary of two adjacent large surface holes is connected.

Since the first rib and the second rib RB1 and RB2 are an etching surface, it may have a smaller thickness than the island portion IS. For example, the island portion may have a width of about 2 um or more. That is, a width in a direction parallel to the other surface of a portion remaining unetched on the other surface may be about 2 um or less. When widths of one end and the other end of one island portion IS are 2 um or more, the total volume of the deposition mask 100 may be increased. The deposition mask 100 having such a structure ensures sufficient rigidity against a tensile force applied to an organic material deposition process or the like, and thus it may be advantageous for maintaining uniformity of the through-hole.

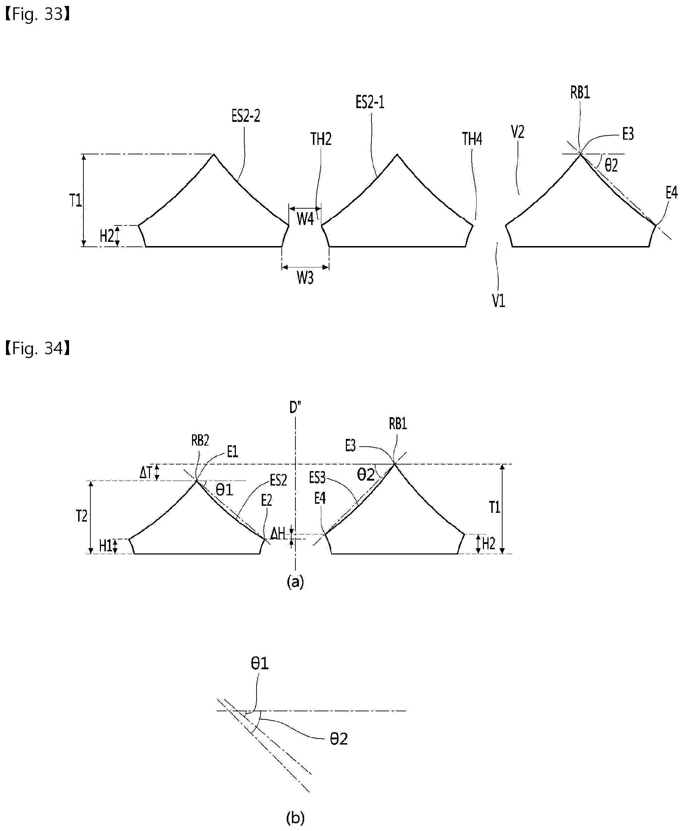

FIG. 32 is a view illustrating a cross-sectional view taken along line B-B' in FIG. 30, FIG. 33 is a view illustrating a cross-sectional view taken along line C-C' in FIG. 30, and FIG. 34 is a view illustrating a cross-sectional view taken along line D-D' in FIG. 30.

FIGS. 32 to 34 show a difference between a cross-sectional inclination angle of the second etching surface ES2 and a cross-sectional inclination angle of the third etching surface ES3 in a through-hole. FIGS. 32 to 34 show a difference between a thickness of the second rib RB2 positioned in a region in which the second etching surfaces ES2 are connected and a thickness of the first rib RB1 positioned in a region in which the third etching surfaces ES3 are connected. FIGS. 32 to 34 show a difference between a height between one surface and a communication portion of the deposition mask 100 on which the small surface hole V1 is formed on the first rib RB1 and a height between one surface and a communication portion of the deposition mask 100 on which the small surface hole V1 is formed on the second rib RB2.

With reference to FIGS. 32 to 34, a cross section in the B-B' direction, a cross section in the C-C' direction, and a vertical and horizontal cross section in the D-D' direction will be described. In addition, ribs RB1 and RB2 and a through-hole TH between the ribs RB1 and RB2 of an effective region according to FIGS. 32 to 34 will be described.

Referring to FIGS. 32 to 34, in the deposition mask 100 according to the embodiment, a thickness of an effective portion AA in which the through-hole is formed by etching may be different from a thickness of an ineffective portion UA that is not etched. In detail, a thickness of a central portion of the first rib RB1 and a central portion of the second rib RB2 may be smaller than the thickness in the ineffective portion UA that is not etched.

In the deposition mask 100 according to the embodiment, the thickness of the ineffective portion UA may be greater than that of the effective portions AA1, AA2, and AA3. For example, in the deposition mask 100, a maximum thickness of the ineffective portion UA or a non-deposition region NDA may be 30 um or less. For example, in the deposition mask 100, the maximum thickness of the ineffective portion UA or the non-deposition region NDA may be 25 um or less. For example, in the deposition mask of the embodiment, the maximum thickness of the ineffective portion or the non-deposition region may be 15 um to 25 um. When the maximum thickness of the ineffective portion or the non-deposition region of the deposition mask according to the embodiment is greater than 30 um, it may be difficult to form a through-hole TH having a fine size because a thickness of a metal plate 10 as a raw material of the deposition mask 100 is thick. In addition, when the maximum thickness of the ineffective portion UA or the non-deposition region NDA of the deposition mask 100 is less than 15 um, it may be difficult to form a through-hole having a uniform size because the thickness of the metal plate is thin.

Maximum thicknesses T1 and T2 measured at the central portions of the first and second ribs RB1 and RB2 may be about 15 um or less. For example, the maximum thicknesses T1 and T2 measured at the center of each of the first and second ribs RB1 and RB2 may be about 7 um to about 10 um. For example, the maximum thicknesses T1 and T2 measured at the center of each of the first and second ribs RB1 and RB2 may be about 6 um to about 9 um. When the maximum thicknesses T1 and T2 measured at the center of each of the first and second ribs RB1 and RB2 are greater than about 15 um, it may be difficult to form an OLED deposition pattern having a high-resolution of 500 PPI or more. In addition, when the maximum thicknesses T1 and T2 measured at the centers of the first and second ribs RB1 and RB2 are less than about 6 um, it may be difficult to form uniformly the deposition pattern.

Meanwhile, the maximum thicknesses T1 and T2 measured at the center of each of the first and second ribs RB1 and RB2 may be different from each other. In detail, the maximum thicknesses T1 and T2 measured at the center of each of the first and second ribs RB1 and RB2 may have different values while satisfying the above range. In more detail, the maximum thickness T1 measured at the center of the first rib RB1 may be greater than the maximum thickness T2 measured at the center of the second rib RB2. The maximum thickness T1 measured at the center of the first rib RB1 may have a value greater than the maximum thickness T2 measured at the center of the second rib RB2 within the above-described range. In other words, the maximum thickness T1 measured at the center of the first rib RB1 may have a predetermined difference value (Δ) from the maximum thickness T2 measured at the center of the second rib RB2.

A height of the small surface hole of the deposition mask 100 may be about 0.2 times to about 0.4 times the maximum thicknesses T1 and T2 of the second rib RB1 and RB2. Accordingly, the height of the small surface hole formed on the first rib RB1 may be different from that of the small surface hole formed on the second rib RB2. In other words, in the small surface hole of the through-hole, the height of the small surface hole in a first direction (specifically, a longitudinal direction) may be different from that of the small surface hole in a second direction (specifically, the lateral direction). In detail, a height H2 of the small surface hole formed on the first rib RB1 may be greater than a height H1 of the small surface hole formed on the second rib RB2.

As an example, the maximum thickness measured at the center of the first rib RB1 or the second rib RB2 may be about 7 um to about 9 um, and the height of the small surface hole between one surface of the deposition mask 100 and the communication portion may be about 1.4 um to about 3.5 um.

The height H2 of the small surface hole at the first rib RB1 of the deposition mask 100 may be about 4.0 um or less. The height H1 of the small surface hole at the second rib RB2 of the deposition mask 100 may be about 3.5 um or less.

Preferably, the height H2 of the small surface hole at the first rib RB1 of the deposition mask 100 may be about 3.5 um or less. The height H1 of the small surface hole at the second rib RB2 of the deposition mask 100 may be about 2.5 um or less.

Preferably, the height H2 of the small surface hole at the first rib RB1 may be about 0.1 um to about 3.4 um. The height H1 of the small surface hole at the second rib RB2 may be about 0.1 um to about 2.4 um. For example, the height of the small surface hole V1 at the first rib RB1 of the deposition mask 100 may be about 0.5 um to about 3.2 um. For example, the height of the small surface hole V1 at the second rib RB1 of the deposition mask 100 may be about 0.5 um to about 2.2 um. For example, the height of the small surface hole at the first rib RB1 of the deposition mask 100 may be about 1 um to about 3 um. For example, the height of the small surface hole at the second rib RB2 of the deposition mask 100 may be about 1 um to about 2 um. Here, the height may be measured in a thickness measurement direction of the deposition mask 100, that is, a depth direction, and may be a height measured from one surface of the deposition mask 100 to the communication portion.

When the height between one surface of the deposition mask 100 and the communication portion is greater than about 3.5 um, deposition failure may occur due to a shadow effect in which the deposition material spreads to a region larger than an area of a through-hole during OLED deposition. Therefore, the height of the small surface hole at the first rib RB1 is set to 3.5 um or less, and the height of the small surface hole at the second rib RB2 is set to 3.0 um or less. Meanwhile, the height of the small surface hole at the first rib RB1 may have a predetermined difference value (Δ) from the height of the small surface hole at the second rib RB2.

In addition, a hole diameter W3 at one surface in which the small surface hole V1 of the deposition mask 100 is formed and a hole diameter W4 at the communication portion which is a boundary between the small surface hole V1 and the large surface hole V2, may be similar to or different from each other. The hole diameter W3 at the one surface in which the small surface hole V1 of the deposition mask 100 is formed may be larger than the hole diameter W4 at the communication portion. For example, a difference between the hole diameter W3 at the one surface of the deposition mask 100 and the hole diameter W4 at the communication portion may be about 0.01 um to about 1.1 um. For example, the difference between the hole diameter W3 at the one surface of the deposition mask and the hole diameter W4 at the communication portion may be about 0.03 um to about 1.1 um. For example, the difference between the hole diameter W3 at the one surface of the deposition mask and the hole diameter W4 at the communication portion may be about 0.05 um to about 1.1 um.

When the difference between the hole diameter W1 at the one surface of the deposition mask 100 and the hole diameter W2 at the communication portion is larger than about 1.1 um, deposition failure may occur due to the shadow effect.

In addition, on the central portion of the second rib RB2, a cross-sectional inclination angle θ corresponding to an inner angle between a virtual first straight line corresponding to the other surface of the deposition mask 100 and a virtual second straight line connecting one end E1 of the second etching surface ES2 of the large surface hole V2 and one end E2 of the communicating portion between the small surface hole V1 and the large surface hole V2 may be 35 degrees to 45 degrees. On the central portion of the first rib RB1, a cross-sectional inclination angle θ corresponding to an inner angle between a virtual first straight line corresponding to the other surface of the deposition mask 100 and a virtual third straight line connecting one end E3 of the third etching surface ES3 of the large surface hole V2 and one end E4 of the communicating portion may be 45 degrees to 55 degrees.

In other words, the cross-sectional inclination angle of the large surface hole may be defined as follows. The cross-sectional inclination angle of the large surface hole may be the inner angle between the virtual first straight line and the virtual second straight line. In this case, the first straight line may refer to the other surface of the deposition mask corresponding to the second or third etching surface of the large surface hole V2. In this case, the other surface may be a surface of the deposition mask in a flat state that has not been etched. In addition, the virtual second straight line may be a straight line connecting one end of the etching surface of the large surface hole V2 and one end of the communication portion.

Accordingly, the deposition pattern having a high-resolution of 400 PPI or more, specifically 500 PPI or more may be formed, and simultaneously, the island portion IS may exist on the other surface of the deposition mask 100.

According to the embodiment, the large surface hole of the through-hole has a first cross-sectional inclination angle in the longitudinal direction, and has a second cross-sectional inclination angle greater than the first cross-sectional inclination angle in the lateral direction, and it is possible to increase the thickness of the ribs disposed in the longitudinal direction by a difference between the first cross-sectional inclination angle and the second cross-sectional inclination angle, thereby securing rigidity of the deposition mask. In addition, as the rigidity of the deposition mask is secured, length deformation may be minimized, and accordingly, pattern deposition efficiency may be improved by increasing the uniformity of the shape of the mask pattern and the position of the through-hole.

In addition, according to the embodiment, the OLED pixel pattern may be uniformly deposited in all regions regardless of the position of the through-hole by reducing the inclination angle of the large surface hole of the through-hole in the direction perpendicular to the moving direction of the organic deposition container.

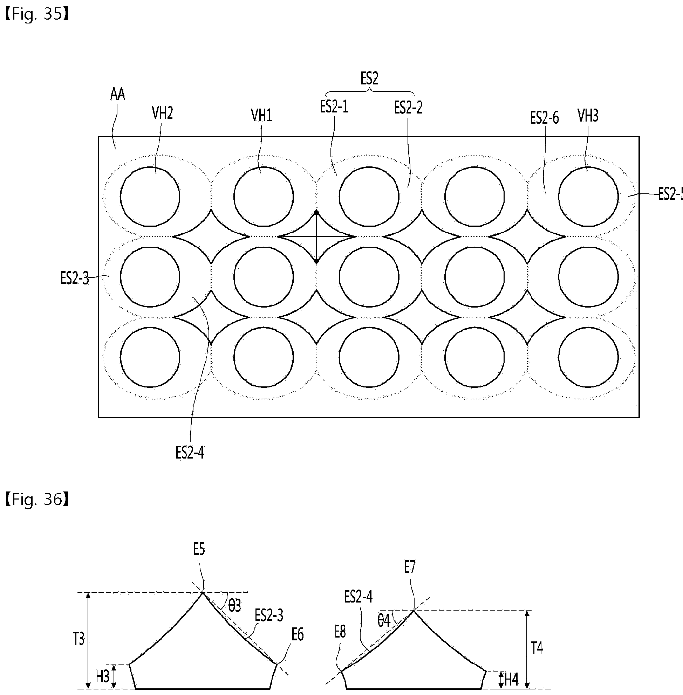

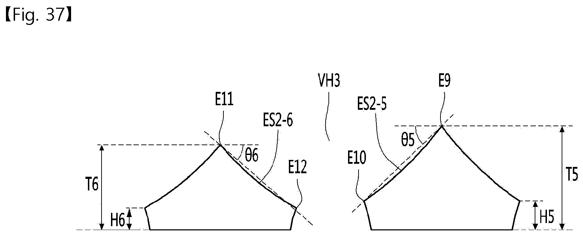

FIG. 35 is a view illustrating a plan view of an effective portion of a deposition mask according to still another embodiment of the present invention, FIG. 36 is a cross-sectional view showing a second through-hole in FIG. 35, and FIG. 37 is a cross-sectional view showing a third through-hole in FIG. 35.

The deposition mask in FIG. 35 has a difference in a through-hole disposed in an outermost portion of an effective portion, as compared with the deposition mask in FIG. 30. Therefore, hereinafter, only the through-hole disposed at the outermost portion of the effective portion in FIG. 35 which is contrasted with FIG. 30 will be described.

Referring to FIG. 35, the effective portion of the deposition mask may include a plurality of through-holes. The plurality of through-holes may include a first through-hole VH1 disposed in an inner region of the effective portion, a second through-hole VH2 disposed in a first outermost portion of the effective portion, and a third through-hole VH3 disposed in a second outermost portion of the effective portion.

The first through-hole VH1 is the same as the through-hole described in FIGS. 31 to 34. That is, the first through-hole VH1 includes a second etching surface ES2 and a third etching surface ES3. The second etching surface ES2 includes a first sub-second etching surface ES2-1 and a second sub-second etching surface ES2-2 facing each other in the longitudinal direction while having the same first cross-sectional inclination angle.

In addition, the third etching surface ES3 includes a first sub-third etching surface ES3-1 and a second sub third etching surface ES3-2 facing each other in the lateral direction while having the same second cross-sectional inclination angle. Further, the first cross-sectional inclination angle of the first through-hole VH1 is smaller than the second cross-sectional inclination angle thereof.

Meanwhile, a second through-hole VH2 may be disposed at the first outermost portion of the effective portion, and a third through-hole VH3 may be disposed at the second outermost portion opposite to the first outermost portion. In detail, the first outermost portion may be an outermost region of a first longitudinal direction in the effective portion. In this case, the first longitudinal direction may be a left direction. Accordingly, the first outermost portion may be a region positioned on the leftmost side in the effective portion. The second outermost portion may be an outermost region of a second longitudinal direction in the effective portion. In this case, the second longitudinal direction may be a right direction. Accordingly, the second outermost portion may be a region positioned at the rightmost side in the effective portion.

The second through-hole VH2 is disposed in the first outermost portion, and the third through-hole VH3 is disposed in the second outermost portion.

A large surface hole of the second through-hole VH2 includes a second etching surface ES2 and a third etching surface ES3 like the first through-hole VH1. In this case, the third etching surface ES3 of the large surface hole of the second through-hole VH2 may have the same cross-sectional inclination angle as the third etching surface ES3 of the large surface hole of the first through-hole VH1. However, a cross-sectional inclination angle of the second etching surface ES2 of the large surface hole of the second through-hole VH2 may be different from the cross-sectional inclination angle of the second etching surface ES2 of the large surface hole of the first through-hole VH1.

The second etching surface ES2 of the large surface hole of the second through-hole VH2 has a third sub-second etching surface ES2-3 and a fourth sub-second etching surface ES2-4 facing each other in the longitudinal direction.

In this case, the third sub-second etching surface ES2-3 is positioned in a region adjacent to an ineffective portion UA, and the fourth sub-second etching surface ES2-4 is positioned in a region adjacent to an inner region (may refer to a central region) of the effective portion.

In addition, the third sub-second etching surface ES2-3 has a third cross-sectional inclination angle, and the fourth sub-second etching surface ES2-4 has a fourth cross-sectional inclination angle. In this case, the third cross-sectional inclination angle and the fourth cross-sectional inclination angle may be different from each other. That is, the third sub-second etching surface ES2-3 may have a cross-sectional inclination angle different from that of the fourth sub-second etching surface ES2-4. Preferably, the cross-sectional inclination angle of the third sub-second etching surface ES2-3 may be greater than that of the fourth sub-second etching surface ES2-4.

In addition, a thickness of a third rib connected to the third sub-second etching surface ES2-3 and a thickness of a fourth rib connected to the fourth sub-second etching surface ES2-4 may also be different from each other. That is, the thickness of the third rib connected to the third sub-second etching surface ES2-3 may be thicker than that of the fourth rib connected to the fourth sub-second etching surface ES2-4.

The maximum thicknesses T3 and T4 measured at a center of each of the third and fourth ribs may be about 15 um or less. For example, the maximum thicknesses T3 and T4 measured at the center of each of the third and fourth ribs may be about 7 um to about 10 um. For example, the maximum thicknesses T3 and T4 measured at the center of each of the third and fourth ribs may be about 6 um to about 9 um. When the maximum thicknesses T3 and T4 measured at the center of each of the third and fourth ribs exceed about 15 um, it may be difficult to form an OLED deposition pattern having a high-resolution of 500 PPI or more. In addition, when the maximum thicknesses T3 and T4 measured at the center of each of the third and fourth ribs are less than about 6 um, it may be difficult to form uniformly the deposition pattern.

Meanwhile, the maximum thicknesses T3 and T4 measured at the center of each of the third and fourth ribs may be different from each other. In detail, the maximum thicknesses T3 and T4 measured at the center of each of the third and fourth ribs may have different values while satisfying the above range. In more detail, the maximum thickness T4 measured at the center of the fourth rib may be smaller than the maximum thickness T3 measured at the center of the third rib. The maximum thickness T4 measured at the center of the fourth rib may have a value smaller than the maximum thickness T3 measured at the center of the third rib within the above-described range.

A height of a small surface hole in the second through-hole VH2 of the deposition mask 100 may be about 0.2 times to about 0.4 times the maximum thicknesses T3 and T4 measured at the centers of the third and fourth ribs. Accordingly, a height of a small surface hole formed on a central portion of the fourth rib may be different from that of a small surface hole formed on a central portion of the third rib. In detail, a height H4 of the small surface hole formed on the central portion of the fourth rib may be smaller than a height H3 of the small surface hole formed on the central portion of the third rib.

As an example, the maximum thickness measured at the center of the third rib or the fourth rib is about 7 um to about 9 um, and a height of a small surface hole between one surface of the second through-hole of the deposition mask 100 and the communication portion is about 1.4 um to about 3.5 um.

The height H4 of the small surface hole at the center of the third rib of the deposition mask 100 may be about 4.0 um or less. The height H1 of the small surface hole at the center of the fourth rib of the deposition mask 100 may be about 3.5 um or less.

Preferably, the height H3 of the small surface hole at the center of the third rib of the second through-hole of the deposition mask 100 may be about 3.5 um or less. The height H4 of the small surface hole at the center of the fourth rib of the second through-hole of the deposition mask 100 may be about 2.5 um or less.

Preferably, the height H3 of the small surface hole at the third rib may be about 0.1 um to about 3.4 um. The height H4 of the small surface hole at the fourth rib may be about 0.1 um to about 2.4 um. For example, a height of a small surface hole V1 at the third rib of the deposition mask 100 may be about 0.5 um to about 3.2 um. For example, a height of a small surface hole V1 at the fourth rib of the deposition mask 100 may be about 0.5 um to about 2.2 um. For example, the height of the small surface hole at the central portion of the third rib of the deposition mask 100 may be about 1 um to about 3 um. For example, the height of the small surface hole at the central portion of the fourth rib of the deposition mask 100 may be about 1 um to about 2 um. Here, the height may be measured in a thickness measurement direction of the deposition mask 100, that is, a depth direction, and a height from one surface of the deposition mask 100 to the communication portion may be measured. When the height between one surface of the deposition mask 100 and the communication portion exceeds about 3.5 um, deposition failure may occur due to a shadow effect in which a deposition material spreads to an area larger than that of the through-hole during OLED deposition. Therefore, the height of the small surface hole at the central portion of the third rib is set to 3.5 um or less, and the height of the small surface hole at the central portion of the fourth rib is set to 3.0 um or less.

In addition, on the central portion of the third rib, a cross-sectional inclination angle θ corresponding to an inner angle between a flat virtual first straight line corresponding to the other surface of the deposition mask 100 and a virtual second straight line connecting one end E5 of the third sub-second etching surface ES2-3 of the large surface hole V2 and one end E6 of the communicating portion may be 45 degrees to 55 degrees. On the central portion of the fourth rib, a cross-sectional inclination angle θ corresponding to an inner angle between a flat virtual first straight line corresponding to the other surface of the deposition mask 100 and a virtual third straight line connecting one end E7 of the fourth sub-second etching surface ES2-4 of the large surface hole V2 and one end E8 of the communicating portion may be 35 degrees to 45 degrees.

Meanwhile, a large surface hole of the third through-hole VH3 includes a second etching surface ES2 and a third etching surface ES3 like the first through-hole VH1. In this case, the third etching surface ES3 of the large surface hole of the third through-hole VH3 may have the same cross-sectional inclination angle as that of the third etching surface ES3 of the large surface hole of the first through-hole VH1. However, a cross-sectional inclination angle of the second etching surface ES2 of the large surface hole of the third through-hole VH3 may be different from the cross-sectional inclination angle of the second etching surface ES2 of the large surface hole of the first through-hole VH1.

The second etching surface ES2 of the large surface hole of the third through-hole VH3 includes a fifth sub-second etching surface ES2-5 and a sixth sub-second etching surface ES2-6 facing each other in the longitudinal direction.

In this case, the fifth sub-second etching surface ES2-5 is positioned in a region adjacent to an ineffective portion UA, and the sixth sub-second etching surface ES2-5 is positioned in a region adjacent to an inner region (may be referred to a central region) of the effective portion.

In addition, the fifth sub-second etching surface ES2-5 has a fifth cross-sectional inclination angle, and the sixth sub-second etching surface ES2-6 has a sixth cross-sectional inclination angle. In this case, the fifth cross-sectional inclination angle and the sixth cross-sectional inclination angle may be different from each other. That is, the fifth sub-second etching surface ES2-5 may have a cross-sectional inclination angle different from that of the sixth sub-second etching surface ES2-6. Preferably, the cross-sectional inclination angle of the fifth sub-second etching surface ES2-5 may be greater than that of the sixth sub-second etching surface ES2-6.

In addition, a thickness of a central portion of a fifth rib connected to the fifth sub-second etching surface ES2-5 and a thickness of a central portion of a sixth rib connected to the sixth sub-second etching surface ES2-6 may also be different from each other. That is, the thickness of the central portion of the fifth rib connected to the fifth sub-second etching surface ES2-5 may be thicker than that of the central portion of the sixth rib connected to the sixth sub-second etching surface ES2-6.

The maximum thicknesses T5 and T6 measured at the center of each of the fifth and sixth ribs may be about 15 um or less. For example, the maximum thicknesses T5 and T6 measured at the center of each of the fifth and sixth ribs may be about 7 um to about 10 um. For example, the maximum thicknesses T5 and T6 measured at the center of each of the fifth and sixth ribs may be about 6 um to about 9 um. When the maximum thicknesses T5 and T6 measured at the center of each of the fifth and sixth ribs exceed about 15 um, it may be difficult to form an OLED deposition pattern having a high-resolution of 500 PPI or more. In addition, when the maximum thicknesses T5 and T6 measured at the center of each of the fifth and sixth ribs are less than about 6 um, it may be difficult to form uniformly the deposition pattern.

Meanwhile, the maximum thicknesses T5 and T6 measured at the center of each of the fifth and sixth ribs may be different from each other. In detail, the maximum thicknesses T5 and T6 measured at the center of each of the fifth and sixth ribs may have different values while satisfying the above range. In more detail, the maximum thickness T6 measured at the center of the sixth rib may be smaller than the maximum thickness T5 measured at the center of the fifth rib. The maximum thickness T6 measured at the center of the sixth rib may have a value smaller than the maximum thickness T5 measured at the center of the fifth rib within the above-described range.

A height of the small surface hole in the third through-hole VH3 of the deposition mask 100 may be about 0.2 times to about 0.4 times the maximum thicknesses T5 and T6 measured at the centers of the fifth and sixth ribs. Accordingly, a height of a small surface hole formed on the sixth rib may be different from that of a small surface hole formed on the fifth rib. In detail, a height H6 of the small surface hole formed on the sixth rib may be smaller than a height H5 of the small surface hole formed on the fifth rib.

As an example, the maximum thickness measured at the center of the fifth rib or the sixth rib is about 7 um to about 9 um, and a height of a small surface hole between one surface of the third through-hole of the deposition mask 100 and the communication portion is about 1.4 um to about 3.5 um.

The height H5 of the small surface hole at the central portion of the fifth rib of the deposition mask 100 may be about 4.0 um or less. The height H6 of the small surface hole at the central portion of the sixth rib of the deposition mask 100 may be about 3.5 um or less. Preferably, the height H5 of the small surface hole in the central portion of the fifth rib of the third through-hole of the deposition mask 100 may be about 3.5 um or less. The height H6 of the small surface hole in the central portion of the sixth rib of the third through-hole of the deposition mask 100 may be about 2.5 um or less.

Preferably, the height H5 of the small surface hole in the central portion of the fifth rib may be about 0.1 um to about 3.4 um. The height H6 of the small surface hole in the central portion of the sixth rib may be 0.1 um to about 2.4 um. For example, the height of the small surface hole V1 at the central portion of the fifth rib of the deposition mask 100 may be about 0.5 um to about 3.2 um. For example, the height of the small surface hole V1 at the central portion of the sixth rib of the deposition mask 100 may be about 0.5 um to about 2.2 um. For example, the height of the small surface hole at the central portion of the fifth rib of the deposition mask 100 may be about 1 um to about 3 um. For example, the height of the small surface hole at the central portion of the sixth rib of the deposition mask 100 may be about 1 um to about 2 um. Here, the height may be measured in a thickness measurement direction of the deposition mask 100, that is, a depth direction, and a height from one surface of the deposition mask 100 to a communication portion may be measured. When the height between one surface of the deposition mask 100 and the communication portion exceeds about 3.5 um, deposition failure may occur due to a shadow effect in which a deposition material spreads to an area larger than that of the through-hole during OLED deposition. Therefore, the height of the small surface hole at the central portion of the fifth rib is set to 3.5 um or less, and the height of the small surface hole at the central portion of the sixth rib is set to 3.0 um or less.

In addition, on the central portion of the fifth rib, a cross-sectional inclination angle θ corresponding to an internal angle between a virtual first straight line and a virtual fourth straight line connecting one end E9 of the fifth sub-second etching surface ES2-5 of the large surface hole V2 and one end E10 of the communication portion may be 45 degrees to 55 degrees. On the central portion of the sixth rib, a cross-sectional inclination angle θ corresponding to an internal angle between the virtual first straight line and a virtual fifth straight line connecting one end E11 of the sixth sub-second etching surface ES2-6 of the large surface hole V2 and one end E12 of the communication portion may be 35 degrees to 45 degrees.

According to the embodiment, the large surface hole of the through-hole has a first cross-sectional inclination angle in the longitudinal direction, and has a second cross-sectional inclination angle greater than the first cross-sectional inclination angle in the lateral direction, and it is possible to increase the thickness of the ribs disposed in the longitudinal direction by a difference between the first cross-sectional inclination angle and the second cross-sectional inclination angle, thereby securing rigidity of the deposition mask. In addition, as the rigidity of the deposition mask is secured, length deformation may be minimized, and accordingly, pattern deposition efficiency may be improved by increasing the uniformity of the shape of the mask pattern and the position of the through-hole.

In addition, according to the embodiment, the OLED pixel pattern may be uniformly deposited in all regions regardless of the position of the through-hole by reducing the inclination angle of the large surface hole of the through-hole in the direction perpendicular to the moving direction of the organic deposition container.

Examples of metallic material deposition mask for OLED pixel deposition will now be recited.

Example A. A metallic material deposition mask for OLED pixel deposition comprises: a deposition region for forming a deposition pattern and a non-deposition region other than the deposition region, wherein the deposition region includes a plurality of effective portions spaced apart in a longitudinal direction and an ineffective portion other than the effective portion, wherein the effective portion includes: a plurality of small surface holes formed on one surface; a plurality of large surface holes formed on the other surface opposite to the one surface; a plurality of through-holes communicating the small surface hole and the large surface hole; and an island portion between the plurality of through-holes, wherein the deposition mask has a resolution of 500 PPI or more in which a diameter of the through-hole is 33 um or less and a distance between respective centers of two adjacent through-holes of the through-holes is 48 um or less, an inclination angle of the large surface hole with respect to the other surface is 40 degrees to 55 degrees, an average centerline average surface roughness in a longitudinal direction of the non-deposition region and an average centerline average surface roughness in a lateral direction are 0.1 um to 0.3 um, an average 10-point average surface roughness Rz in the longitudinal direction of the non-deposition region and an average 10-point average surface roughness in the lateral direction are 0.5 um to 2.0 um, a deviation of a value of the average centerline average surface roughness in the longitudinal direction with respect to the average centerline average surface roughness in the lateral direction is less than 50%, and a deviation of a value of the average 10-point average surface roughness in the longitudinal direction with respect to the average 10-point average surface roughness in the lateral direction is less than 50%.

Example B. A metallic material deposition mask for OLED pixel deposition comprises: a deposition region for forming a deposition pattern and a non-deposition region other than the deposition region, wherein the deposition region includes a plurality of effective portions spaced apart in a longitudinal direction and an ineffective portion other than the effective portion, wherein the effective portion includes: a plurality of small surface holes formed on one surface; a plurality of large surface holes formed on the other surface opposite to the one surface; a plurality of through-holes communicating the small surface hole and the large surface hole; and an island portion between the plurality of through-holes, wherein the deposition mask has a resolution of 500 PPI or more in which a diameter of the through-hole is 33 um or less and a distance between respective centers of two adjacent through-holes of the through-holes is 48 um or less, an inclination angle of the large surface hole with respect to the other surface is 40 degrees to 55 degrees, an average centerline average surface roughness in a longitudinal direction of the island portion and an average centerline average surface roughness in a lateral direction are 0.1 um to 0.3 um, an average 10-point average surface roughness Rz in the longitudinal direction of the non-deposition region and an average 10-point average surface roughness in the lateral direction are 0.5 um to 2.0 um, a deviation of a value of the average centerline average surface roughness in the longitudinal direction with respect to the average centerline average surface roughness in the lateral direction is less than 50%, and a deviation of a value of the average 10-point average surface roughness in the longitudinal direction with respect to the average 10-point average surface roughness in the lateral direction is less than 50%.

Example C. The deposition mask of examples A or B, wherein the metallic material is manufactured into a metal plate that is an iron-nickel alloy having a predetermined thickness after rolling and annealing, the longitudinal direction of the deposition mask corresponds to the rolling direction, and the large surface hole and small surface hole are formed by etching on the metal plate.

Example D. The deposition mask of example C, wherein an average centerline average surface roughness in a rolling direction of the metal plate is different from an average centerline average surface roughness in a transverse direction, and an average 10-point average surface roughness in the rolling direction of the metal plate is different from an average 10-point average surface roughness in the transverse direction.

Example E. The deposition mask of example D, wherein in the non-deposition region, the metal plate having the predetermined thickness is etched so as to have the average 10-point average surface roughness Rz.

Example F. The deposition mask of example E, wherein the predetermined thickness the metal plate is 30 um or more, the non-deposition region includes a half-etching portion for adjusting a tensile force, and a thickness of a portion in which the half-etching portion is not formed in the non-deposition region is 20 um to 30 um.

Example G. The deposition mask of example C, wherein the deviation of the value of the average centerline average surface roughness in the longitudinal direction with respect to the average centerline average surface roughness in the lateral direction is 30% or less, and the deviation of the value of the average 10-point average surface roughness in the longitudinal direction with respect to the average 10-point average surface roughness in the lateral direction is 30% or less.

Example H. The deposition mask of example G, wherein the predetermined thickness is 25 um or more, the non-deposition region includes a half-etching portion for adjusting a tensile force, and a thickness of a portion in which the half-etching portion is not formed in the non-deposition region is 15 um to 25 um.

Example I. The deposition mask of examples A or B, comprising an etching control layer on the non-deposition region.

Example J. The deposition mask of example F, wherein in a surface roughness of the island portion, an average centerline average surface roughness in a longitudinal direction and an average centerline average surface roughness in a lateral direction are 0.1 um to 0.3 um, respectively, an average 10-point average surface roughness in the longitudinal direction and an average 10-point average surface roughness in the lateral direction are 0.5 um to 2.0 um, respectively, a deviation of a value of the average centerline average surface roughness in the longitudinal direction with respect to the average centerline average surface roughness in the lateral direction is less than 50%, and a deviation of a value of the average 10-point average surface roughness in the longitudinal direction with respect to the average 10-point average surface roughness in the lateral direction is less than 50%.

Example K. The deposition mask of example H, wherein in a surface roughness of the island portion, an average centerline average surface roughness in a longitudinal direction and an average centerline average surface roughness in a lateral direction are 0.1 um to 0.2 um, an average 10-point average surface roughness in the longitudinal direction and an average 10-point average surface roughness in the lateral direction are 0.5 um to 1.5 um, a deviation of a value of the average centerline average surface roughness in the longitudinal direction with respect to the average centerline average surface roughness in the lateral direction is 30% or less, and a deviation of a value of the average 10-point average surface roughness in the longitudinal direction with respect to the average 10-point average surface roughness in the lateral direction is 30% or less.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, the above description has been focused on the embodiments, but it is merely illustrative and does not limit the present invention. It will be apparent to those skilled in the art that various modifications and applications not illustrated above are possible without departing from the essential features of the present embodiment. For example, elements of the embodiments described herein may be modified and realized. Also, it should be construed that differences related to such changes and applications are included in the scope of the present invention defined in the appended claims.

## Claims

1. A metal deposition mask (100) used for manufacturing an OLED, the metal deposition mask comprising:
a first surface (101) and a second surface (102) facing the first surface,
wherein the metal deposition mask comprises a deposition region (DA) for forming a deposition pattern and a non-deposition region (NDA) other than the deposition region,
wherein the deposition region includes a plurality of effective portions (AA1, AA2, AA3) spaced apart in a longitudinal direction and an ineffective portion other than the effective portion,
wherein the effective portions include a plurality of small surface holes (V1) formed on the first surface; a plurality of large surface holes (V2) formed on the second surface; a through-hole (TH) communicating the small surface hole and the large surface hole; and an island portion (IS) between the plurality of through-holes,
wherein each of an average centerline average surface roughness in a longitudinal direction and an average centerline average surface roughness in a lateral direction of the non-deposition region or the island portion of the metal deposition mask is 0.1 um to 0.3 um,
wherein an average centerline average surface roughness in a diagonal direction (OD) between the longitudinal direction and the lateral direction of the non-deposition region or the island portion of the metal deposition mask is 0.1 um to 0.3 um, wherein the longitudinal direction is a rolling direction (RD) of the metal deposition mask,
wherein the lateral direction (TD) is a direction perpendicular to the rolling direction of the metal deposition mask, and
wherein the diagonal direction is a +45 degree direction or a -45 degree direction between the longitudinal direction and the lateral direction.

2. The metal deposition mask of claim 1, wherein an average centerline average surface roughness in the longitudinal direction and an average centerline average surface roughness in the lateral direction of the non-deposition region is 0.1 um to 0.3 um, and
wherein an average centerline average surface roughness in the longitudinal direction and an average centerline average surface roughness in the lateral direction of island portion of the metal deposition mask is 0.1 um to 0.3 um.

3. The metal deposition mask of claim 1 or claim 2, wherein each of an average 10-point average surface roughness in the longitudinal direction, an average 10-point average surface roughness in the lateral direction, and an average 10-point average surface roughness in the diagonal direction of the non-deposition region or the island portion of the metal deposition mask is 0.5 um to 2.0um.

4. The metal deposition mask of any one of claims 1 to 3, wherein a deviation of the average centerline average surface roughness in the longitudinal direction with respect to the average centerline average surface roughness in the lateral direction of the first surface or the second surface of the metal deposition mask is less than 50%.

5. The metal deposition mask of any one of claims 1 to 4, wherein a deviation of the average centerline average surface roughness in the longitudinal direction with respect to the average centerline average surface roughness in the lateral direction of the non-deposition region or the island portion of the metal deposition mask is less than 30%.

6. The metal deposition mask of claim 5, wherein a deviation of the average centerline average surface roughness in the longitudinal direction with respect to the average centerline average surface roughness in the lateral direction of the non-deposition region or the island portion of the metal deposition mask is less than 15%.

7. The metal deposition mask of any one of claims 1 to 6, wherein a deviation of an average 10-point average surface roughness in the longitudinal direction with respect to an average 10-point average surface roughness in the lateral direction of the non-deposition region or the island portion of the metal deposition mask is less than 50%.

8. The metal deposition mask claim, wherein each of an average 10-point average surface roughness in the longitudinal direction, an average 10-point average surface roughness in the lateral direction, and an average 10-point average surface roughness in the diagonal direction of the non-deposition region or the island portion of the metal deposition mask is 0.5 um to 2.0um.

## Patentansprüche

1. Metallaufdampfmaske (100), die zur Herstellung einer OLED verwendet wird, wobei die Metallaufdampfmaske Folgendes umfasst:
eine erste Oberfläche (101) und eine zweite Oberfläche (102), die der ersten Oberfläche zugewandt ist,
wobei die Metallaufdampfmaske einen Bedampfungsbereich (DA) zum Bilden eines Bedampfungsmusters und einen anderen Nicht-Bedampfungsbereich (NDA) als den Bedampfungsbereich umfasst,
wobei der Bedampfungsbereich eine Vielzahl von effektiven Abschnitten (AA1, AA2, AA3), die in einer Längsrichtung voneinander beabstandet sind, und einen anderen ineffektiven Abschnitt als den effektiven Abschnitt umfasst,
wobei die effektiven Abschnitte Folgendes umfassen: eine Vielzahl von kleinen Oberflächenlöchern (V1), die auf der ersten Oberfläche ausgebildet sind; eine Vielzahl von großen Oberflächenlöchern (V2), die auf der zweiten Oberfläche ausgebildet sind;
ein Durchgangsloch (TH), das das kleine Oberflächenloch und das große Oberflächenloch miteinander verbindet; und einen Inselabschnitt (IS) zwischen der Vielzahl von Durchgangslöchern,
wobei jede einer mittleren arithmetischen Mittellinienrauhigkeit in einer Längsrichtung und einer mittleren arithmetischen Mittellinienrauhigkeit in einer Querrichtung des Nicht-Bedampfungsbereichs oder des Inselabschnitts der Metallaufdampfmaske 0,1 µm bis 0,3 µm beträgt,
wobei eine mittlere arithmetische Mittellinienrauhigkeit in einer Diagonalrichtung (OD) zwischen der Längsrichtung und der Querrichtung des Nicht-Bedampfungsbereichs oder des Inselabschnitts der Metallaufdampfmaske 0,1 µm bis 0,3 µm beträgt,
wobei die Längsrichtung eine Walzrichtung (RD) der Metallaufdampfmaske ist,
wobei die Querrichtung (TD) eine Richtung senkrecht zur Walzrichtung der Metallaufdampfmaske ist, und
wobei die Diagonalrichtung eine +45-Grad-Richtung oder eine -45-Grad-Richtung zwischen der Längsrichtung und der Querrichtung ist.

2. Metallaufdampfmaske nach Anspruch 1, wobei eine mittlere arithmetische Mittellinienrauhigkeit in der Längsrichtung und eine mittlere arithmetische Mittellinienrauhigkeit in der Querrichtung des Nicht-Bedampfungsbereichs 0,1 µm bis 0,3 µm beträgt, und
wobei eine mittlere arithmetische Mittellinienrauhigkeit in der Längsrichtung und eine mittlere arithmetische Mittellinienrauhigkeit in der Querrichtung des Inselabschnitts der Metallaufdampfmaske 0,1 µm bis 0,3 µm beträgt.

3. Metallaufdampfmaske nach Anspruch 1 oder Anspruch 2, wobei jede einer mittleren Zehnpunktermittelrauhigkeit in der Längsrichtung, einer mittleren Zehnpunktermittelrauhigkeit in der Querrichtung und einer mittleren Zehnpunktermittelrauhigkeit in der Diagonalrichtung des Nicht-Bedampfungsbereichs oder des Inselabschnitts der Metallaufdampfmaske 0,5 µm bis 2,0 µm beträgt.

4. Metallaufdampfmaske nach einem der Ansprüche 1 bis 3, wobei eine Abweichung der mittleren arithmetischen Mittellinienrauhigkeit in der Längsrichtung in Bezug auf die mittlere arithmetische Mittellinienrauhigkeit in der Querrichtung der ersten Oberfläche oder der zweiten Oberfläche der Metallaufdampfmaske weniger als 50 % beträgt.

5. Metallaufdampfmaske nach einem der Ansprüche 1 bis 4, wobei eine Abweichung der mittleren arithmetischen Mittellinienrauhigkeit in der Längsrichtung in Bezug auf die mittlere arithmetische Mittellinienrauhigkeit in der Querrichtung des Nicht-Bedampfungsbereichs oder des Inselabschnitts der Metallaufdampfmaske weniger als 30 % beträgt.

6. Metallaufdampfmaske nach Anspruch 5, wobei eine Abweichung der mittleren arithmetischen Mittellinienrauhigkeit in der Längsrichtung in Bezug auf die mittlere arithmetische Mittellinienrauhigkeit in der Querrichtung des Nicht-Bedampfungsbereichs oder des Inselabschnitts der Metallaufdampfmaske weniger als 15 % beträgt.

7. Metallaufdampfmaske nach einem der Ansprüche 1 bis 6, wobei eine Abweichung einer mittleren Zehnpunktermittelrauhigkeit in der Längsrichtung in Bezug auf eine mittlere Zehnpunktermittelrauhigkeit in der Querrichtung des Nicht-Bedampfungsbereichs oder des Inselabschnitts der Metallaufdampfmaske weniger als 50 % beträgt.

8. Metallaufdampfmaske nach Anspruch 1, wobei jede einer mittleren Zehnpunktermittelrauhigkeit in der Längsrichtung, einer mittleren Zehnpunktermittelrauhigkeit in der Querrichtung und einer mittleren Zehnpunktermittelrauhigkeit in der Diagonalrichtung des Nicht-Bedampfungsbereichs oder des Inselabschnitts der Metallaufdampfmaske 0,5 µm bis 2,0 µm beträgt.

## Revendications

1. Masque de dépôt métallique (100) utilisé pour la fabrication d'une OLED, le masque de dépôt métallique comprenant :
une première surface (101) et une seconde surface (102) faisant face à la première surface,
dans lequel le masque de dépôt métallique comprend une région de dépôt (DA) pour former un motif de dépôt et une région de non-dépôt (NDA) autre que la région de dépôt,
dans lequel la région de dépôt comprend une pluralité de parties effectives (AA1, AA2, AA3) espacées dans une direction longitudinale et une partie ineffective autre que la partie effective,
dans lequel les parties effectives comprennent : une pluralité de petits trous de surface (V1) formés sur la première surface ; une pluralité de grands trous de surface (V2) formés sur la seconde surface ; un trou traversant (TH) faisant communiquer le petit trou de surface et le grand trou de surface ; et une portion d'île (IS) entre la pluralité de trous traversants,
dans lequel chacune d'une rugosité de surface moyenne arithmétique moyenne dans une direction longitudinale et d'une rugosité de surface moyenne arithmétique moyenne dans une direction latérale de la région de non-dépôt ou de la portion d'île du masque de dépôt métallique est de 0,1 µm à 0,3 µm,
dans lequel une rugosité de surface moyenne arithmétique moyenne dans une direction diagonale (OD) entre la direction longitudinale et la direction latérale de la région de non-dépôt ou de la portion d'île du masque de dépôt métallique est de 0,1 µm à 0,3 µm,
dans lequel la direction longitudinale est une direction de laminage (RD) du masque de dépôt métallique,
dans lequel la direction latérale (TD) est une direction perpendiculaire à la direction de laminage du masque de dépôt métallique, et
dans lequel la direction diagonale est une direction à +45 degrés ou une direction à - 45 degrés entre la direction longitudinale et la direction latérale.

2. Masque de dépôt métallique selon la revendication 1, dans lequel une rugosité de surface moyenne arithmétique moyenne dans la direction longitudinale et une rugosité de surface moyenne arithmétique moyenne dans la direction latérale de la région de non-dépôt est de 0,1 µm à 0,3 µm, et
dans lequel une rugosité de surface moyenne arithmétique moyenne dans la direction longitudinale et une rugosité de surface moyenne arithmétique moyenne dans la direction latérale de la portion d'île du masque de dépôt métallique est de 0,1 µm à 0,3 µm.

3. Masque de dépôt métallique selon la revendication 1 ou la revendication 2, dans lequel chacune d'une rugosité de surface moyenne en dix points moyenne dans la direction longitudinale, d'une rugosité de surface moyenne en dix points moyenne dans la direction latérale et d'une rugosité de surface moyenne en dix points moyenne dans la direction diagonale de la région de non-dépôt ou de la portion d'île du masque de dépôt métallique est de 0,5 µm à 2,0 µm.

4. Masque de dépôt métallique selon l'une quelconque des revendications 1 à 3, dans lequel un écart de la rugosité de surface moyenne arithmétique moyenne dans la direction longitudinale par rapport à la rugosité de surface moyenne arithmétique moyenne dans la direction latérale de la première surface ou de la seconde surface du masque de dépôt métallique est inférieur à 50 %.

5. Masque de dépôt métallique selon l'une quelconque des revendications 1 à 4, dans lequel un écart de la rugosité de surface moyenne arithmétique moyenne dans la direction longitudinale par rapport à la rugosité de surface moyenne arithmétique moyenne dans la direction latérale de la région de non-dépôt ou de la portion d'île du masque de dépôt métallique est inférieur à 30 %.

6. Masque de dépôt métallique selon la revendication 5, dans lequel un écart de la rugosité de surface moyenne arithmétique moyenne dans la direction longitudinale par rapport à la rugosité de surface moyenne arithmétique moyenne dans la direction latérale de la région de non-dépôt ou de la portion d'île du masque de dépôt métallique est inférieur à 15 %.

7. Masque de dépôt métallique selon l'une quelconque des revendications 1 à 6, dans lequel un écart d'une rugosité de surface moyenne en dix points moyenne dans la direction longitudinale par rapport à une rugosité de surface moyenne en dix points moyenne dans la direction latérale de la région de non-dépôt ou de la portion d'île du masque de dépôt métallique est inférieur à 50 %.

8. Masque de dépôt métallique selon la revendication 1, dans lequel chacune d'une rugosité de surface moyenne en dix points moyenne dans la direction longitudinale, d'une rugosité de surface moyenne en dix points moyenne dans la direction latérale et d'une rugosité de surface moyenne en dix points moyenne dans la direction diagonale de la région de non-dépôt ou de la portion d'île du masque de dépôt métallique est de 0,5 µm à 2,0 µm.
